# EUROPEAN PATENT APPLICATION

(11) **EP 4 709 076 A1**
(43) Date of publication of application: **11.03.2026**
(21) Application number: 25190179.9
(22) Date of filing: 17.07.2025
(51) Int. Cl.: H10B 43/40, H10B 43/10, H10B 43/50, H10D 1/68

(54) **SEMICONDUCTOR DEVICES**

(30) Priority: 10.09.2024 KR 20240123342
(71) Applicant: Samsung Electronics Co., Ltd., Suwon-si, Gyeonggi-do 16677 (KR)
(72) Inventor: KIM, Jiyoung, 16677 Suwon-si (KR); LEE, Sehoon, 16677 Suwon-si (KR); KIM, Siwan, 16677 Suwon-si (KR); KIM, Junhyoung, 16677 Suwon-si (KR); SUNG, Sukkang, 16677 Suwon-si (KR); LEE, Sehyung, 16677 Suwon-si (KR)
(74) Representative: Marks & Clerk LLP

(57) **Abstract**

A semiconductor device includes a gate electrode structure including gate electrodes spaced apart from each other in a first direction substantially perpendicular to an upper surface of a substrate; insulation patterns disposed between the gate electrodes; a first capacitor electrode extending through the gate electrode structure and the insulation patterns in the first direction, the first capacitor electrode including a metal; a dielectric pattern on a sidewall of the first capacitor electrode; and second capacitor electrodes corresponding to portions of the gate electrodes adjacent to the first capacitor electrode. The first capacitor electrode includes a first extension portion extending in the first direction and first protrusion portions protruding in a horizontal direction substantially parallel to the upper surface of the substrate from portions of a sidewall of the first extension portion that respectively face the insulation patterns in the horizontal direction.

## Description

### BACKGROUND

In an electronic system requiring data storage, a high capacity semiconductor device that may store high capacity data is desirable. Thus, a method of increasing the data storage capacity of the semiconductor device has been studied. For example, a semiconductor device including memory cells that are 3-dimensionally stacked has been suggested.

### SUMMARY

In general, the present disclosure is directed toward a semiconductor device having improved electrical characteristics.

According some implementations, the present disclosure is directed to a semiconductor device that includes a gate electrode structure including gate electrodes spaced apart from each other in a first direction perpendicular to an upper surface of a substrate; insulation patterns disposed between the gate electrodes; a first capacitor electrode extending through the gate electrode structure and the insulation patterns in the first direction, the first capacitor electrode including a metal; a dielectric pattern on a sidewall of the first capacitor electrode; and second capacitor electrodes being (e.g. formed from) respective portions of the gate electrodes adjacent to the first capacitor electrode. The first capacitor electrode includes a first extension portion extending in the first direction; and first protrusion portions protruding from portions of a sidewall of the first extension portion in a horizontal direction substantially parallel to the upper surface of the substrate, the portions of a sidewall of the first extension portion facing the insulation patterns in the horizontal direction.

According to some implementations, the present disclosure is directed to a semiconductor device that includes a gate electrode structure including gate electrodes spaced apart from each other in a first direction perpendicular to an upper surface of a substrate; a blocking pattern covering upper surfaces, lower surfaces, and sidewalls of the gate electrodes, wherein the blocking pattern comprises a metal oxide; insulation patterns disposed between the gate electrodes; a first capacitor electrode extending through the gate electrode structure and the insulation patterns in the first direction; a dielectric pattern on a sidewall of the first capacitor electrode; and second capacitor electrodes having portions of the gate electrodes adjacent to the first capacitor electrode, wherein an outer radius from a central axis of the first capacitor electrode to an outer sidewall of the first capacitor electrode periodically increases and decreases along the first direction, and wherein the outer radius increases at heights corresponding to the insulation patterns.

According to some implementations, the present disclosure is directed to a semiconductor device that includes a gate electrode structure including gate electrodes spaced apart from each other in a first direction substantially perpendicular to an upper surface of a substrate; a memory channel structure including a channel extending through the gate electrode structure in the first direction, and a charge storage structure on an outer sidewall of the channel; a capacitor structure extending through the gate electrode structure and spaced apart from the memory channel structure in a horizontal direction parallel to the upper surface of the substrate, wherein the capacitor structure includes: a first capacitor electrode extending in the first direction; a dielectric pattern on a sidewall of the first capacitor electrode; and second capacitor electrodes having portions of the gate electrodes adjacent to the first capacitor electrode, wherein the first capacitor electrode includes protrusion portions that protrude in the horizontal direction between adjacent ones of the gate electrodes in the first direction.

According to some implementations, the present disclosure is directed to a semiconductor device that includes a capacitor structure. A first capacitor electrode of the capacitor structure may include protrusion portions respectively protruding in a horizontal direction between vertically adjacent gate electrodes. Accordingly, capacitance of a capacitor including the first capacitor electrode may be increased.

At least some of the above and other features of the invention are set out in the claims.

### BRIEF DESCRIPTION OF THE DRAWINGS

Example implementations will be more clearly understood from the following detailed description, taken in conjunction with the accompanying drawings.
FIGS. 1 to 7 are plan views and cross-sectional views illustrating an example of a semiconductor device according to some implementations.
FIGS. 8 to 46 are plan views and cross-sectional views illustrating examples of methods of manufacturing a semiconductor device according to some implementations.
FIG. 47 is a cross-sectional view illustrating an example of a semiconductor device according to some implementations.
FIG. 48 is a cross-sectional view illustrating an example of a semiconductor device according to some implementations.
FIG. 49 is a cross-sectional view illustrating an example of a method of manufacturing a semiconductor device according to some implementations.
FIG. 50 is a cross-sectional view illustrating an example of a semiconductor device according to some implementations.
FIG. 51 is a cross-sectional view illustrating an example of a semiconductor device according to some implementations.
FIG. 52 is a cross-sectional view illustrating an example of a semiconductor device according to some implementations.
FIG. 53 is a plan view illustrating an example of a semiconductor device according to some implementations.
FIG. 54 is a plan view illustrating an example of a semiconductor device according to some implementations.
FIG. 55 is a plan view illustrating an example of a semiconductor device according to some implementations.
FIG. 56 is a plan view illustrating an example of a semiconductor device according to some implementations.
FIG. 57 is a plan view illustrating an example of a semiconductor device according to some implementations.
FIG. 58 is a cross-sectional view illustrating an example of a semiconductor device according to some implementations.
FIG. 59 is a cross-sectional view illustrating an example of a semiconductor device according to some implementations.
FIGS. 60 to 63 are cross-sectional views illustrating examples of methods of manufacturing a semiconductor device according to some implementations.
FIG. 64 is a cross-sectional view illustrating an example of a semiconductor device according to some implementations.
FIGS. 65 and 66 are cross-sectional views illustrating an example of a semiconductor device according to some implementations.

### DETAILED DESCRIPTION

Hereinafter, example implementations will be explained in detail with reference to the accompanying drawings. It will be understood that, although the terms "first," "second," and/or "third" may be used herein to describe various materials, layers, regions, pads, electrodes, patterns, structure and/or processes, these various materials, layers, regions, pads, electrodes, patterns, structure and/or processes should not be limited by these terms. These terms are only used to distinguish one material, layer, region, pad, electrode, pattern, structure or process from another material, layer, region, pad, electrode, pattern, structure or process. Thus, "first", "second" and/or "third" may be used selectively or interchangeably for each material, layer, region, electrode, pad, pattern, structure or process respectively.

Hereinafter, a vertical direction substantially perpendicular to an upper surface of a substrate may be referred to as a first direction D1, and two directions crossing each other among horizontal directions substantially parallel to the upper surface of the substrate may be referred to as second and third directions D2 and D3, respectively. In some implementations, the second and third directions D2 and D3 may be substantially perpendicular to each other. Each of the first to third directions D1, D2 and D3 may include not only a direction shown in the drawings but also a direction opposite thereto. "Upper features" may be located further along the first direction D1 (e.g. above) "lower" features. While the terms "horizontal" and "vertical" are used, these are defined relative to the structure of the device, and therefore need not imply any particular orientation of the device in use. The first direction D1 may define a height direction.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

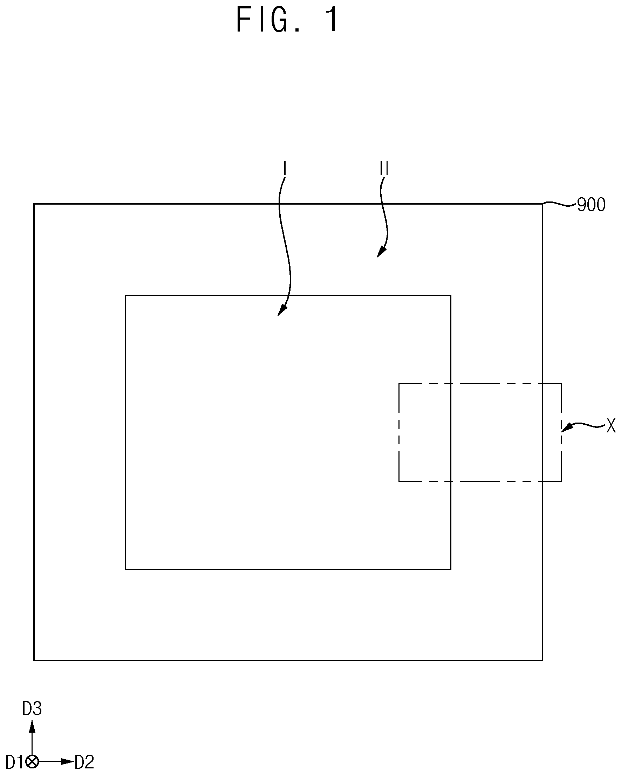

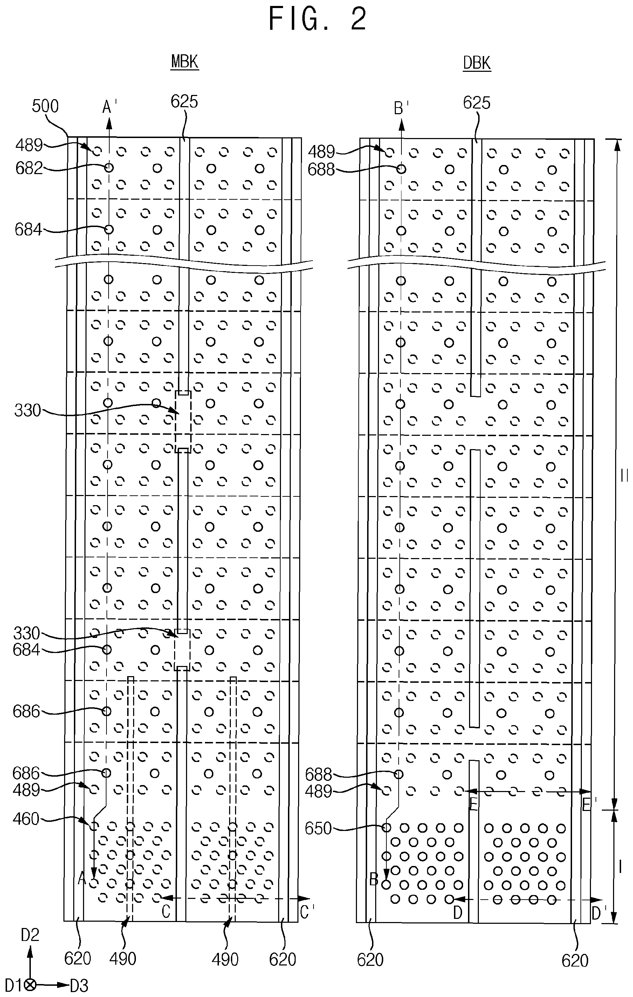

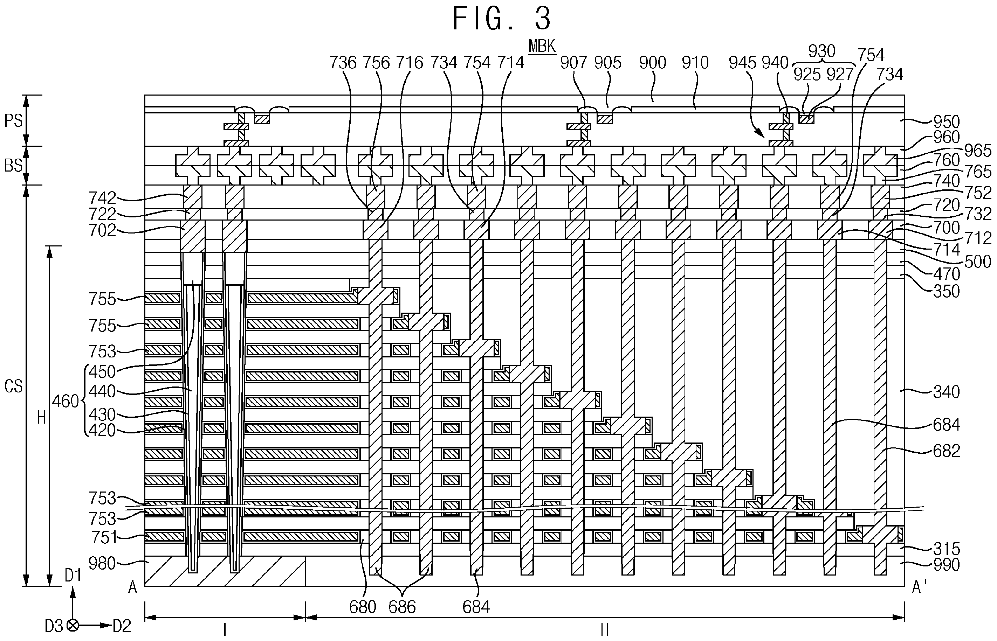

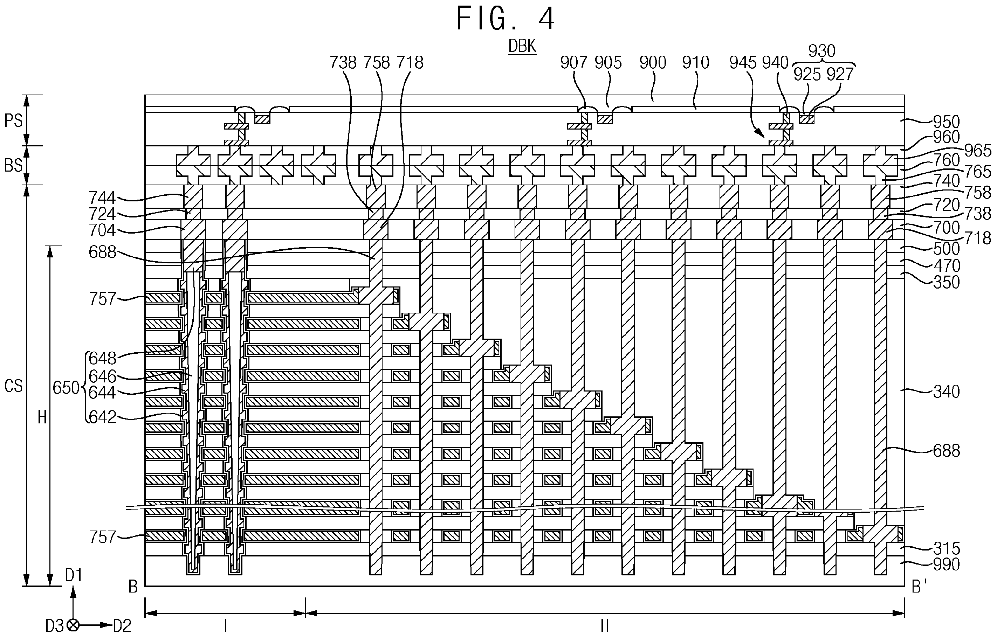

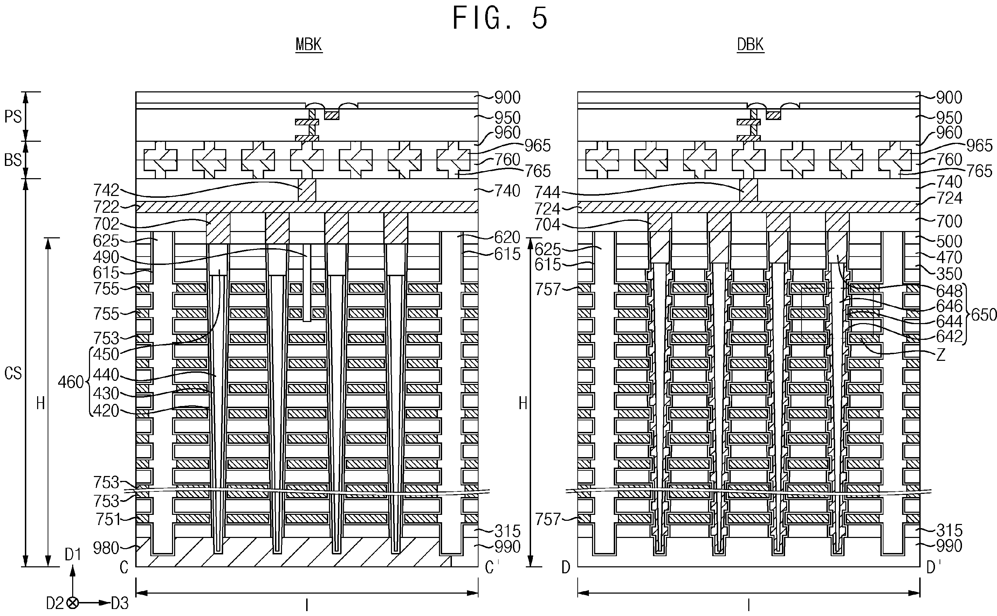

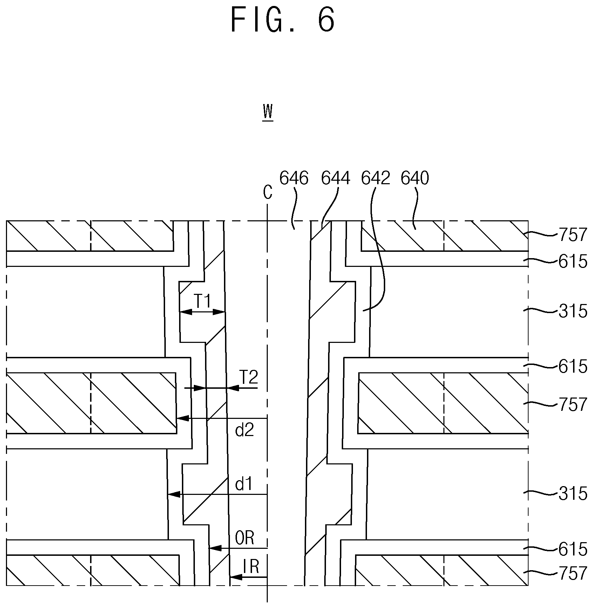

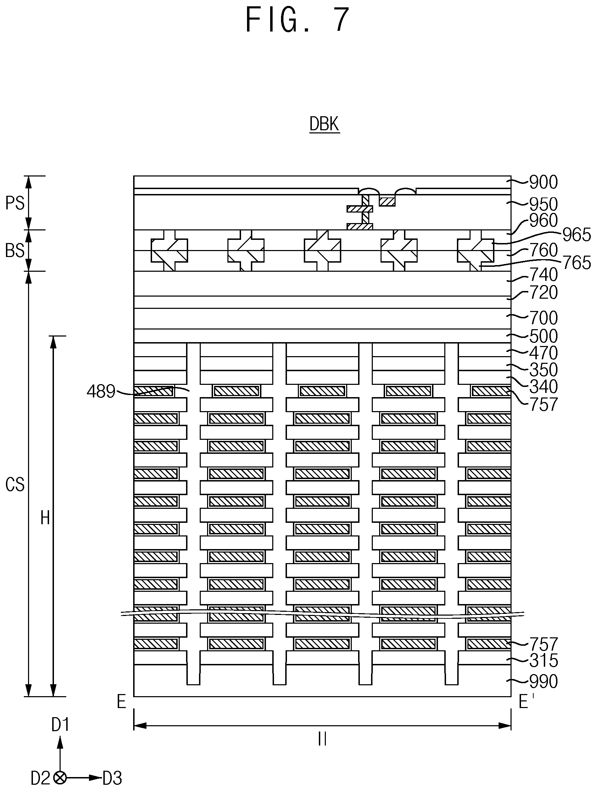

FIGS. 1 to 7 are plan views and cross-sectional views illustrating an example of a semiconductor device according to some implementations. In, FIG. 1 is the plan view, and FIGS. 2 to 7 are plane and cross-sectional views illustrating an example of a region X of FIG. 1 according to some implementations. FIG. 2 is a horizontal cross-sectional view at a height H of FIGS. 3 to 5 and FIG. 7 according to some implementations. FIGS. 3 and 4 are cross-sectional views taken along lines A-A' and B-B' of FIG. 2, respectively, according to some implementations. FIG. 5 includes cross-sectional views taken along lines C-C' and D-D' of FIG. 2 according to some implementations. FIG. 6 is an enlarged cross-sectional view of a region W of FIG. 5 according to some implementations. FIG. 7 is a cross-sectional view taken along line E-E' of FIG. 2 according to some implementations.

In FIGS. 1 to 7, the semiconductor device may include a cell structure CS and a peripheral circuit structure PS arranged along the first direction D1, and a bonding structure BS disposed between the cell structure CS and the peripheral circuit structure PS. The semiconductor device may be a memory device, for instance a non-volatile memory device. For instance, the semiconductor device may be a NAND flash memory device (e.g. a vertical NAND (VNAND) flash memory device).

The cell structure CS may include a gate electrode structure, first to fourth division patterns 330, 490, 620 and 625, a memory channel structure 460 and a capacitor structure 650 on a first common source plate (CSP) 980 and a ninth insulating interlayer 990. Additionally, the cell structure CS may further include a support structure 489, a second blocking pattern 615, first to sixteenth contact plugs 682, 684, 686, 688, 702, 704, 712, 714, 716, 718, 742, 744, 752, 754, 756 and 758, first to sixth wirings 722, 724, 732, 734, 736 and 738, and first to seventh insulating interlayers 340, 350, 470, 500, 700, 720 and 740. The first common source plate 980 and ninth insulating interlayer 990 may collectively form a substrate. The directions defined herein (e.g. the first, second and third directions D1, D2 and D3) may be defined relative to an upper surface of the substrate (e.g. an upper surface of the first common source plate 980 and ninth insulating interlayer 990). The upper surface may be the surface upon which the rest of the cell structure CS is formed. Alternatively, the directions may be defined relative to an upper or lower surface of a second substrate 900 (described later). Alternatively, the directions may be defined relative to the direction in which the gate electrodes are stacked. For instance, the first direction D1 may be a direction in which the gate electrodes are spaced apart from each other. The second and third directions D2 and D3 may be perpendicular to the first direction D1.

In some implementations, the semiconductor device may have a Periphery Over Cell (POC) structure. That is, the peripheral circuit structure PS may be disposed on the cell structure CS that includes memory cells. However, the concept of the present disclosure is not limited thereto, and by inverting the semiconductor device illustrated in FIGS. 3 to 7, the semiconductor device may be a memory device having a Cell Over Periphery (COP) structure that is opposite to the POC structure.

The cell structure CS may include a first region I and a second region II surrounding the first region I in a plan view. In some implementations, the first region I may be a cell array region, and the second region II may be a pad region or an extension region. The first and second regions I and II of the cell structure CS may collectively form a cell region.

That is, memory cells, each including a gate electrode, a channel, and a charge storage structure, may be provided in the first region I of the cell structure CS, and contact plugs for transmitting signals to the memory cells and pads of the gate electrodes contacting the contact plugs may be provided in the second region II of the cell structure CS. While the drawings illustrate the second region II completely surrounding the first region I, the concept of the present disclosure is not limited thereto, and, for example, the second region II may be disposed only at opposite sides in the second direction D2 of the first region I.

Hereinafter, for convenience of explanation, a portion of the peripheral circuit structure PS and a portion of the bonding structure BS that overlap with the first region I of the cell structure CS in the first direction D1 will also be referred to as the first region I, and a portion of the peripheral circuit structure PS and a portion of the bonding structure BS that overlap with the second region II of the cell structure CS in the first direction D1 will also be referred to as the second region II.

The semiconductor device may include a plurality of memory blocks arranged along the third direction D3. Specifically, a first portion of the first region I where the memory channel structures 460 are provided and portions of the second region II disposed at opposite sides of the first portion of the first region I in the second direction D2 may together define a main memory block MBK. Additionally, a second portion of the first region I where the capacitor structures 650 are provided and portions of the second region II disposed at opposite sides of the second portion of the first region I in the second direction D2 may together define a dummy memory block DBK. In some implementations, the main memory block MBK may comprise a plurality of main memory blocks MBK that are spaced apart from each other in the third direction D3, and the dummy memory block DBK may comprise a plurality of dummy memory blocks DBK that are spaced apart from each other in the third direction D3. The main memory blocks MBK and the dummy memory blocks DBK may be arranged in various layouts in the third direction D3.

The first CSP 980 may include, e.g., polysilicon doped with n-type impurities. In some implementations, the first CSP 980 may include a metal silicide layer and polysilicon layer doped with n-type impurities that are sequentially stacked. The metal silicide layer may include, e.g., tungsten silicide. The ninth insulating interlayer 990 may contact a sidewall of the first CSP 980.

The gate electrode structure may include gate electrodes which may be disposed at a plurality of levels, respectively and spaced apart from each other in the first direction D1. Each of the gate electrodes may extend in the second direction D2.

Hereinafter, for convenience of explanation, a portion of the gate electrode structure provided in the main memory block MBK will be referred to as a first gate electrode structure, and a portion of the gate electrode structure provided in the dummy memory block DBK will be referred to as a second gate electrode structure.

The first gate electrode structure may include first to third gate electrodes 751, 753, and 755 sequentially stacked in the first direction D1. Each of the first and third gate electrodes 751 and 755 may be disposed at one or a plurality of levels, and the second gate electrodes 753 may be disposed at a plurality of levels. In FIGS. 3 to 5 and FIG. 7, the first gate electrode 751 is disposed at one level and the third gate electrodes 755 are disposed at two levels, respectively. However, the present disclosure is not limited thereto. That is, the number of first gate electrodes 751 and the number of third gate electrodes 755 may be varied.

In some implementations, the first gate electrode 751 may serve as a ground selection line (GSL), the second gate electrodes 753 may serve as word lines, and the third gate electrodes 755 may serve as string selection lines (SSL).

However, gate electrodes may be additionally formed in one or more levels below the GSL and/or above the SSL to serve as GIDL (Gate Induced Drain Leakage) gate electrodes enabling body erase using the GIDL phenomenon. Also, some of the second gate electrodes 753 respectively formed in multiple levels between the GSL and the SSL may be dummy word lines.

The second gate electrode structure may include a plurality of fourth gate electrodes 757 spaced apart from each other along the first direction D1.

Each of the first to fourth gate electrodes 751, 753, 755, and 757 may include a gate conductive pattern and a gate barrier pattern covering a surface of the gate conductive pattern. The gate conductive pattern may include a metal (e.g. a metal having a low resistance), e.g., tungsten, titanium, tantalum, platinum, etc., and the gate barrier pattern may include a metal nitride, e.g., titanium nitride, tantalum nitride, etc.

The first insulation patterns 315 may be disposed between the first to fourth gate electrodes 751, 753, 755, and 757, on an upper surface of an uppermost third gate electrode 755, on an upper surface of an uppermost fourth gate electrode 757, between the first gate electrode 751 and the first CSP 980, between the first gate electrode 751 and the ninth insulating interlayer 990, and between a lowermost fourth gate electrode 757 and the ninth insulating interlayer 990. The first insulation pattern 315 may include an oxide, e.g., silicon oxide.

In some implementations, the gate electrode structure may have a staircase shape in which lengths in the second direction D2 decreases in a stepwise manner in the second direction D2 from a lowermost level toward an uppermost level, and may include steps arranged in the second direction D2 on the second region II of the cell structure CS. In some implementations, the gate electrode structure may further include steps arranged in the third direction D3 on the second region II of the cell structure CS.

Hereinafter, a portion of each of the gate electrodes corresponding to each of the steps of the gate electrode structure, that is, an end portion of each of the gate electrodes that may not overlapped by upper ones of the gate electrodes may be referred to as a pad. Accordingly, the pad of each of the gate electrodes may be disposed on the second region II of the cell structure CS. In some implementations, the pad of each of the first to fourth gate electrodes 751, 753, 755, and 757 may have a greater thickness (e.g. in the first direction D1) than other portions of the same gate electrode.

In some implementations, each of the memory blocks may include the gate electrode structure, and accordingly, the gate electrode structure may comprise a plurality of gate structures spaced apart from each other in the third direction D3. The third division pattern 620 extending in the second direction D2 may be disposed between adjacent ones of the memory blocks in the third direction D3, that is, between the gate electrode structures, so as to separate the gate electrode structures. In some implementations, the third division pattern 620 may extend through the first to fourth insulating interlayers 340, 350, 470, and 500, the gate electrode structure, the first CSP 980 and the ninth insulating interlayer 990 in the first and second regions I and II. In some implementations, the third division pattern 620 may extend in the first direction D1 through the first to fourth insulating interlayers 340, 350, 470, and 500, and the gate electrode structure, and may extend in the first direction D1 at least partially into (e.g. into an upper portion of) the first CSP 980 and the ninth insulating interlayer 990, in the first and second regions I and II.

The fourth division pattern 625 may be disposed within each of the memory blocks, and may extend in the second direction D2 through the first to fourth insulating interlayers 340, 350, 470 and 500, the gate electrode structure, the first CSP 980 and the ninth insulating interlayer 990 in the first and second regions I and II. In some implementations, the fourth division pattern 625 may extend in the first direction D1 through the first to fourth insulating interlayers 340, 350, 470 and 500 and the gate electrode structure, and may extend in the first direction D1 at least partially into (e.g. into an upper portion of) the first CSP 980 and the ninth insulating interlayer 990, in the first and second regions I and II. Unlike the third division pattern 620, the fourth division pattern 625 may not extend continuously to an end of the second region II, and may include a plurality of portions spaced apart from each other in the second direction D2.

In some implementations, the fourth division pattern 625 may extend in the second direction D2 in the first region I and a portion of the second region II adjacent to the first region I where the third gate electrodes 755 are provided. Accordingly, each of the third gate electrodes 755 may be divided in the third direction D3 by the fourth division pattern 625.

The second division pattern 490 may be provided within the main memory block MBK and may extend in the second direction D2 in the first region I and the portion of the second region II adjacent to the first region I where the third gate electrodes 755 are provided. The second division pattern 490 may extend through upper two levels of the first gate electrode structures where the third gate electrodes 755 are disposed. Accordingly, each of the third gate electrodes 755 may be additionally divided in the third direction D3 by the second division pattern 490.

The first division pattern 330 may be provided within the main memory block MBK and may extend through a portion of the first gate electrode 751 in the second region II. The first division pattern 330 may comprise a plurality of first division patterns 330 spaced apart from each other in the second and third directions D2 and D3. In some implementations, the first division pattern 330 may contact end portions in the second direction D2 of the fourth division pattern 625. Accordingly, each of the first gate electrodes 751 may be divided in the third direction D3 by the first and fourth division patterns 330 and 625.

While the drawings illustrate the first and second division patterns 330 and 490 provided only within the main memory block MBK, the concept of the present disclosure is not limited thereto. That is, the first and fourth division patterns 330 and 625 may also be provided within the dummy memory block DBK.

Each of the first to fourth division patterns 330, 490, 620, and 625 may include an oxide, e.g., silicon oxide.

In some implementations, each of the main memory blocks MBK may include, per level, two first gate electrodes 751 divided by the first division pattern 330, one second gate electrode 753, and four third gate electrodes 755 divided by the second and fourth division patterns 490 and 625. However, the concept of the present disclosure is not limited thereto. In some implementations, each of the dummy memory blocks DBK may include one fourth gate electrode 757 per level. However, the concept of the present disclosure is not limited thereto.

The memory channel structure 460 may be provided in a portion of the main memory block MBK in the first region I. The memory channel structure 460 may extend in the first direction D1 through the second and third insulating interlayers 350 and 470, the first to third gate electrodes 751, 753, and 755, and the first insulation patterns 315 of each of the main memory blocks MBK and contact the first CSP 980.

The memory channel structure 460 may include a channel 430 having a shape of a cup, a first filling pattern 440 having a shape of pillar that may extend in the first direction D1 and fill a space defined by an upper portion of the channel 430, a first capping pattern 450 contacting upper surfaces of the first filling pattern 440 and the channel 430, and a charge storage structure 420 on an outer sidewall of the first capping pattern 450 and an upper outer sidewall of the channel 430.

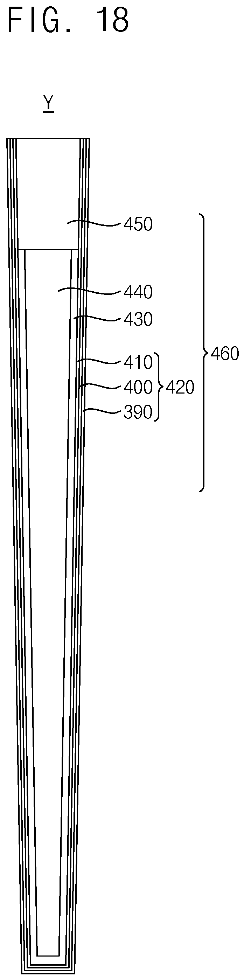

In FIGS. 1 to 7, together with FIG. 18, the charge storage structure 420 may include a tunnel insulation pattern 410, a charge storage pattern 400 and a first blocking pattern 390 sequentially stacked in the horizontal direction on the outer sidewall of the channel 430.

The channel 430 may include, for example, undoped polysilicon, the first filling pattern 440 may include an oxide, for example, silicon oxide, and the first capping pattern 450 may include, for example, polysilicon doped with n-type impurities.

Each of the tunnel insulation pattern 410 and the first blocking pattern 390 may include an oxide, for example, silicon oxide, and the charge storage pattern 400 may include a nitride, for example, silicon nitride.

In some implementations, the memory channel structure 460 may comprise a plurality of memory channel structures 460 that are spaced apart from each other in the second and third directions D2 and D3 in the portion of the main memory block MBK in the first region I and form a memory channel structure array. The memory channel structures 460 of the memory channel structure array may be connected to each other by the first CSP 980. Specifically, a lower outer sidewall and a lower surface of each of the channels 430 may not be covered by the charge storage structure 420, and the first CSP 980 may contact the uncovered lower outer sidewall and the lower surface of each of the channels 430 so as to electrically connect the channels 430 to each other. Accordingly, the first CSP 980 may comprise a plurality of first CSPs 980 that are spaced apart from each other in the third direction D3 corresponding to the main memory blocks MBK.

The support structure 489 may be provided in the second region II, and may extend through the second and third insulating interlayers 350 and 470, the first to fourth gate electrodes 751, 753, 755, and 757, the first insulation patterns 315, and the ninth insulating interlayer 990. In particular implementations, the support structure 489 may may extend in the first direction D1 through the second and third insulating interlayers 350 and 470, the first to fourth gate electrodes 751, 753, 755, and 757 and the first insulation patterns 315, and may extend in the first direction D1 at least partially into (e.g. into an upper portion of) the ninth insulating interlayer 990. In example embodiments, the support structure 489 may comprise a plurality of support structures 489 that are spaced apart from each other in the second and third directions D2 and D3 in the second region II.

In some implementations, the support structure 489 may include a first extension portion and first protrusion portions. The first extension portion may have a shape of a pillar extending in the first direction D1. The first protrusion portions may protrude from a sidewall of the first extension portion and may be spaced apart from each other in the first direction D1. The first protrusion portions may be respectively protruding from portions of the sidewall of the first extension portion facing the first to fourth gate electrodes 751, 753, 755 and 757. In some implementations, an outer radius of an uppermost first protrusion portion may be greater than an outer radius of respective first protrusion portions in lower levels. The support structure 489 may include an oxide, for example, silicon oxide.

The capacitor structure 650 may be provided in a portion of the dummy memory block DBK in the first region I, and may extend in the first direction D1 through the second and third insulating interlayers 350 and 470, the fourth gate electrodes 757, the first insulation pattern 315, and an upper portion of the ninth insulating interlayer 990.

The capacitor structure 650 may include a second filling pattern 646 having a shape of a pillar extending in the first direction D1, a first capacitor electrode 644 covering an outer sidewall and a lower surface of the second filling pattern 646, a second capping pattern 648 contacting upper surfaces of the second filling pattern 646 and the first capacitor electrode 644, and a dielectric pattern 642 covering an outer sidewall of the second capping pattern 648 and an outer sidewall and a lower surface of the first capacitor electrode 644.

In some implementations, the capacitor structure 650 may include a second extension portion and second protrusion portions. The second extension portion may have a shape of a pillar extending in the first direction D1. The second protrusion portions may protrude from a sidewall of the second extension portion and may be spaced apart from each other in the first direction D1. The second protrusion portions may be respectively protruding from portions of the sidewall of the second extension portion facing the first insulation patterns 315.

Hereinafter, for convenience of explanation, a pillar axis of the capacitor structure 650 will be referred to as a central axis C. In some implementations, a first distance d1 in the horizontal direction from the central axis C to a sidewall of the first insulation pattern 315 may be greater than a second distance d2 in the horizontal direction from the central axis C to a sidewall of the fourth gate electrode 757 disposed immediately above or below the first insulation pattern 315.

The first capacitor electrode 644 may include a third extension portion and third protrusion portions. The third extension portion of the first capacitor electrode 644 may extend in the first direction D1 and may have a shape of a cup. The third protrusion portions may protrude in the horizontal direction from a sidewall of the third extension portion and may be spaced apart from each other in the first direction D1. The third protrusion portions may respectively protruding in the horizontal direction from portions of the sidewall of the third extension portion facing the first insulation patterns 315.

In some implementations, a difference between an outer radius OR and an inner radius IR of a first portion of the first capacitor electrode 644 where the third protrusion portion is formed may be greater than a difference between the outer radius OR and the inner radius IR of a second portion of the first capacitor electrode 644 where the third protrusion portion is not formed. That is, a first thickness T1 in the horizontal direction of the first portion of the first capacitor electrode 644 where the third protrusion portion is formed may be greater than a second thickness T2 in the horizontal direction of the second portion of the first capacitor electrode 644 where the third protrusion portion is not formed.

The outer radius OR of the first capacitor electrode 644 may periodically increase and decrease along the first direction D1 with increasing distance from a lower surface of the ninth insulating interlayer 990 (e.g. decreasing distance from the second substrate 900), and the inner radius IR of the first capacitor electrode 644 may steadily increase along the first direction D1 with increasing distance from the lower surface of the ninth insulating interlayer 990 in the first direction D1 (e.g. decreasing distance from the second substrate 900). The outer radius OR of the first capacitor electrode 644 may increase at heights corresponding to the first insulation patterns 315.

The dielectric pattern 642 may be disposed along an outer sidewall of the third extension portion of the first capacitor electrode 644, and upper and lower surfaces and outer sidewalls of the third protrusion portions of the first capacitor electrode 644. Accordingly, a cross-section of the dielectric pattern 642 determined by the first direction D1 and the horizontal direction may have a zigzag shape rather than a straight line.

While the drawings illustrate the dielectric pattern 642 as a single layer, the concept of the present disclosure is not limited thereto. That is, the dielectric pattern 642 may also include multiple layers.

The dielectric pattern 642 may include an oxide, for example, silicon oxide or a metal oxide having a high dielectric constant, such as hafnium oxide (HfO₂), zirconium oxide (ZrO₂), etc. A "high dielectric constant" may be a dielectric constant that is higher than the dielectric constant of silicon oxide. The first capacitor electrode 644 may include a conductive material, such as a metal, for example, titanium, tantalum, etc., or a metal nitride, for example, titanium nitride, tantalum nitride, etc. The second filling pattern 646 may include an oxide, for example, silicon oxide. The second capping pattern 648 may include a metal, for example, titanium, tantalum, etc., or a metal nitride, for example, titanium nitride, tantalum nitride, etc.

In some implementations, the capacitor structure 650 may comprise a plurality of capacitor structures 650 that are spaced apart from each other in the second and third directions D2 and D3 in the portion of the dummy memory block DBK on the first region I.

Meanwhile, a portion of each of the fourth gate electrodes 757 adjacent to the first capacitor electrode 644 may serve as capacitor electrode together with the first capacitor electrode 644. Accordingly, a portion of each of the fourth gate electrodes 757 adjacent to the first capacitor electrode 644 may be referred to as the second capacitor electrode 640.

The first capacitor electrode 644 to which a power supply voltage is applied, the fourth gate electrode 757 or the second capacitor electrode 640 to which a ground voltage is applied, and a portion of the second blocking pattern 615 and a portion of the dielectric pattern 642 interposed between the first and second capacitor electrodes 644 and 640 may together form a capacitor. Alternatively, the ground voltage may be applied to the first capacitor electrode 644, and the power supply voltage may be applied to the fourth gate electrode 757 or the second capacitor electrode 640.

The second blocking pattern 615 may cover upper and lower surfaces of each of the first to fourth gate electrodes 751, 753, 755, and 757, and sidewalls of each of the first to fourth gate electrodes 751, 753, 755, and 757 facing the memory channel structures 460, the support structures 489, the capacitor structures 650 and the first to fourth contact plugs 682, 684, 686, and 688. The second blocking pattern 615 may include a metal oxide, for example, aluminum oxide, hafnium oxide, etc.

Each of the first to third contact plugs 682, 684, and 686 may extend through the first to fourth insulating interlayers 340, 350, 470, and 500, the first to third gate electrodes 751, 753, and 755, the first insulation patterns 315, and an upper portion the ninth insulating interlayer 990 in the portion of the main memory block MBK in the second region II.

In some implementations, the first contact plug 682 may extend through a pad of the first gate electrode 751. The second contact plug 684 may extend through a pad of a corresponding second gate electrode 753 and the second gate electrodes 753 and the first gate electrode 751 therebelow. The third contact plug 686 may extend through a pad of the corresponding third gate electrode 755 and the third gate electrode 755 and the first and second gate electrodes 751 and 753 therebelow.

Each of the fourth contact plugs 688 may extend through first to fourth insulating interlayers 340, 350, 470, and 500, the fourth gate electrodes 757, the first insulation patterns 315, and an upper portion of the ninth insulating interlayer 990 in the portion of the dummy memory block DBK on the second region II.

In some implementations, the fourth contact plug 688 may extend through a pad of a corresponding fourth gate electrode 757 and the fourth gate electrodes 757 therebelow.

In some implementations, fourth insulation patterns 680 may be respectively disposed at portions of a sidewall of each of the first to fourth contact plugs 682, 684, 686, and 688 that faces the first to fourth gate electrodes 751, 753, 755, and 757. However, the fourth insulation patterns 680 may not be disposed at a portion of the sidewall of each of the first to fourth contact plugs 682, 684, 686, and 688 that faces the uppermost gate electrode, that is, the gate electrode including the pad through which each of the first to fourth contact plugs 682, 684, 686, and 688 extends.

Each of the first to fourth contact plugs 682, 684, 686, and 688 may include a fourth protrusion portion. The fourth protrusion portion may protrude in the horizontal direction, be disposed at the portion of the sidewall of each of the first to fourth contact plugs 682, 684, 686, and 688 that faces the uppermost gate electrode, and directly contact the uppermost gate electrode.

The fourth insulation patterns 680 may include an oxide, for example, silicon oxide.

In some implementations, each of the first to fourth contact plugs 682, 684, 686, and 688 may include a conductive pattern and a barrier pattern covering a surface of the conductive pattern. The conductive pattern may include a metal (e.g. a metal having low electrical resistance), for example, tungsten, titanium, tantalum, platinum, etc., and the barrier pattern may include a metal nitride, for example, titanium nitride, tantalum nitride, etc.

Meanwhile, the first to fourth division patterns 330, 490, 620, and 625, the support structures 489, and the first to fourth contact plugs 682, 684, 686, and 688 may be arranged in various layouts

The fifth contact plug 702 may extend through the fifth and fourth insulating interlayers 700 and 500 to contact an upper surface of the memory channel structure 460. The sixth contact plug 704 may extend through the fifth insulating interlayer 700 to contact an upper surface of the capacitor structure 650. The seventh to tenth contact plugs 712, 714, 716, and 718 may extend through the fifth insulating interlayer 700 to respectively contact upper surfaces of the first to fourth contact plugs 682, 684, 686, and 688.

The first to sixth wirings 722, 724, 732, 734, 736, and 738 may extend through the sixth insulating interlayer 720 to respectively contact upper surfaces of the fifth to tenth contact plugs 702, 704, 712, 714, 716, and 718.

The eleventh to sixteenth contact plugs 742, 744, 752, 754, 756, and 758 may extend through the seventh insulating interlayer 740 to respectively contact upper surfaces of the first to sixth wirings 722, 724, 732, 734, 736, and 738.

In some implementations, each of the fifth to sixteenth contact plugs 702, 704, 712, 714, 716, 718, 742, 744, 752, 754, 756, and 758 and the first to sixth wirings 722, 724, 732, 734, 736, and 738 may include a conductive pattern and a barrier pattern covering a surface of the conductive pattern. The conductive pattern may include a metal (e.g. a metal with low electrical resistance), for example, tungsten, titanium, tantalum, platinum, etc., and the barrier pattern may include a metal nitride, for example, titanium nitride, tantalum nitride, etc.

Meanwhile, the fifth to sixteenth contact plugs 702, 704, 712, 714, 716, 718, 742, 744, 752, 754, 756, and 758 and the first to sixth wirings 722, 724, 732, 734, 736, and 738 may be arranged in various layouts.

The ninth insulating interlayer 989 and each of the first to seventh insulating interlayers 340, 350, 470, 500, 700, 720, and 740 may include an oxide, for example, silicon oxide.

The peripheral circuit structure PS may include an active pattern 905, an isolation pattern 910, a transistor, a seventeenth contact plug 940, a wiring structure 945, and an eighth insulating interlayer 950 disposed below the second substrate 900.

The second substrate 900 may include a semiconductor material, for example, silicon, germanium, silicon-germanium, or a III-V compound semiconductor, for example, GaP, GaAs, GaSb, etc. In some implementations, the second substrate 900 may be a silicon-on-insulator (SOI) substrate or a germanium-on-insulator (GOI) substrate.

The active pattern 905 may protrude downward from the second substrate 900, and a sidewall of the active pattern 905 may be covered by the isolation pattern 910. The active pattern 905 may be integrally formed with the second substrate 900 and may include a semiconductor material, such as silicon, which is identical to a material of the second substrate 900. The isolation pattern 910 may include an oxide, for example, silicon oxide.

The transistor may include a gate structure 930 and an impurity region 907. The gate structure 930 may include a gate insulation pattern 925 and a fifth gate electrode 927 sequentially stacked below the second substrate 900. The impurity region 907 may be provided in a portion of the active pattern 905 adjacent to the gate structure 930.

The seventeenth contact plug 940 may be provided in the eighth insulating interlayer 950 and may contact the impurity region 907.

The wiring structure 945 may be provided in the eighth insulating interlayer 950 and may contact the seventeenth contact plug 940.

The eighth insulating interlayer 950 may cover the transistor, the seventeenth contact plug 940 and the wiring structure 945.

**In** some implementations, the seventeenth contact plug 940 and various components included in the wiring structure 845 may include a conductive pattern and a barrier pattern covering a surface of the conductive pattern. The conductive pattern may include a metal (e.g. a metal with low electrical resistance), for example, tungsten, titanium, tantalum, platinum, etc., and the barrier pattern may include a metal nitride, for example, titanium nitride, tantalum nitride, etc.

The eighth insulating interlayer 950 may include an oxide, for example, silicon oxide.

The bonding structure BS may include first and second bonding layers 760 and 960 and first and second bonding patterns 765 and 965.

The first bonding layer 760 may be disposed on upper surfaces of the seventh insulating interlayer 740 and the eleventh to sixteenth contact plugs 742, 744, 752, 754, 756, and 758 of the cell structure CS, and the second bonding layer 960 may be disposed on lower surfaces of the eighth insulating interlayer 950 and the wiring structure 945 of the peripheral circuit structure PS. An upper surface of the first bonding layer 760 and a lower surface of the second bonding layer 960 may be bonded together. The first and second bonding patterns 765 and 965 may be respectively accommodated within the first and second bonding layers 760 and 960 and may contact each other.

Each of the first bonding patterns 765 may contact and be electrically connected to corresponding ones of the eleventh to sixteenth contact plugs 742, 744, 752, 754, 756, and 758. Each of the second bonding patterns 965 may contact the wiring structure 945 and be electrically connected to the transistor of the peripheral circuit structure PS through the seventeenth contact plug 940.

Accordingly, the memory channel structure 460 may be electrically connected to at least one of the transistors through the fifth contact plug 702, the first wiring 722, the eleventh contact plug 742, corresponding first and second bonding patterns 765 and 965, and the wiring structure 945. The capacitor structure 650 may be electrically connected to at least one of the transistors through the sixth contact plug 704, the second wiring 724, the twelfth contact plug 744, corresponding first and second bonding patterns 765 and 965, and the wiring structure 945. The first contact plug 682 may be electrically connected to at least one of the transistors through the seventh contact plug 712, the third wiring 732, the thirteenth contact plug 752, corresponding first and second bonding patterns 765 and 965, and the wiring structure 945. The second contact plug 684 may be electrically connected to at least one of the transistors through the eighth contact plug 714, the fourth wiring 734, the fourteenth contact plug 754, corresponding first and second bonding patterns 765 and 965, and the wiring structure 945. The third contact plug 686 may be electrically connected to at least one of the transistors through the ninth contact plug 716, the fifth wiring 736, the fifteenth contact plug 756, corresponding first and second bonding patterns 765 and 965, and the wiring structure 945. The fourth contact plug 688 may be electrically connected to at least one of the transistors through the tenth contact plug 718, the sixth wiring 738, the sixteenth contact plug 758, corresponding first and second bonding patterns 765 and 965, and the wiring structure 945.

In some implementations, the first bonding pattern 765 may include sequentially stacked lower and upper portions, and a width in the horizontal direction of the lower portion of the first bonding pattern 765 may be smaller than a width in the horizontal direction of the upper portion of the first bonding pattern 765. In some implementations, the second bonding pattern 965 may include sequentially stacked lower and upper portions, and a width in the horizontal direction of the lower portion of the second bonding pattern 965 may be greater than a width in the horizontal direction of the upper portion of the second bonding pattern 965.

Each of the first and second bonding layers 760 and 960 may include, for example, silicon carbonitride (SiCN), and each of the first and second bonding patterns 765 and 965 may include a metal, for example, copper (Cu).

In the semiconductor device, the first capacitor electrode 644 may include the third protrusion portions disposed at heights corresponding to the first insulation patterns 315. Accordingly, compared to when the first capacitor electrode 644 does not include the third protrusion portions, the distance between the first capacitor electrode 644 and the fourth gate electrode 757 may be reduced, thereby increasing the capacitance of the capacitor.

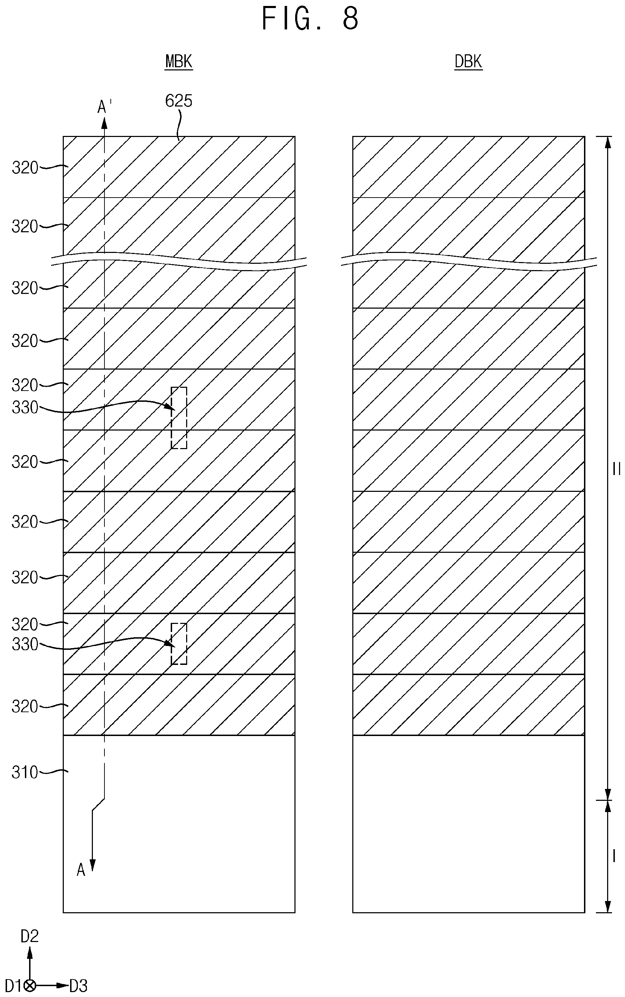

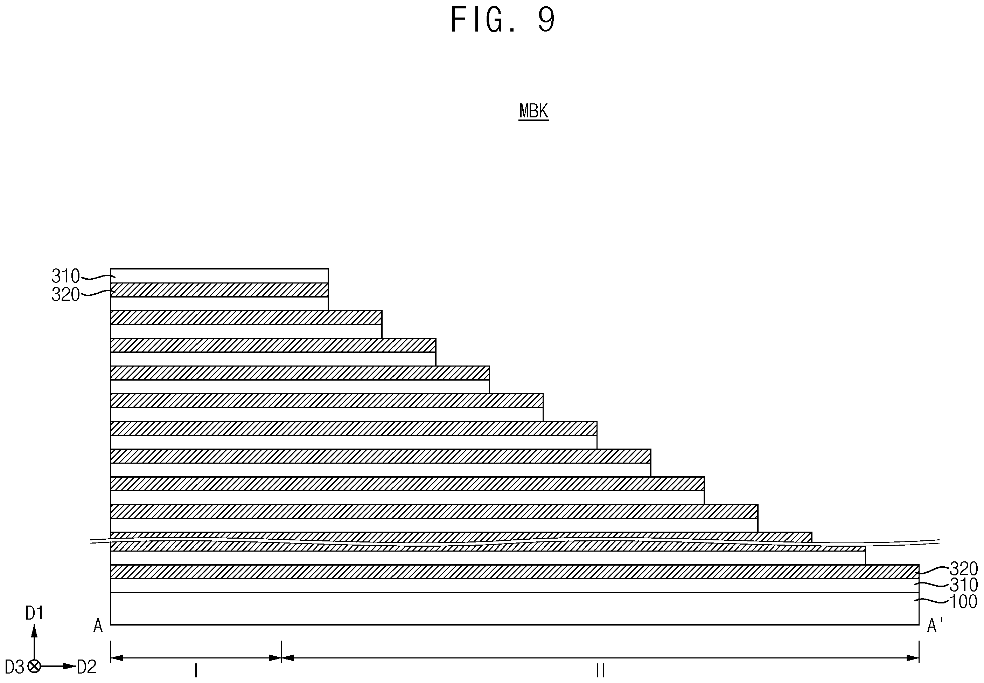

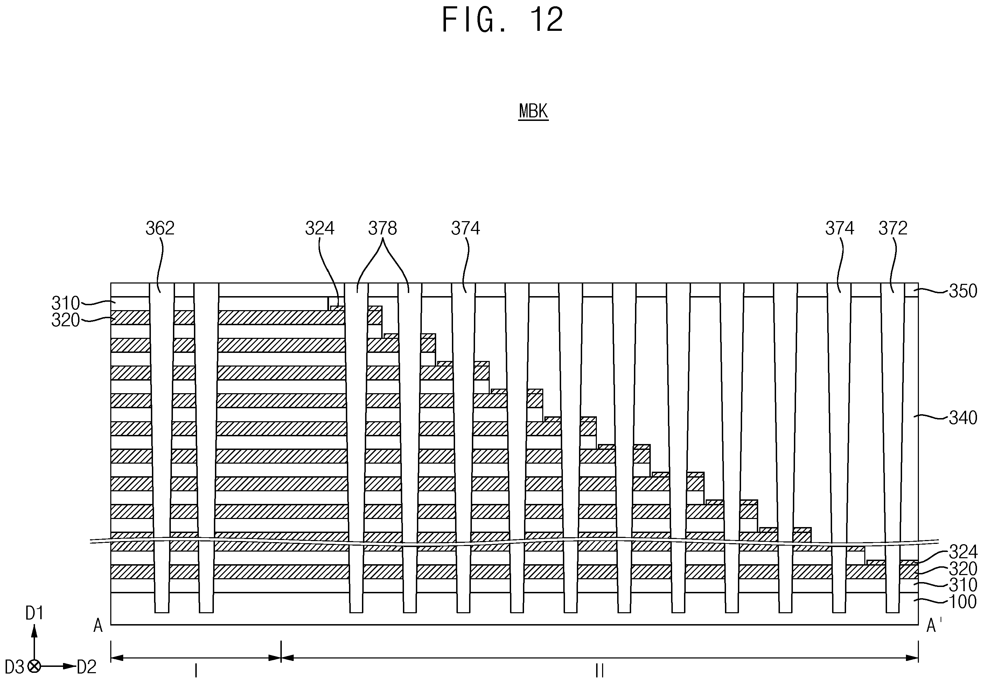

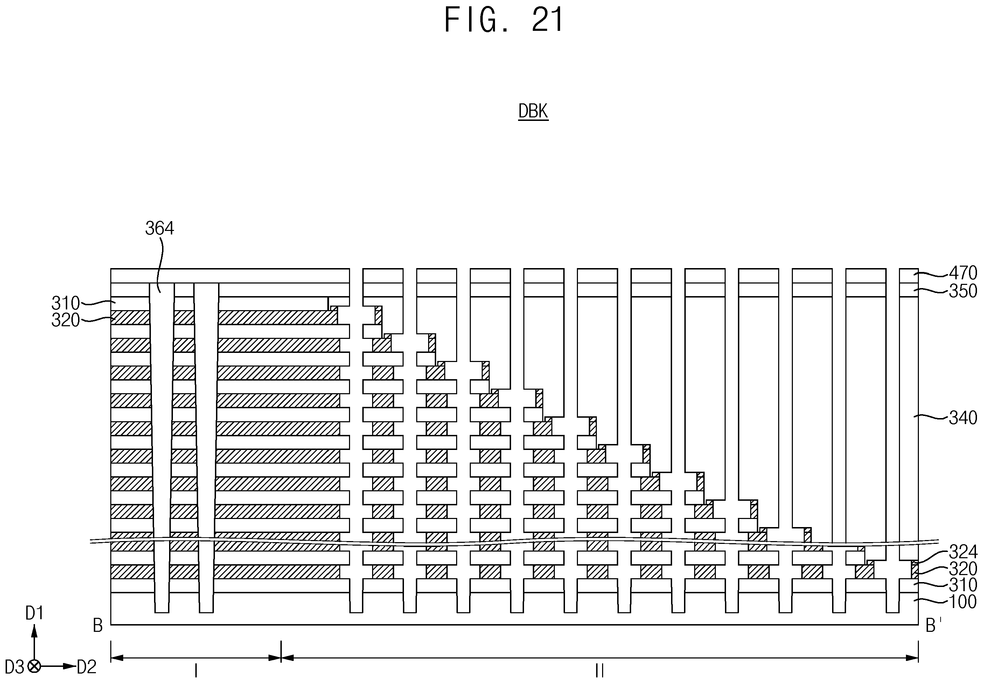

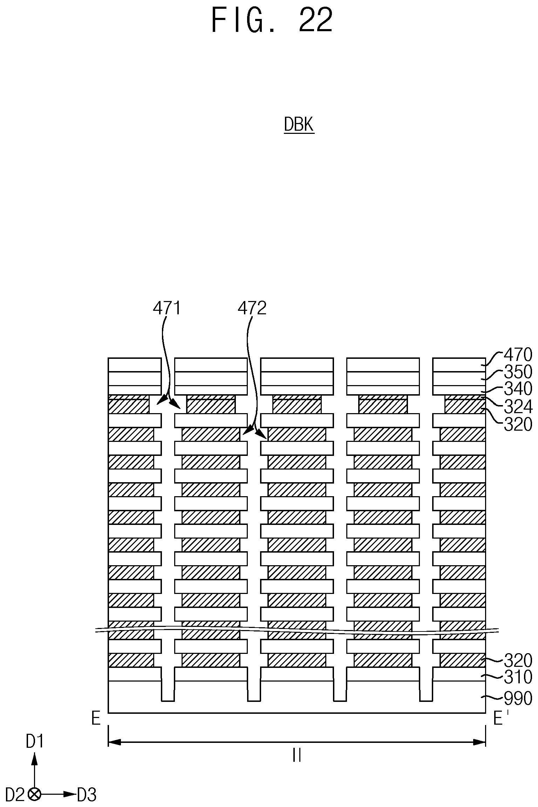

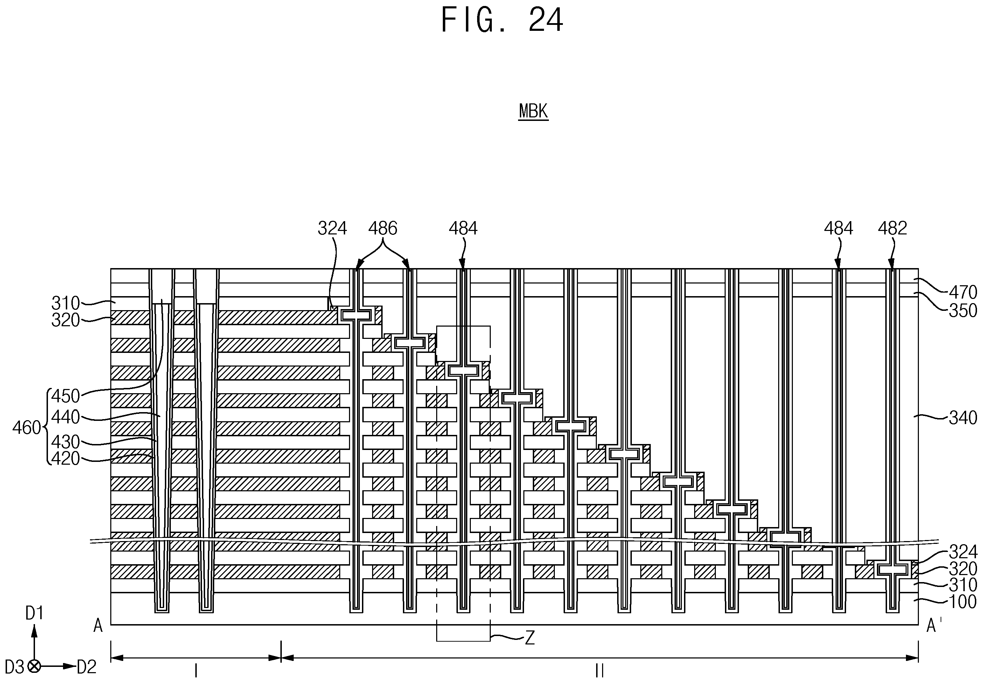

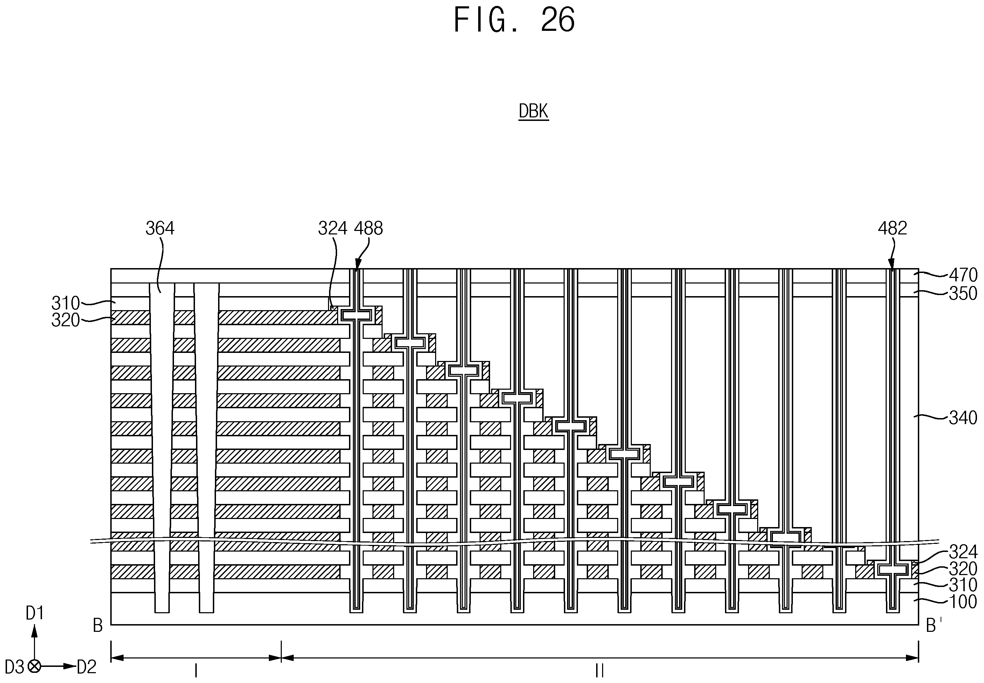

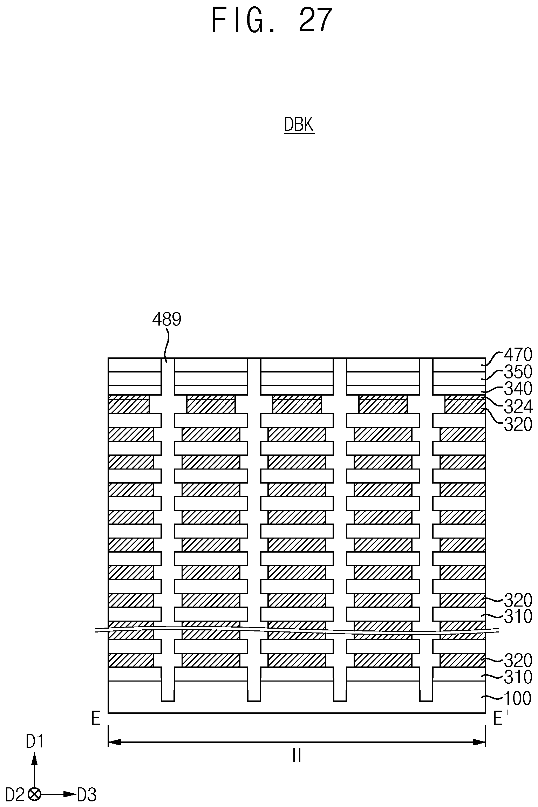

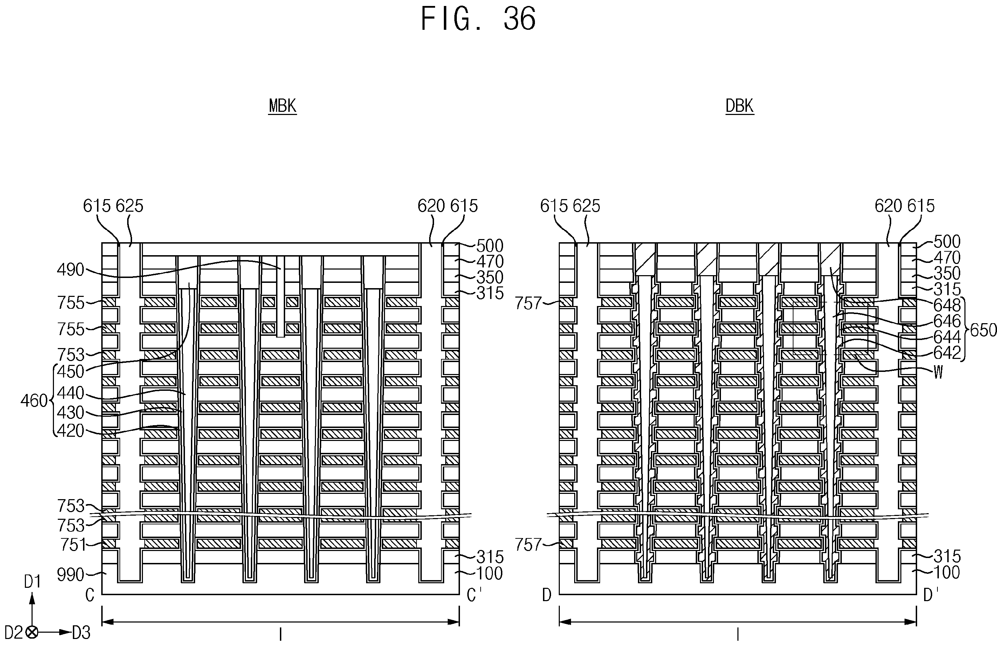

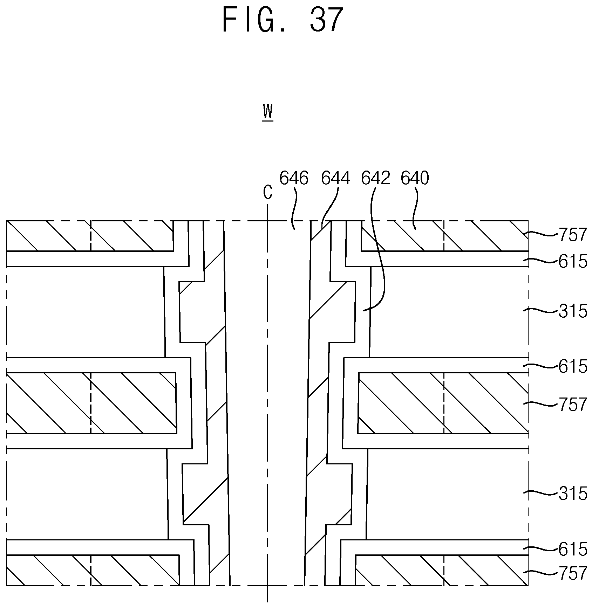

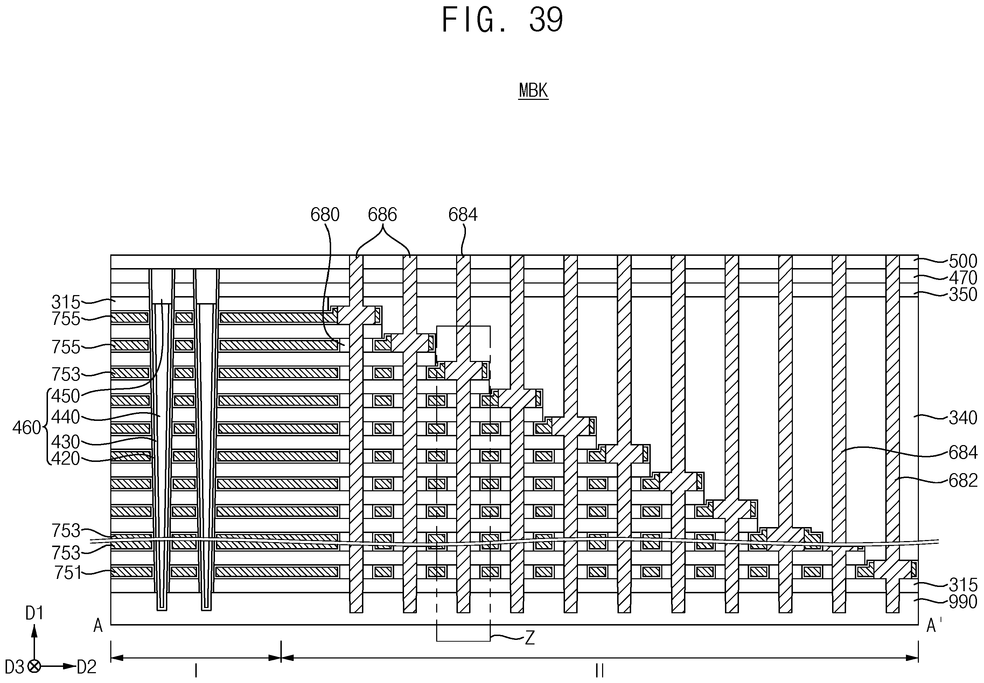

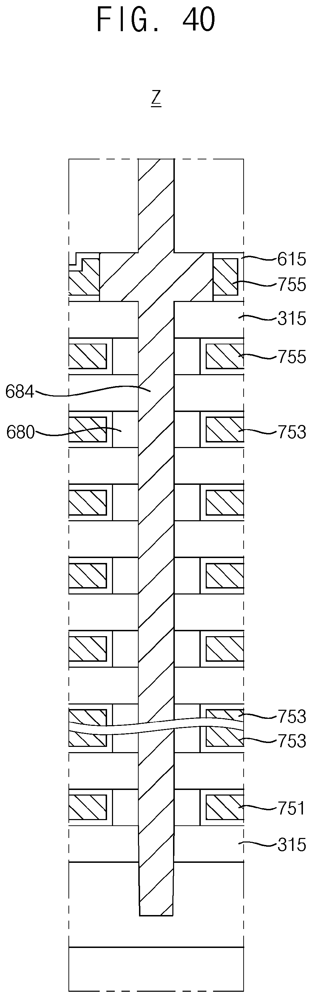

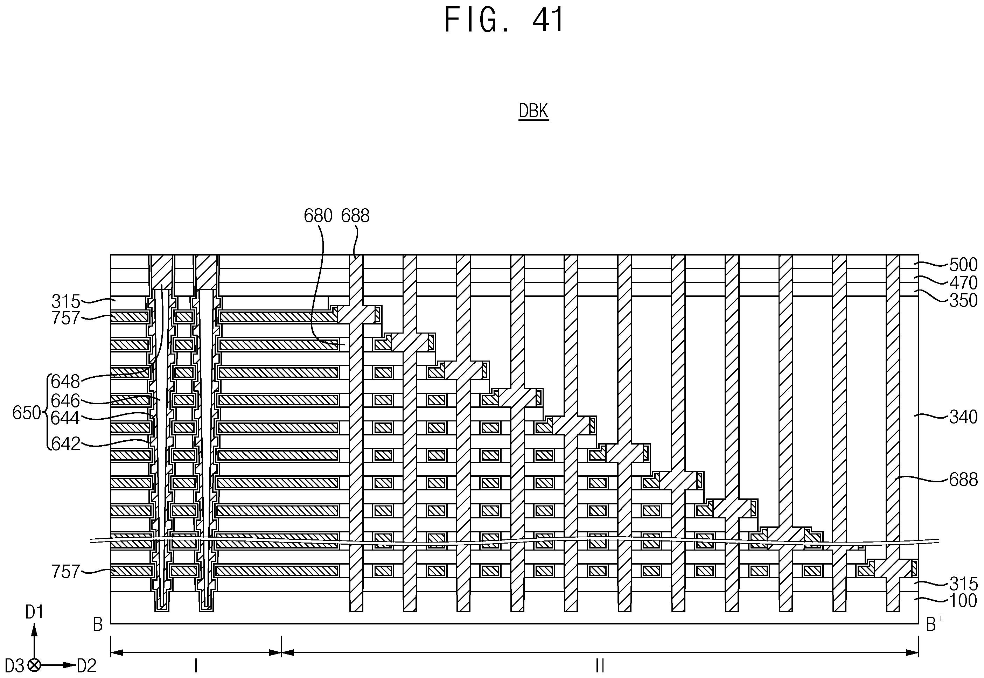

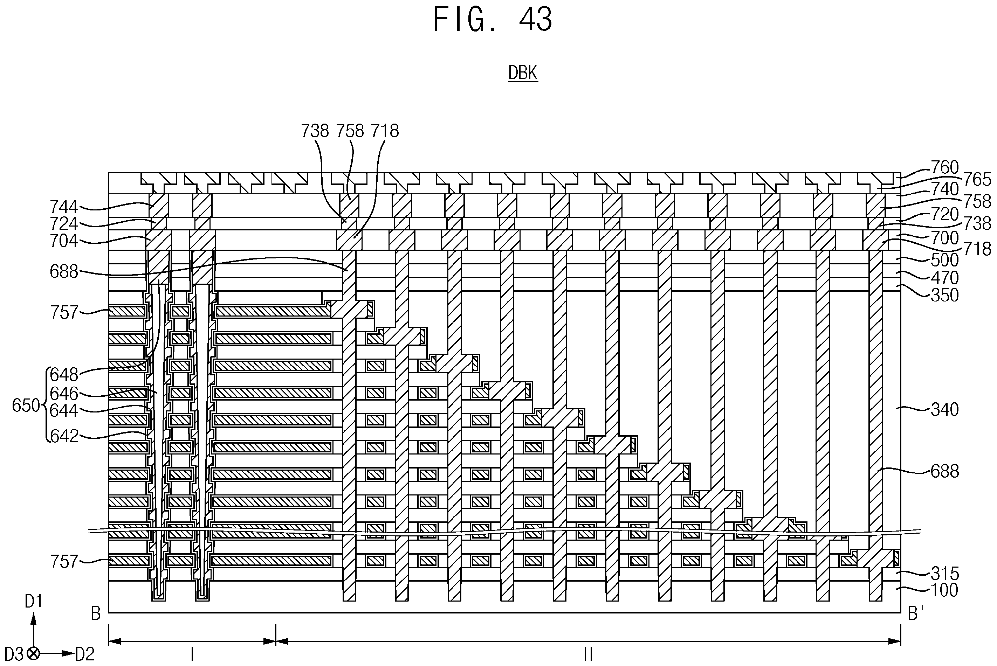

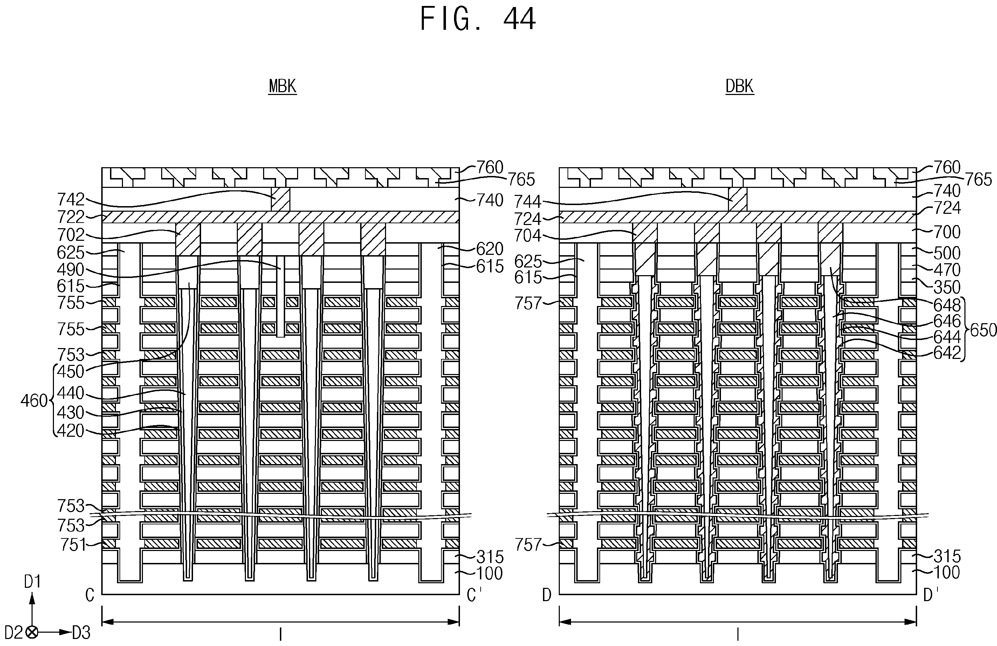

FIGS. 8 to 46 are plan views and cross-sectional views illustrating examples of methods of manufacturing a semiconductor device according to some implementations. Specifically, FIGS. 8, 11, 16, 23, 28, 31, 35, and 38 are plan views, and FIGS. 9-10, 12-15, 17-22, 24-27, 29-30, 32-34, 36-37, and 39-46 are cross-sectional views.

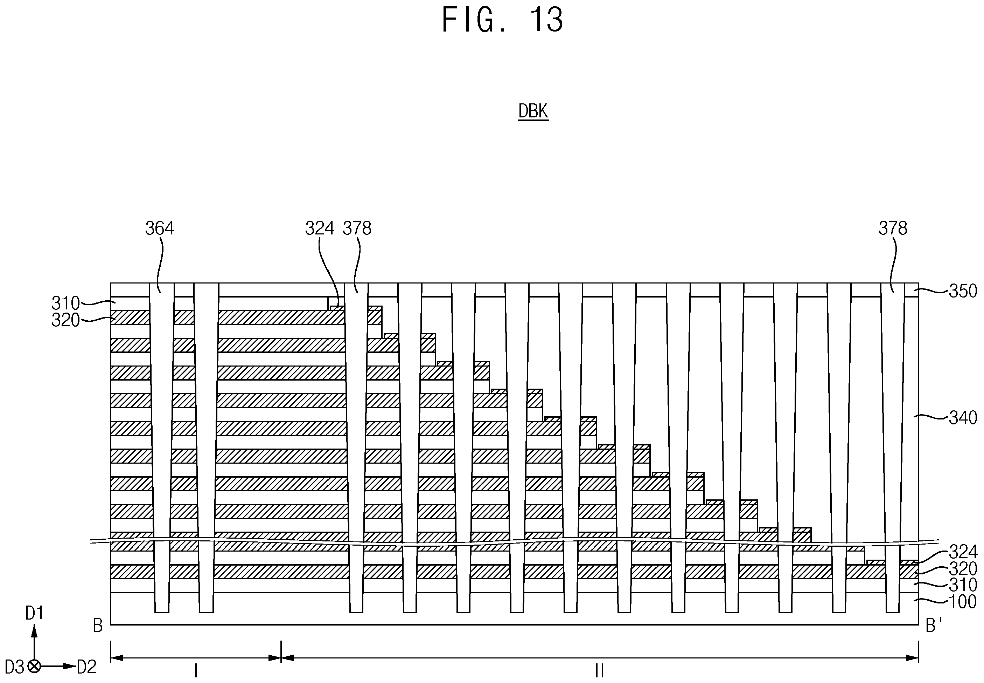

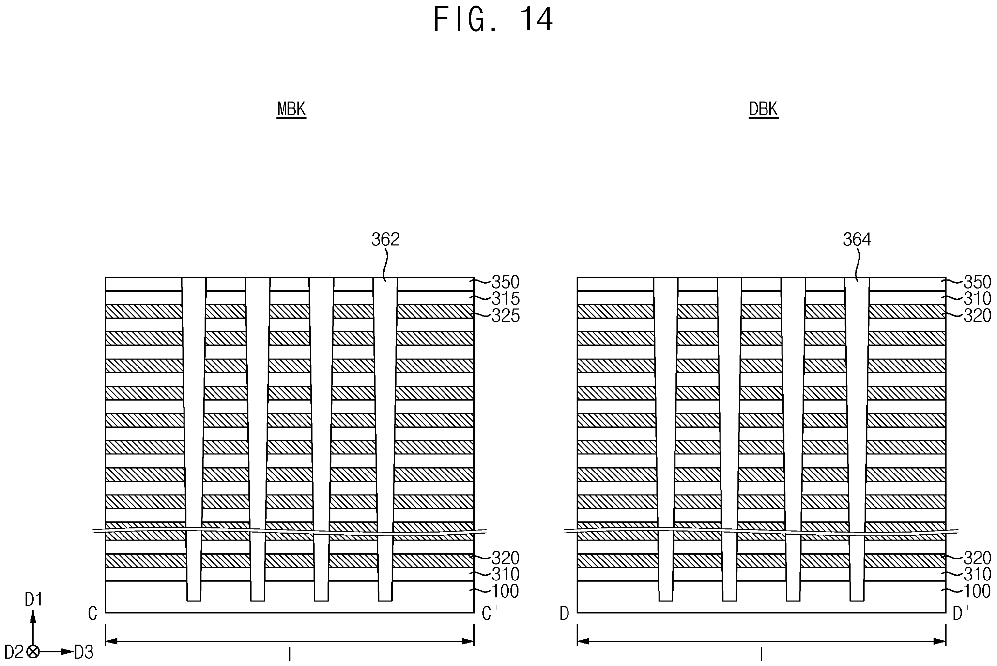

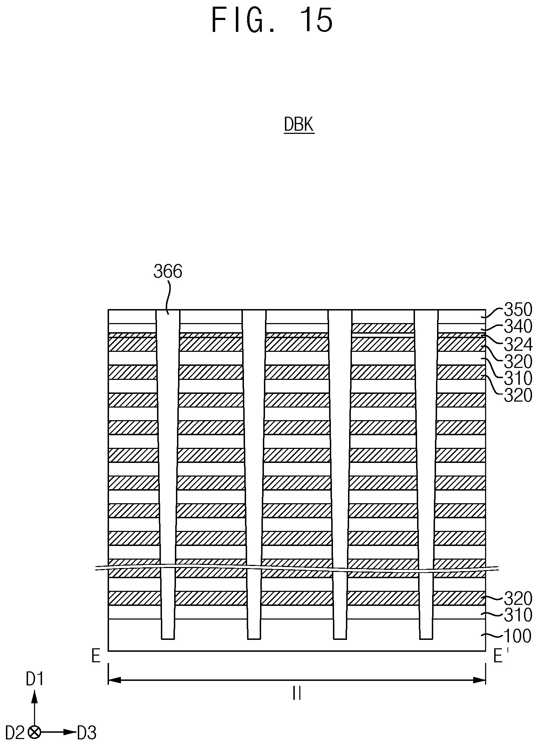

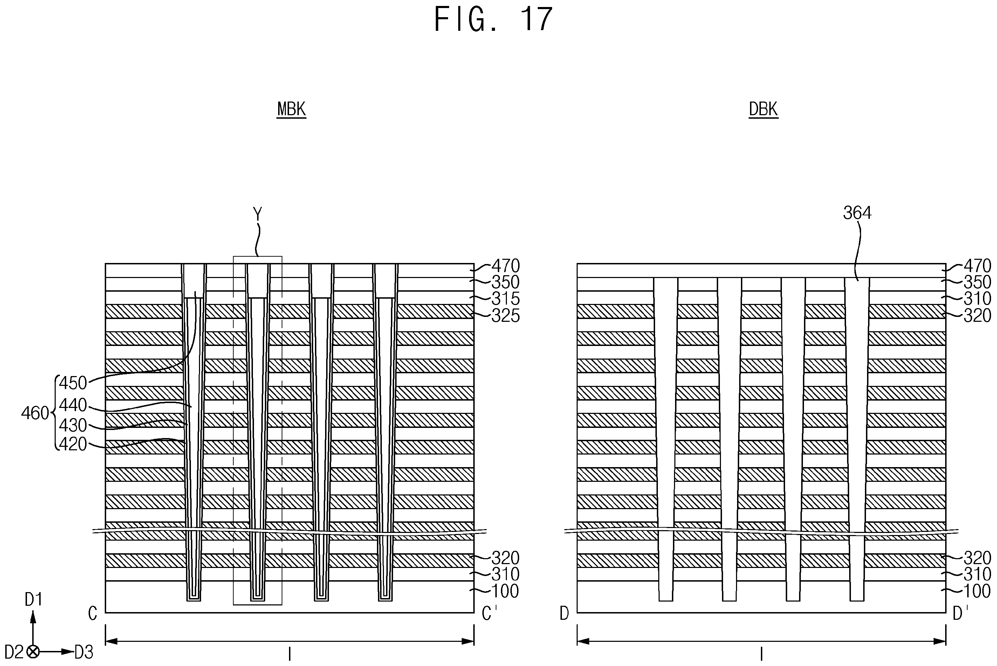

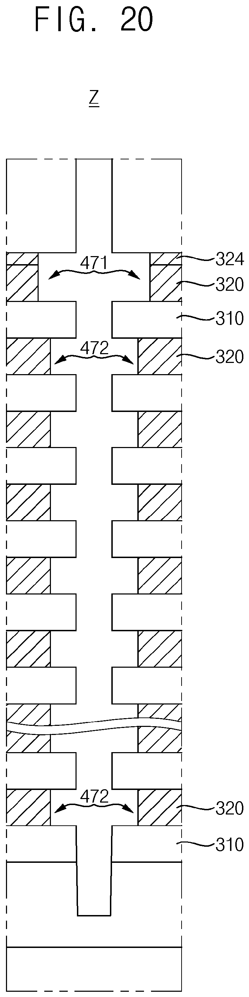

FIGS. 9-10, 12, 19-20, 24-25, 39-40, 42, and 45-46 are cross-sectional views taken along line A-A' of corresponding plan views, and FIGS. 20, 25, and 40 are enlarged cross-sectional views of a region Z of corresponding cross-sectional views. FIGS. 13, 21, 26, 41, and 43 are cross-sectional views taken along line B-B' of corresponding plan views. FIGS. 14, 17-18, 29-30, 32-34, 36-37, and 44 include cross-sectional views taken along lines C-C' and D-D' of corresponding plan views. Particularly, FIG. 18 is an enlarged cross-sectional view of a region Y of FIG. 17, and FIGS. 34 and 37 are enlarged cross-sectional views of a region W of corresponding cross-sectional views. FIGS. 15, 22, and 27 are cross-sectional views taken along line E-E' of corresponding plan views.

In FIGS. 8 and 9, a first insulation layer 310 and a first sacrificial layer 320 may be alternately and repeatedly stacked in the first direction D1 on a first substrate 100, thereby forming a mold layer including the first insulation layers 310 and the first sacrificial layers 320.

The first substrate 100 may include a semiconductor material, for example, silicon, germanium, silicon-germanium, or a III-V compound semiconductor, for example, GaP, GaAs, GaSb, etc. In some implementations, the substrate 100 may be a silicon-on-insulator (SOI) substrate or a germanium-on-insulator (GOI) substrate.

The first substrate 100 may include a first region I and a second region II surrounding the first region I in a plan view. In some implementations, the first region I may be a cell array region, and the second region II may be a pad region or an extension region. The first and second regions I and II may together form a cell region.

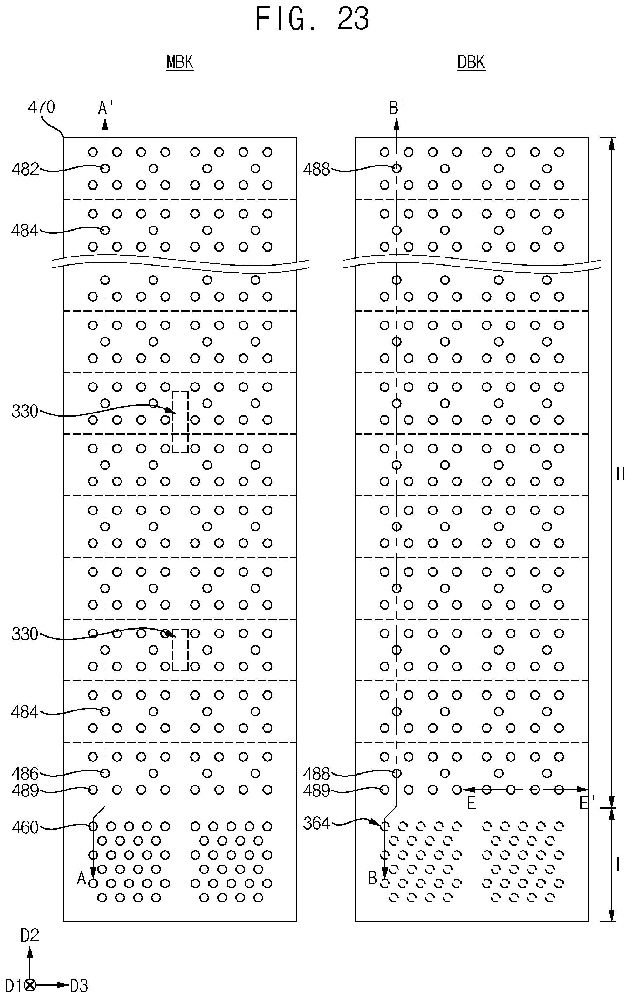

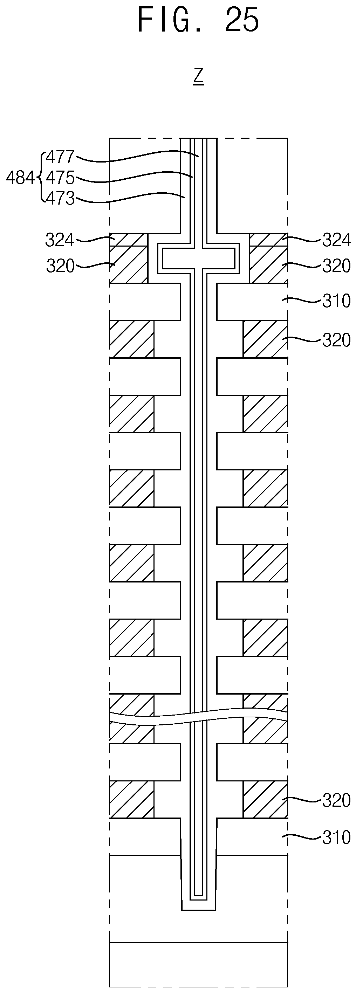

Meanwhile, as described below, a plurality of memory blocks may be formed on the first substrate 100, and first ones of the memory blocks where the memory channel structures 460 (refer to FIGS. 23 to 27) are formed will be respectively referred to as main memory blocks MBK, and second ones of the memory blocks where the capacitor structures 650 (refer to FIGS. 25 to 37) are formed will be respectively referred to as dummy memory blocks DBK.

The first insulation layer 310 may include an oxide, for example, silicon oxide, and the first sacrificial layer 320 may include a material having an etch selectivity with respect to the first insulation layer 310, for example, a nitride such as silicon nitride.

However, in a lowermost first sacrificial layer 320, a first division pattern 330 extending through a portion of the lowermost first sacrificial layer 320 may be formed. The first division pattern 330 may be formed on the second region II of the first substrate 100. In some implementations, the division pattern 330 may comprise a plurality of first division patterns 330 that are spaced apart from each other in the second and third directions D2 and D3.

Although the first division patterns 330 are illustrated as being formed only in the main memory block MBK, the concept of the present disclosure is not limited thereto, and the first division pattern 330 may also be formed in the dummy memory block DBK.

Subsequently, a photoresist pattern partially covering an uppermost first insulation layer 310 may be formed, and the uppermost first insulation layer 310 and an uppermost first sacrificial layer 320 there below may be etched using the photoresist pattern as an etching mask. Accordingly, a portion of the first insulation layers 310 directly under the uppermost first sacrificial layers 320 may be exposed.

After performing a trimming process for reducing an area of the photoresist pattern, the uppermost first insulation layer 310, the uppermost first sacrificial layer 320, the exposed first insulation layer 310 and the first sacrificial layer 320 directly under the exposed first insulation layers 310 may be etched by an etching process using the reduced photoresist pattern as an etching mask. The trimming process and the etching process may be repeatedly performed to form a mold, which may have a staircase shape and include a plurality of step layers each of which may include one first sacrificial layer 320 and one first insulation layer 310 sequentially stacked.

Hereinafter, the "step layer" may refer to all portions of the first sacrificial layer 320 and the first insulation layer 310 at the same level, which may include an unexposed portion as well as an exposed portion of the first sacrificial layer 320 and the first insulation layer 310, and a "step" may refer to only the exposed portion of the "step layer." In some implementations, the steps may be arranged in the second direction D2. In some implementations, the steps may be arranged in the third direction D3.

Each of the steps included in the mold may be formed on the second region II of the first substrate 100.

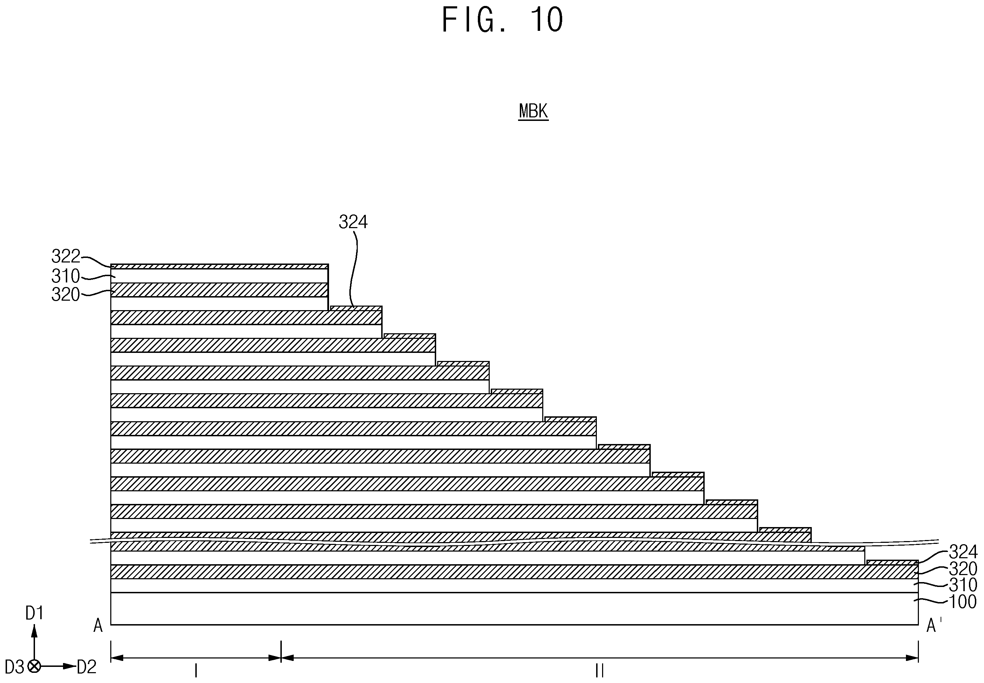

In FIG. 10, an insulation pad layer may be formed, and partially removed to form first and second insulation pads 322 and 324. In some implementations, the insulation pad layer may include the same material as the first sacrificial layer 320, however may have an etching rate different from an etching rate of the first sacrificial layer 320.

After forming the insulation pad layer, respective portions of the insulation pad layer adjacent to sidewalls of the steps of the mold may be removed to form the first insulation pad 322 on an upper surface of the uppermost first insulation layer 310 and to form the second insulation pads 324 on respective upper surfaces of the first sacrificial layers 320 that may form the steps of the mold. In some implementations, each of the first and second insulation pads 322 and 324 may extend in the third direction D3.

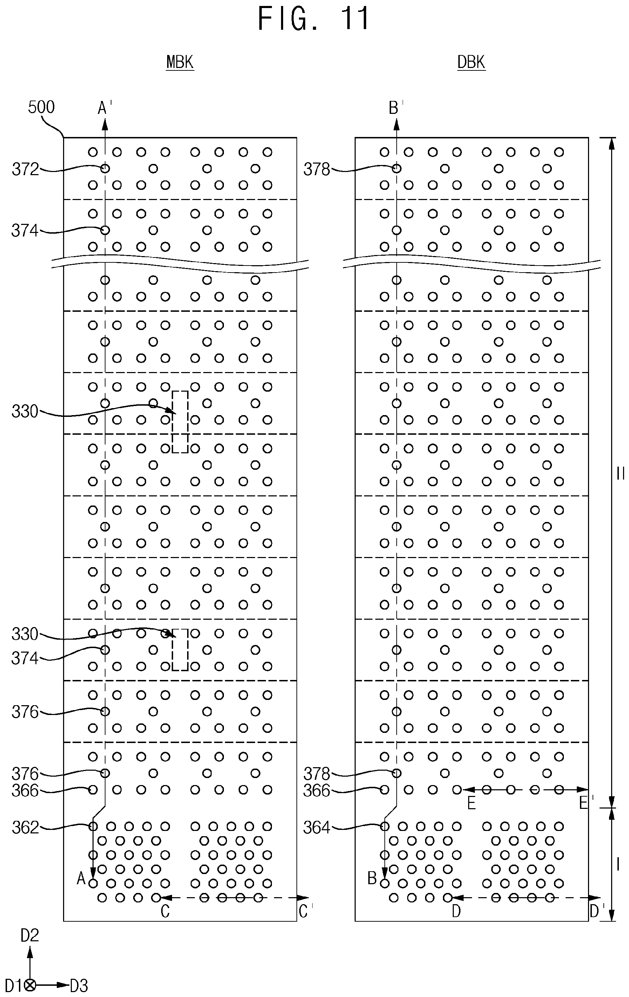

In FIGS. 11 to 15, a first insulating interlayer 340 may be formed on the mold and the first and second insulation pads 322 and 324, and may be planarized until the upper surface of the uppermost first insulation layer 310 is exposed. During the planarization, the first insulation pad 322, the uppermost first insulation layer 310, and the uppermost first sacrificial layer 320 may be removed together, and a sidewall of the mold may be covered by the first insulating interlayer 340.

A second insulating interlayer 350 may be formed on upper surfaces of the mold and the first insulating interlayer 340.

An etching process may be performed to form a first hole and a second hole that may extend in the first direction D1 through the second insulating interlayer 350, the mold, and an upper portion of the first substrate 100 on the first region I of the first substrate 100. In some implementations, the first hole may comprise a plurality of first holes that are spaced apart from each other in the second and third directions D2 and D3 in the main memory block MBK of the first substrate 100, and the second hole may comprise a plurality of second holes that are spaced apart from each other in the second and third directions D2 and D3 in the dummy memory block DBK of the first substrate 100.

Additionally, a third hole extending in the first direction D1 through the first and second insulating interlayers 340 and 350, the mold, and the upper portion of the first substrate 100 may be formed in the main memory block MBK and the dummy memory block DBK on the second region II of the first substrate 100. In some implementations, the third hole may comprise a plurality of third holes that are spaced apart from each other in the second and third directions D2 and D3 on the second region II of the first substrate 100.

Furthermore, fourth to sixth holes extending in the first direction D1 through the first and second insulating interlayers 340 and 350, the mold, and the upper portion of the first substrate 100 may be formed in the main memory block MBK on the second region II of the first substrate 100. In some implementations, each of the fourth to sixth holes may be formed between adjacent third holes in a plan view.

Also, a seventh hole extending in the first direction D1 through the first and second insulating interlayers 340 and 350, the mold, and the upper portion of the first substrate 100 may be formed in the dummy memory block DBK on the second region II of the first substrate 100. In some implementations, the seventh hole may be formed between adjacent third holes in a plan view.

In some implementations, the first to seventh holes may be simultaneously formed by a single etching process. In some implementations, the first to seventh holes may be formed by separate etching processes.

Subsequently, first to seventh sacrificial patterns 362, 364, 366, 372, 374, 376, and 378 may be formed in the first to seventh holes, respectively.

A second sacrificial layer may be formed on the second insulating interlayer 350 to fill the first to seventh holes, and the second sacrificial layer may be planarized until an upper surface of the second insulating interlayer 350 is exposed to form the first to seventh sacrificial patterns 362, 364, 366, 372, 374, 376, and 378.

In some implementations, the second sacrificial layer may include, for example, a carbon-containing insulating material, a metal, or undoped polysilicon, etc.

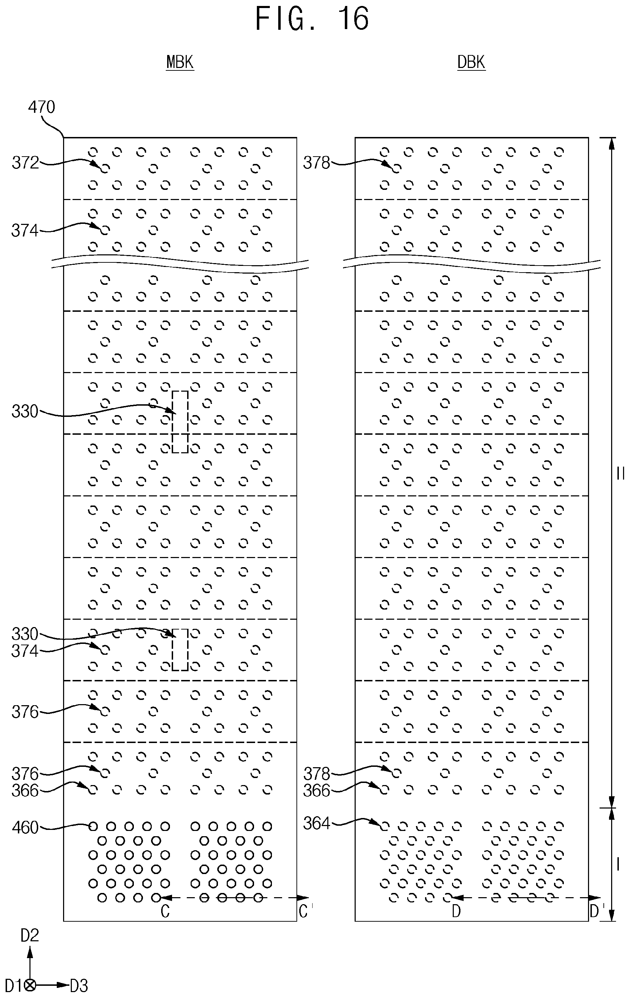

In FIGS. 16 to 18, a third insulating interlayer 470 may be formed on the second insulating interlayer 350 and the first to seventh sacrificial patterns 362, 364, 366, 372, 374, 376, and 378. The third insulating interlayer 470 may be partially etched by an etching process to expose the first sacrificial pattern 362. The exposed first sacrificial pattern 362 may be removed to reopen the first hole and expose the upper surface of the first substrate 100.

A charge storage structure layer and a channel layer may be sequentially formed on the upper surface of the first substrate 100 exposed by the first hole, a sidewall of the first hole, and an upper surface of the third insulating interlayer 470. A first filling layer may be formed on the channel layer to fill a remaining portion of the first hole. The charge storage structure layer may include a first blocking layer, a charge storage layer and a tunnel insulation layer sequentially stacked.

Subsequently, the first filling layer, the channel layer and the charge storage structure layer may be planarized until the upper surface of the third insulating interlayer 470 is exposed. Accordingly, a charge storage structure 420, a channel 430, and a first filling pattern 440 may be formed in the first hole. The charge storage structure 420 may include a first blocking pattern 390, a charge storage pattern 400 and a tunnel insulation pattern 410 sequentially stacked.

Subsequently, upper portions of the first filling pattern 440 and the channel 430 may be removed to form a first recess, and a first capping pattern 450 may be formed to fill the first recess.

The charge storage structure 420, the channel 430, the first filling pattern 440 and first capping pattern 450 formed in the first hole may together form a memory channel structure 460. In some implementations, the memory channel structure 460 may have a shape of a pillar extending in the first direction D1. The memory channel structure 460 may comprise a plurality of memory channel structures 460 that are spaced apart from each other in the second and third directions D2 and D3 in the main memory block MBK on the first region I of the first substrate 100.

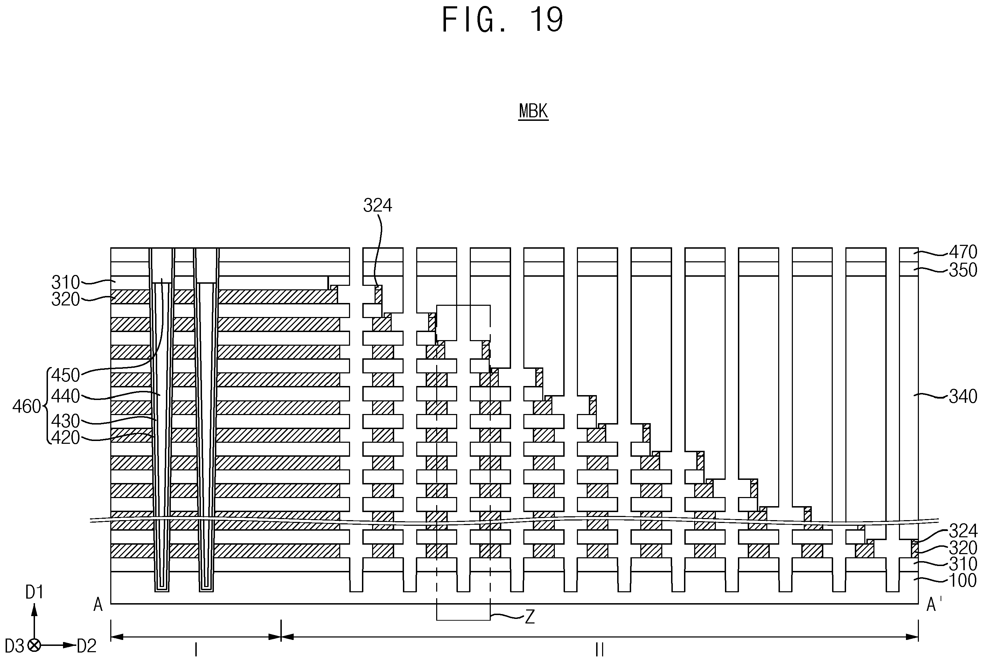

In FIGS. 19 to 22, the third to seventh sacrificial patterns 366, 372, 374, 376, and 378 may be exposed by partially etching the third insulating interlayer 470 by an etching process. The exposed third to seventh sacrificial patterns 366, 372, 374, 376, and 378 may be removed to reopen the third to seventh holes and expose the upper surface of the first substrate 100.

Subsequently, portions of the first sacrificial layers 320 adjacent to the third to seventh holes may be removed by performing an additional etching process to form second and third recesses 471 and 472.

In some implementations, during the formation of the second recess 471, not only a portion of the first sacrificial layer 320 but also the second insulation pad 324, which may be formed on the first sacrificial layer 320 and may include substantially the same material as the first sacrificial layer 320, may be removed together. Accordingly, the second recess 471 may have a width in the first direction D1 greater than the third recess 472. In FIGS. 23 to 27, a second insulation layer may be formed on inner walls of the third to seventh holes and the second and third recesses 471 and 472 and the upper surface of the third insulating interlayer 470 to fill the second and third recesses 471 and 472. A sacrificial liner layer may be formed on the second insulation layer. A second sacrificial layer may be formed on the sacrificial liner to fill a remaining portion of the third to seventh holes. The second sacrificial layer, the sacrificial liner layer and the second insulation layer may be planarized until the upper surface of the third insulating interlayer 470 is exposed.

In some implementations, the second insulation layer may include an oxide, for example, silicon oxide, the sacrificial liner layer may include an insulating nitride, for example, silicon nitride, and the second sacrificial layer may include, for example, polysilicon.

By the planarization process, a sacrificial pillar including a second insulation pattern 473, a sacrificial liner 475 and an eighth sacrificial pattern 477 may be formed in each of the third to seventh holes. Specifically, the third sacrificial pillar and fourth to seventh sacrificial pillars 482, 484, 486, and 488 may be formed in the third to seventh holes, respectively.

Subsequently, the sacrificial liner 475 and the eighth sacrificial pattern 477 of the third sacrificial pillar may be removed, and a third insulation pattern may be formed to fill remaining portion of the third hole. The third insulation pattern may include substantially the same material as the second insulation pattern 473, for example, an oxide, such as silicon oxide. Accordingly, the third insulation pattern may be merged with the second insulation pattern 473.

Hereinafter, the second insulation pattern 473 and the third insulation pattern within the third hole will together be referred to as a support structure 489.

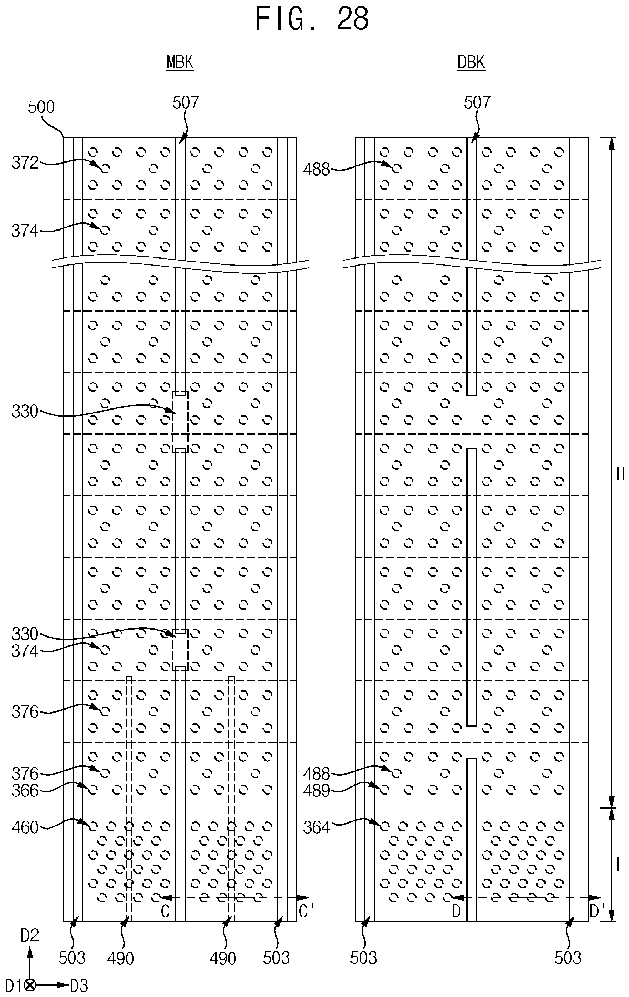

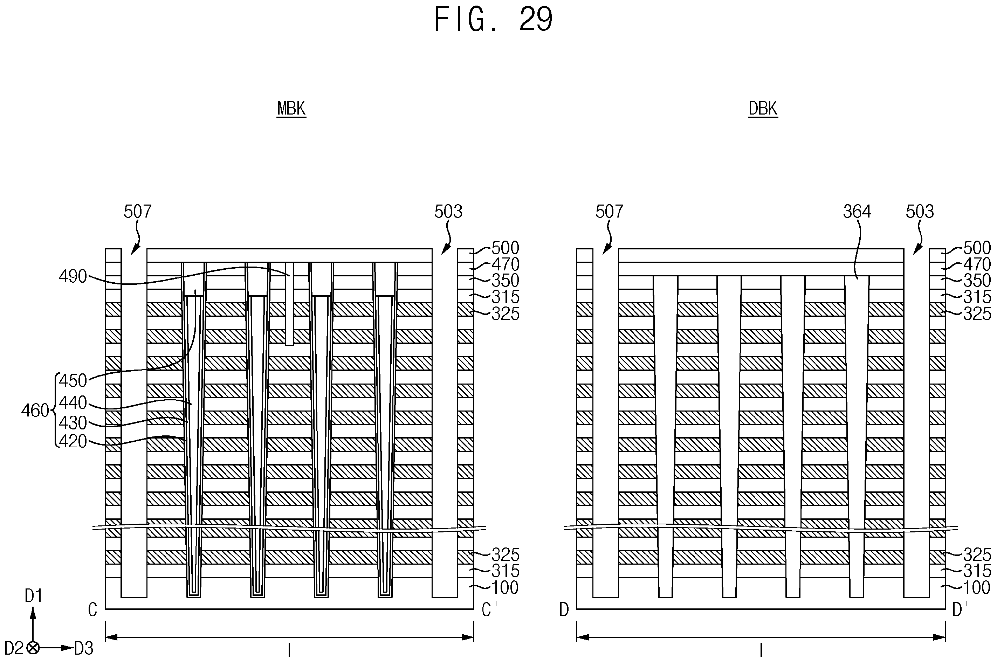

In FIGS. 28 and 29, a first opening extending in the second direction D2 through the third insulating interlayer 470, some of the first insulation layers 310 and some of the first sacrificial layers 320 may be formed, and a second division pattern 490 filling the first opening may be formed.

In some implementations, the second division pattern 490 may extend through upper portions of some of the memory channel structures 460 on the main memory block DBK. Additionally, the second division pattern 490 may extend through not only the upper portions of the some of the memory channel structures 460, but also the second and third insulating interlayers 350 and 470, the first sacrificial layers 320 disposed in upper two levels, and the first insulation layers 310 disposed in the upper two levels, and may also partially extend through the first insulation layer 310 disposed in a level below the upper two levels. In some implementations, the second division pattern 490 may extend in the second direction D2 in the main memory block MBK on the first and second regions I and II of the first substrate 100, and may extend through the upper two step levels of the mold. Accordingly, the first sacrificial layers 320 disposed in the upper two levels in the main memory block MBK may be divided in the third direction D3 by the second division pattern 490.

Meanwhile, although the second division pattern 490 is illustrated in the drawings as being formed only in the main memory block MBK, the concept of the present disclosure is not limited thereto, and the second division pattern 490 may also be formed in the dummy memory block DBK.

Subsequently, a fourth insulating interlayer 500 may be formed on the third insulating interlayer 470, the memory channel structure 460, the fourth to seventh sacrificial pillars 482, 484, 486, and 488, the support structure 489 and the second division pattern 490, and a second opening 503 may be formed to extend in the second direction D2 through the first to fourth insulating interlayers 340, 350, 470, and 500, the mold, and the upper portion of the first substrate 100 on the first and second regions I and II of the first substrate 100 by performing an etching process.

In some implementations, the second opening 503 may extend in the second direction D2 on the first and second regions I and II of the first substrate 100 to opposite ends in the second direction D2 of the staircase-shaped mold, and the second opening 503 may comprise a plurality of second openings 503 that are spaced apart from each other in the third direction D3. Accordingly, the mold may be divided into a plurality of portions that are spaced apart from each other in the third direction D3 by the second openings 503. The plurality of portions of the mold may respectively form memory blocks. As the second opening 503 is formed, the first insulation layers 310 and the first sacrificial layers 320 included in the mold may be divided into first insulation patterns 315 and first sacrificial patterns 325 extending in the second direction D2.

Meanwhile, a third opening 507 extending in the second direction D2 through the first to fourth insulating interlayers 340, 350, 470 and 500, the mold, and the upper portion of the first substrate 100 on the first and second regions I and II of the first substrate 100 may be formed. A plurality of third openings 507 may be formed, spaced apart from each other in the second direction D2 and the third direction D3.

Even though the mold is divided into a plurality of portions, each of which may extend in the second direction D2, spaced apart from each other in the third direction D3 by the wet etching process for forming the second and third openings 503 and 507, the mold may not collapse due to the memory channel structure 460, the second sacrificial pattern 364, the support structure 489, and the fourth to seventh sacrificial pillars 482, 484, 486, and 488 that extend through the mold.

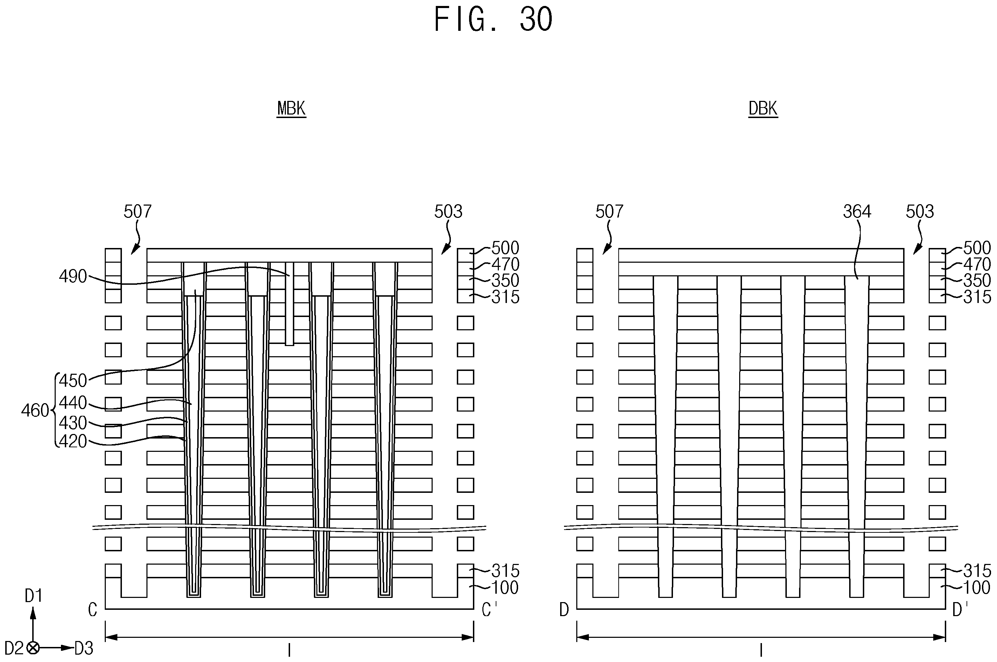

In FIG. 30, the first sacrificial patterns 325 and the second insulation pad 324 exposed by the second and third openings 503 and 507 may be removed to form a first gap between neighboring ones of first insulation patterns 315 at respective levels in the first direction D1, and a portion of an outer sidewall of the charge storage structure 420 included in the memory channel structure 460, a portion of a sidewall of the second sacrificial pattern 364, a portion of a sidewall of the support structure 489, and portions of sidewalls of the fourth to seventh sacrificial pillars 482, 484, 486 and 488 may be exposed by the first gap.

In some implementations, a wet etching process may be performed using, e.g., phosphoric acid (H₃PO₄) or sulfuric acid (H₂SO₄) to remove the first sacrificial patterns 325. The wet etching process may be performed through the second and third openings 503 and 507, and an entire portion of the first sacrificial pattern 325 between the second and third openings 493 and 497 may be removed by an etching solution provided from the second and third openings 503 and 507.

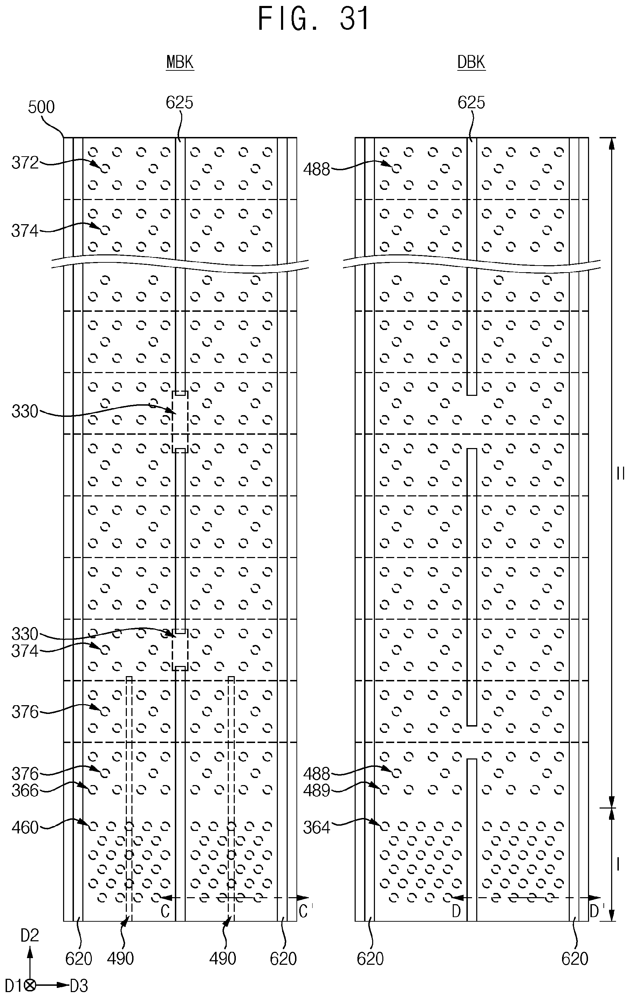

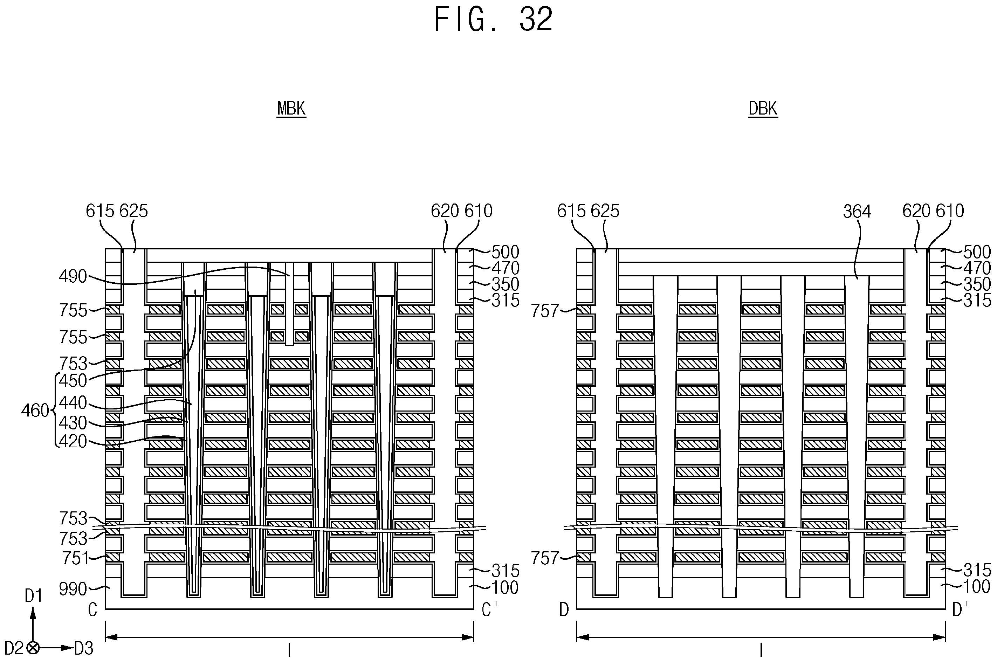

In FIGS. 31 and 32, a second blocking layer may be formed on the outer sidewall of the charge storage structure 420, the sidewall of the second sacrificial pattern 364, the sidewalls of the fourth to seventh sacrificial pillars 482, 484, 486, and 488, and the sidewall of the support structure 489 exposed by the first gap, an inner wall of the first gap, surfaces of the first insulation patterns 315, sidewalls of the first to fourth insulating interlayers 340, 350, 470, and 500 and an upper surface of the fourth insulating interlayer 500, and a gate electrode layer may be formed on the second blocking layer.

The gate electrode layer may be partially removed to form a gate electrode in each of the first gaps. In some implementations, the gate electrode layer may be partially removed by a wet etching process. As a result, the first sacrificial pattern 325 of the mold including the step layers each of which may include the first sacrificial pattern 325 and the first insulation pattern 315 may be replaced with the gate electrode and the second blocking layer covering lower and upper surfaces of the gate electrode.

The gate electrode may extend in the second direction D2, and the gate electrode may comprise a plurality of gate electrodes that are respectively stacked in a plurality of levels and spaced apart from each other in the first direction D1 to form a gate electrode structure. The gate electrode structure may have a staircase shape including the gate electrode as a step layer. An end portion of each of the gate electrodes in the second direction D2, which may not be overlapped by overlying ones of upper gate electrodes in the first direction D1, that is, a portion corresponding to a step of a step layer of the gate electrode structure and having a relatively greater thickness, may be referred to as a pad.

In some implementations, a gate electrode structure may comprise a plurality of gate electrode structures that are spaced apart from each other in the third direction D3. The gate electrode structures may be separated by the second and third openings 503 and 507 in the third direction D3.

Meanwhile, within the main memory block MBK, the gate electrode structure may include first to third gate electrodes 751, 753 and 755 sequentially stacked the first direction D1, and within the dummy memory block DBK, the gate electrode structure may include fourth gate electrodes 757 sequentially stacked the first direction D1.

Subsequently, a second division layer may be formed on the second blocking layer to fill the second and third openings 503 and 507, and may be planarized until the upper surface of the fourth insulating interlayer 500 is exposed. Accordingly, the second blocking layer may be transformed into a second blocking pattern 615, and first and second division patterns 620 and 625 may be formed in the second and third openings 503 and 507, respectively.

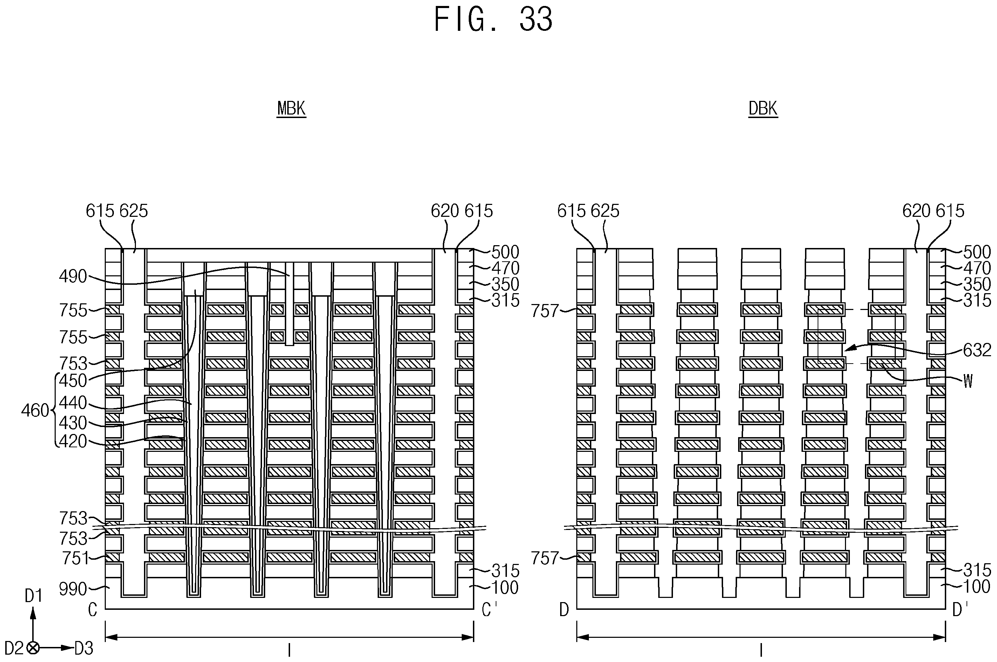

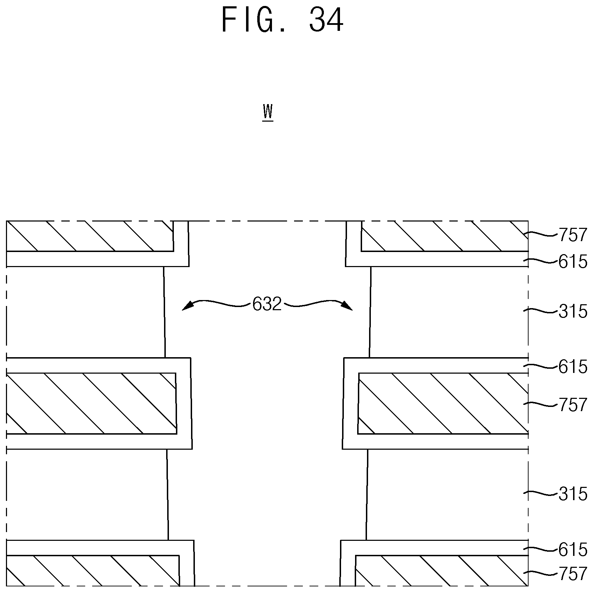

In FIGS. 33 and 34, the third and fourth insulating interlayers 470 and 500 may be partially removed to expose the second sacrificial pattern 364 by an etching process, and the second sacrificial pattern 364 may be removed to reopen the second hole and expose the upper surface of the first substrate 100. Accordingly, the sidewalls of the first insulation patterns 315 and the second blocking pattern 615 may be exposed.

Subsequently, a fourth recess 632 may be formed by removing portions of the first insulation patterns 315 adjacent to the second holes by performing an additional etching process. Accordingly, portions of upper and lower surfaces of the second blocking pattern 615 may be additionally exposed.

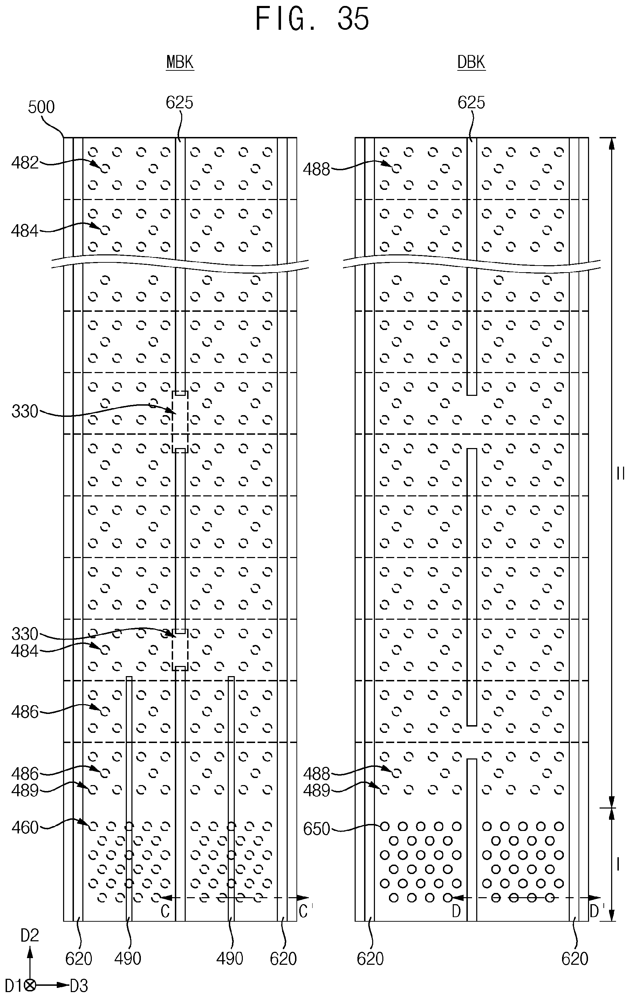

In FIGS. 35 to 37, a dielectric layer may be formed on inner walls of the second hole and the fourth recess 632 and the upper surface of the fourth insulating interlayer 500, and a capacitor electrode layer may be formed on the dielectric layer. The capacitor electrode layer may be formed to fill a remaining portion of the fourth recess 632.

A second filling layer may be formed to fill a remaining portion of the second hole on the capacitor electrode layer, and the second filling layer, the capacitor electrode layer, and the dielectric layer may be planarized until the upper surface of the fourth insulating interlayer 500 is exposed. Accordingly, a dielectric pattern 642, a first capacitor electrode 644 and a second filling pattern 646 may be formed in the second hole.

As the capacitor electrode layer is formed to fill the fourth recess 632, the first capacitor electrode 644 may be formed to include third extension portion and third protrusion portions. The third protrusion portions may protrude in the horizontal direction from a sidewall of the third extension portion. The third protrusion portions of the first capacitor electrode 644 may be respectively formed on portions of the sidewall of the third extension portion facing the first insulation patterns 315.

Subsequently, a fifth recess may be formed by removing upper portions of the second filling pattern 646 and the first capacitor electrode 644, and a second capping pattern 648 may be formed to fill the fifth recess. The dielectric pattern 642, the first capacitor electrode 644, the second filling pattern 646 and the second capping pattern 648 formed in each of the second holes may together form a capacitor structure 650.

The first capacitor electrode 644, the fourth gate electrode 757, a portion of the second blocking pattern 615, and a portion of the dielectric pattern 642 between the first capacitor electrode 644 and the fourth gate electrode 757 may together form a capacitor.

Meanwhile, although the drawings illustrate forming the capacitor structure 650 in the second hole after replacing the first sacrificial patterns 325 with the first to fourth gate electrodes 751, 753, 755, and 757, the concept of the present disclosure is not limited thereto. That is, the capacitor structure 650 may be formed in the second hole before replacing the first sacrificial patterns 325 with the first to fourth gate electrodes 751, 753, 755, and 757.

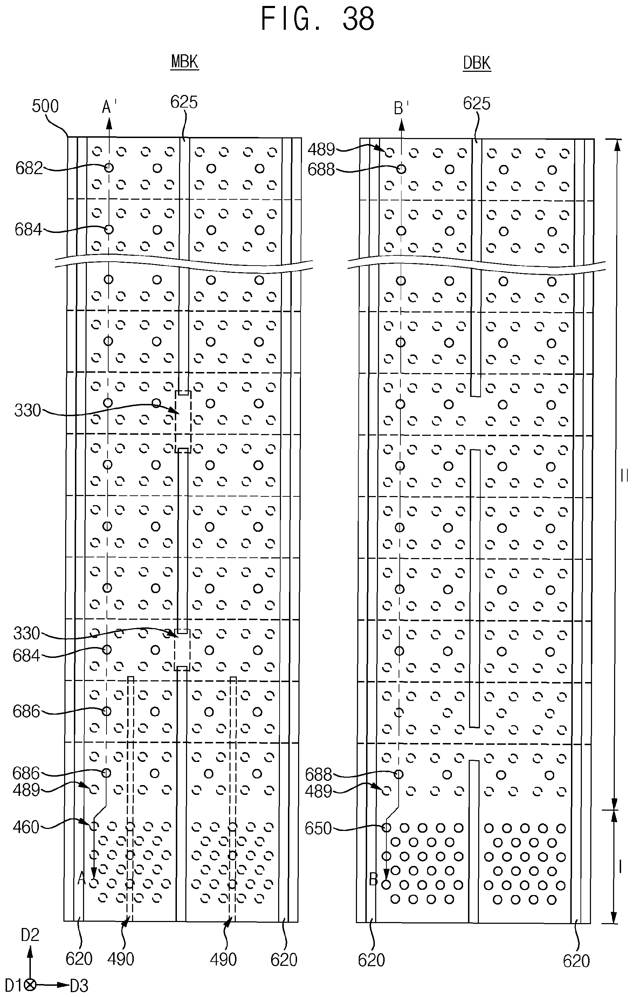

In FIGS. 38 to 41, the fourth insulating interlayer 500 may be partially etched by an etching process to expose the fourth to seventh sacrificial pillars 482, 484, 486, and 488. The exposed fourth to seventh sacrificial pillars 482, 484, 486, and 488 may be removed, and the fourth to seventh holes may be reopened to expose the upper surface of the first substrate 100.

Specifically, the eighth sacrificial pattern 477 and the sacrificial liner 475 included in each of the fourth to seventh sacrificial pillars 482, 484, 486, and 488 may be removed. While a portion of the second insulation pattern 473 in the second recess 471 that has a relatively large width in the first direction D1 may be completely removed, a portion of the second insulation pattern 473 in the third recess 472 that has a relatively small width in the first direction D1 may remain as a fourth insulation pattern 680.

Additionally, a portion of a sidewall of the second blocking pattern 615 exposed by the second recess 471 may be removed, and accordingly, a sidewall of the gate electrode formed in an uppermost level in each of the fourth to seventh holes may be exposed.

Subsequently, first to fourth contact plugs 682, 684, 686, and 688 may be formed in the fourth to seventh holes, respectively.

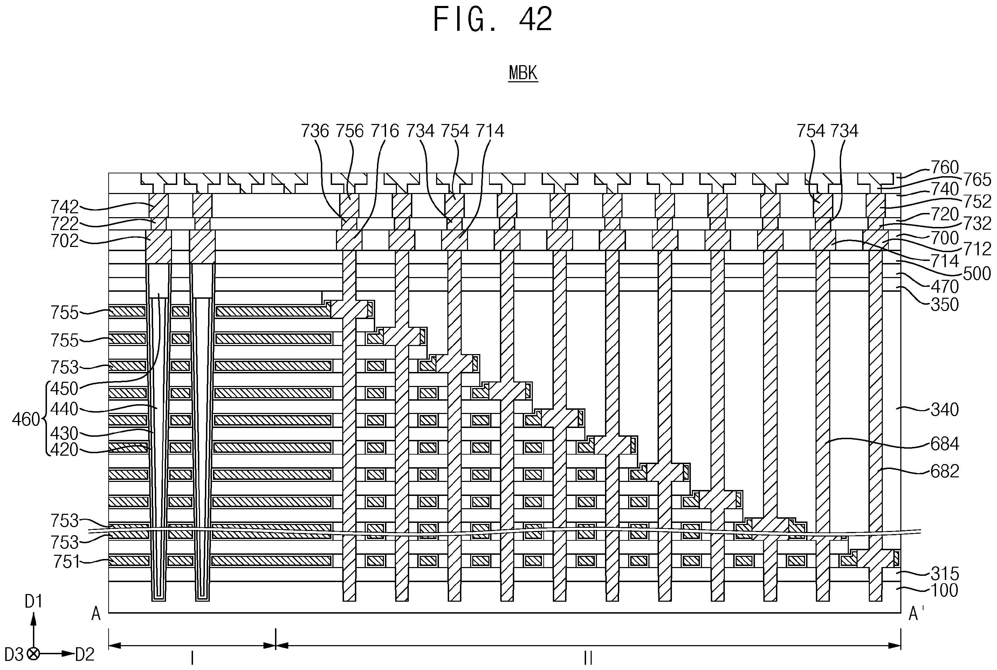

In FIGS. 42 to 44, fifth to sixteenth contact plugs 702, 704, 712, 714, 716, 718, 742, 744, 752, 754, 756, and 758, first to sixth wirings 722, 724, 732, 734, 736, and 738, and fifth to seventh insulating interlayers 700, 720, and 740 covering the fifth to sixteenth contact plugs 702, 704, 712, 714, 716, 718, 742, 744, 752, 754, 756, and 758 and the first to sixth wirings 722, 724, 732, 734, 736, and 73 may be formed.

Specifically, a fifth insulating interlayer 700 may be formed on the fourth insulating interlayer 500 and the first to fourth contact plugs 682, 684, 686, and 688. A fifth contact plug 702 extending through the fifth and fourth insulating interlayers 700 and 500 and contacting the upper surface of the memory channel structure 460 may be formed. A sixth contact plug 704 extending through the fifth insulating interlayer 700 and contacting the upper surface of the capacitor structure 650 may be formed. Seventh to tenth contact plugs 712, 714, 716, and 718 extending through the fifth insulating interlayer 700 and respectively contacting the upper surfaces of the first to fourth contact plugs 682, 684, 686, and 688 may be formed.

A sixth insulating interlayer 720 may be formed on the fifth insulating interlayer 700, and the fifth to tenth contact plugs 702, 704, 712, 714, 716, and 718. First to sixth wirings 722, 724, 732, 734, 736, and 738 extending through the sixth insulating interlayer 720 and respectively contacting upper surfaces of the fifth to tenth contact plugs 702, 704, 712, 714, 716, and 718 may be formed.

A seventh insulating interlayer 740 may be formed on the sixth insulating interlayer 720 and the first to sixth wirings 722, 724, 732, 734, 736, and 738. Eleventh to sixteenth contact plugs 742, 744, 752, 754, 756, and 758 extending through the seventh insulating interlayer 740 and respectively contacting upper surfaces of the first to sixth wirings 722, 724, 732, 734, 736, and 738 may be formed.

A first bonding layer 760 and a first bonding pattern 765 extending through the first bonding layer 760 may be formed on the seventh insulating interlayer 740 and the eleventh to sixteenth contact plugs 742, 744, 752, 754, 756, and 758. In some implementations, the first bonding pattern 765 may comprise a plurality of first bonding patterns 765 spaced apart from each other in the second and third directions D2 and D3. In some implementations, the first bonding pattern 765 may contact and be electrically connected to a corresponding one of the eleventh to sixteenth contact plugs 742, 744, 752, 754, 756, and 758.

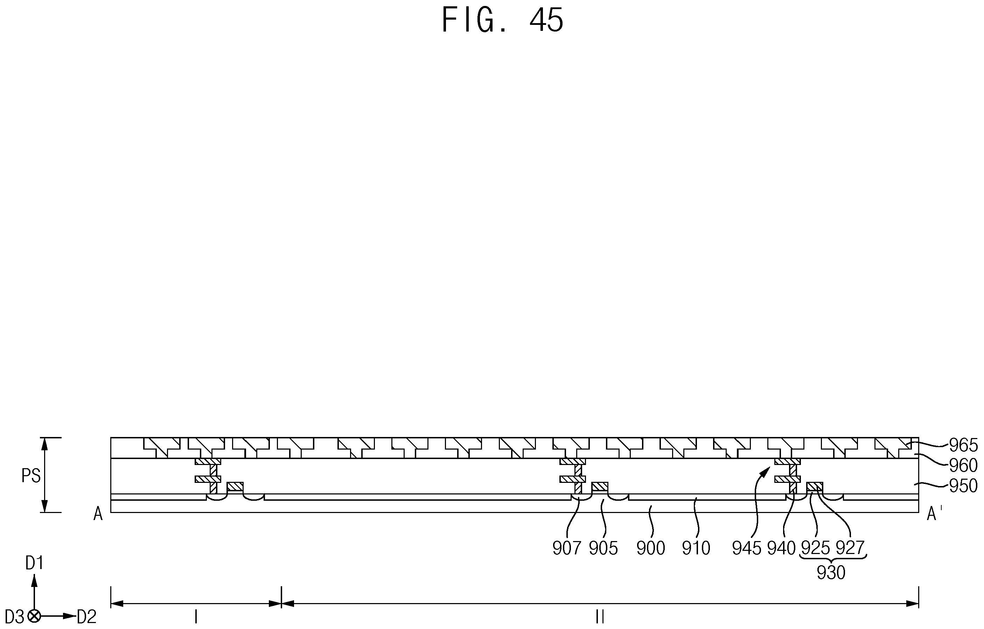

In FIG. 45, a peripheral circuit structure PS may be formed on a second substrate 900 including first and second regions I and II respectively corresponding to the first and second regions I and II of the first substrate 100.

The peripheral circuit structure PS may include an active pattern 905, an isolation pattern 910, a transistor, a seventeenth contact plug 940, a wiring structure 945, and an eighth insulating interlayer 950 on the second substrate 900.

The active pattern 905 may protrude upward from the second substrate 900, and a sidewall of the active pattern 905 may be covered by the isolation pattern 910.

The transistor may include a gate structure 930 and an impurity region 907. The gate structure 930 may include a gate insulation pattern 925 and a fifth gate electrode 927 sequentially stacked on the second substrate 900. The impurity region 907 may be formed in a portion of the active pattern 905 adjacent to the gate structure 930. The seventeenth contact plug 940 may be formed within the eighth insulating interlayer 950 and may contact the impurity region 907. The wiring structure 945 may be formed within the eighth insulating interlayer 950 and may contact the seventeenth contact plug 940. The eighth insulating interlayer 950 may cover the transistor, the seventeenth contact plug 940, and the wiring structure 945.

Subsequently, a second bonding layer 960 and a second bonding pattern 965 extending through the second bonding layer 960 may be formed on the peripheral circuit structure PS. In some implementations, the second bonding pattern 765 may comprise a plurality of second bonding patterns 765 spaced apart from each other in the second and third directions D2 and D3. In some implementations, the second bonding patterns 965 may contact and be electrically connected to the wiring structure 945, and may be formed at positions corresponding to the first bonding patterns 765.

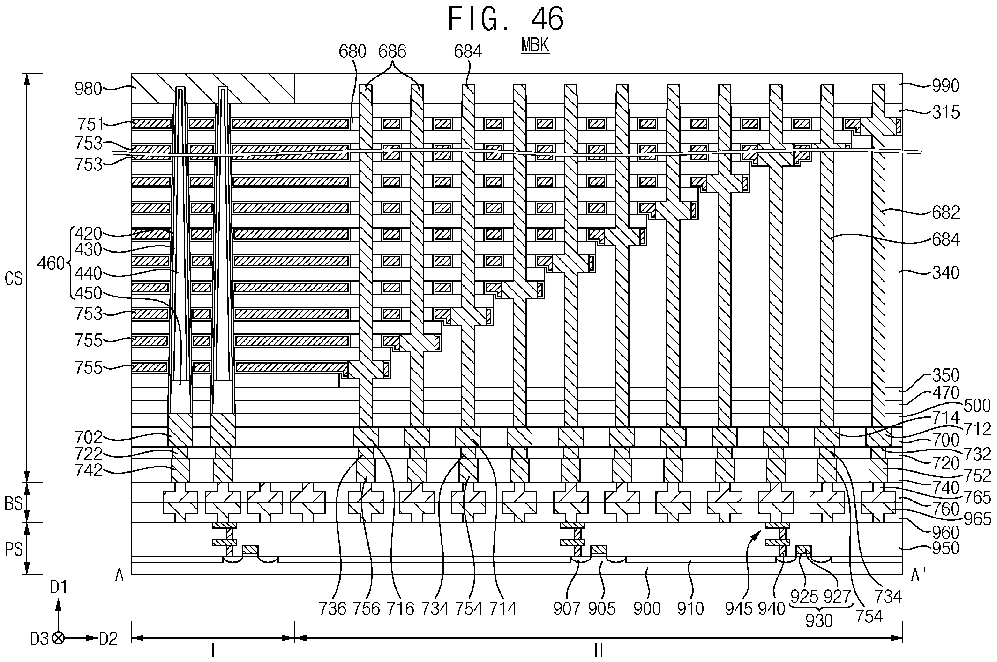

In FIG. 46, by flipping the first substrate 100, the first bonding layer 760 may be brought into contact with the second bonding layer 960, allowing the first and second substrates 100 and 900 to be bonded together. In this process, the first and second bonding patterns 765 and 965 may come into contact with each other.

Meanwhile, since the first substrate 100 and various structures formed on the first substrate 100 are inverted upside down, they will be described below based on the inverted orientation.

An upper portion of the charge storage structure 420 and an upper surface of an uppermost first insulation pattern 315 may be exposed by removing the first substrate 100 by, for example a grinding process, and the exposed upper portion of the charge storage structure 420 may be removed to expose an upper surface and an upper outer sidewall of an upper portion of the channel 430.

A first CSP layer may be formed on the exposed upper surface and upper outer sidewall of the upper portion of the channel 430, an upper surface of the charge storage structure 420 and the upper surface of the uppermost first insulation pattern 315, and the first CSP layer may be patterned to form a first CSP 980. A ninth insulating interlayer 990 may be formed to cover the first CSP 980, and an upper portion of the ninth insulating interlayer 990 may be planarized until an upper surface of the first CSP 980 is exposed.

In example embodiments, the first CSP 980 may electrically connect the channels 430 of the memory channel structures 460 of each of the main memory blocks MBK by contacting the exposed upper outer sidewalls and the upper surfaces of these channels 430.

The first CSP 980 and various structures formed between the first CSP 980 and the bonding structure BS may together form a cell structure CS.

In FIGS. 1 to 7, the method of manufacturing the semiconductor device may be completed by flipping the second substrate 900, the first CSP 980, and the various structures between the second substrate 900 and the first CSP 980.

In some implementations, portions of the first insulation patterns 315 adjacent to the second hole may be removed to form the fourth recesses 632. Then, the capacitor electrode layer may be formed to fill the fourth recesses 632, resulting in the formation of the first capacitor electrode 644 with the third protrusion portions. The third protrusion portions of the first capacitor electrode 644 may reduce distance between the first capacitor electrode 644 and the fourth gate electrode 757 compared to when the first capacitor electrode 644 does not have the third protrusion portions, thereby increasing the capacitance of the capacitor.

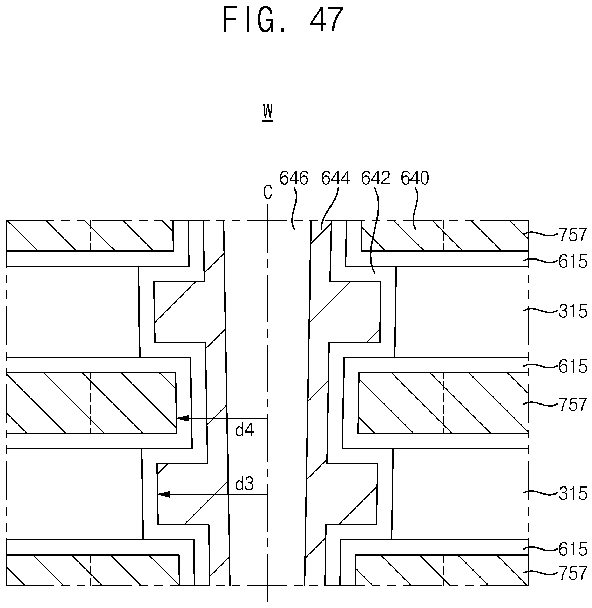

FIG. 47 is a cross-sectional view illustrating an example of a semiconductor device corresponding to FIG. 6 according to some implementations. The semiconductor device may be substantially the same or similar to those described with reference to FIGS. 1 to 7 except for the shape of the first capacitor electrode 644, and thus, repeated explanations are omitted herein.

In FIG. 47, a third distance d3 from the central axis C to an outer sidewall of the third portion of the first capacitor electrode 644 where the third protrusion portion is formed may be greater than a fourth distance d4 from the central axis C to a sidewall of the fourth gate electrode 757 disposed immediately above or below the third protrusion portion. Accordingly, the third protrusion portion of the first capacitor electrode 644 may at least partially overlap in the first direction D1 with the fourth gate electrode 757 disposed immediately above or below the third protrusion portion.

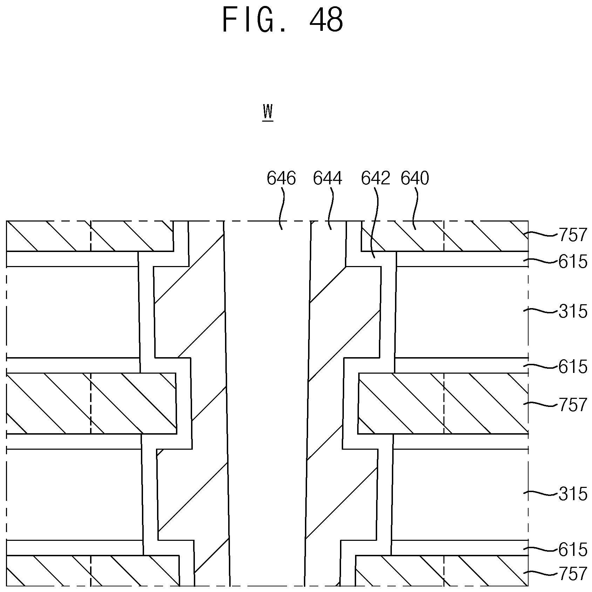

FIG. 48 is a cross-sectional view illustrating an example of a semiconductor device corresponding to FIG. 47 according to some implementations. The semiconductor device may be substantially the same or similar to those described with reference to FIG. 47 except for the relationship between the fourth gate electrode 757, the second blocking pattern 615 and the dielectric pattern 642, and thus, repeated explanations are omitted herein.

In FIG. 48, the second blocking pattern 615 may not be formed on upper and lower surfaces and sidewalls of respective first portions of the fourth gate electrodes 757 facing the capacitor structure 650. Accordingly, the second blocking pattern 615 may not be interposed between the first portions of the fourth gate electrodes 757 and the first capacitor electrode 644, and the dielectric pattern 642 may contact the upper surface and the sidewalls of the first portions of the fourth gate electrode 757.

The first capacitor electrode 644, the fourth gate electrode 757, and the portion of the dielectric pattern 642 interposed between the first capacitor electrode 644 and the fourth gate electrode 757 may together form a capacitor.

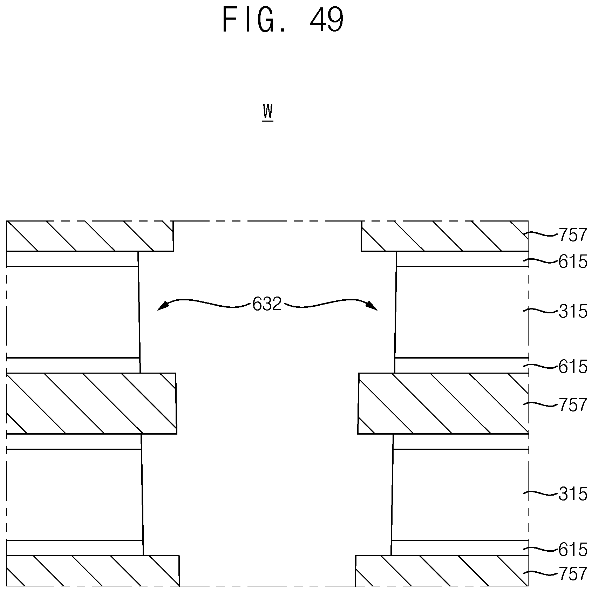

FIG. 49 is a cross-sectional view illustrating an example of a method of manufacturing a semiconductor device according to some implementations, which is an enlarged cross-sectional view of a region W of a corresponding cross-sectional view. The method of manufacturing the semiconductor device may be substantially the same or similar to those described with reference to FIGS. 1 to 46, and thus, repeated explanations are omitted herein.

In FIG. 49, processes substantially the same or similar to those described with reference to FIGS. 8 to 34 may be performed. Subsequently, portions of the second blocking pattern 615 exposed by the fourth recesses 632 may be removed, and accordingly, upper and lower surfaces and sidewalls of first portions of the fourth gate electrodes 757 adjacent to the second hole may be exposed. The portions of the second blocking pattern 615 may be removed by performing, for example, a wet etching process.

Processes substantially the same or similar to those described with reference to FIGS. 35 to 46 and FIGS. 1 to 7 may be performed, and the manufacturing of the semiconductor device of FIG. 48 may be completed.

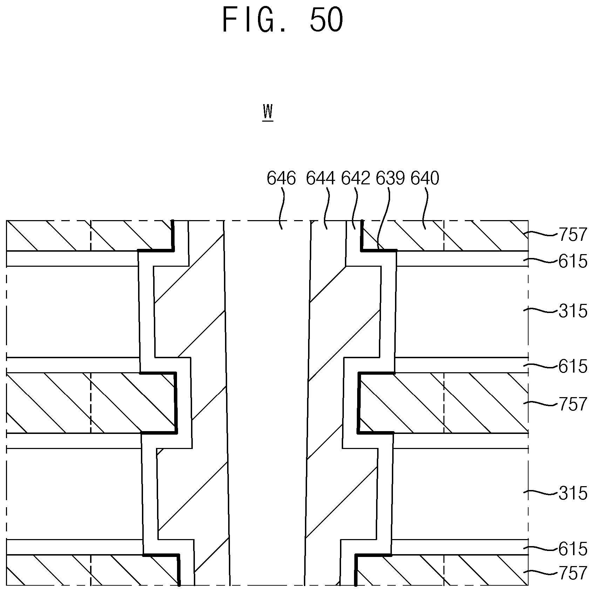

FIG. 50 is a cross-sectional view illustrating an example of a semiconductor device corresponding to FIG. 48 according to some implementations. The semiconductor device may be substantially the same or similar to those explained with reference to FIG. 48 except for further including a native oxide layer 639, and thus, repeated explanations are omitted herein.

In FIG. 50, the native oxide layer 639 may be interposed between the first portion of the fourth gate electrode 757 and the dielectric pattern 642. The native oxide layer 639 may include a metal oxide, for example, tungsten oxide, titanium oxide, tantalum oxide, platinum oxide, etc. The native oxide layer 639 may be formed by oxidation of the exposed surface of the first portion of the fourth gate electrode 757 during the process described with reference to FIG. 49.

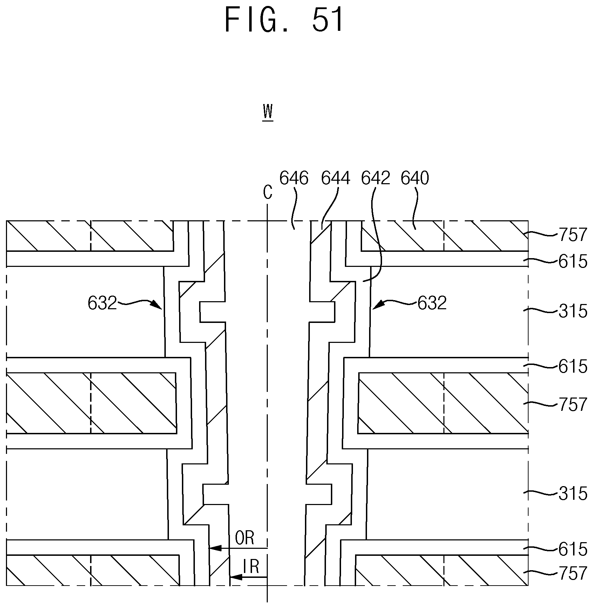

FIG. 51 is a cross-sectional view illustrating an example of a semiconductor device corresponding to FIG. 6 according to some implementations. The semiconductor device may be substantially the same or similar to those described with reference to FIGS. 1 to 7 except for the shapes of the second filling pattern 646 and the first capacitor electrode 644, and thus, repeated explanations are omitted herein.

In FIG. 51, the first capacitor electrode 644 may be formed with a uniform thickness along an inner wall of the dielectric pattern 642 having a zigzag shape. The fourth recesses 632 may not be filled by the first capacitor electrode 644, and accordingly, respective portions of the first capacitor electrode 644 disposed in the fourth recesses 632 may be formed to have sixth recesses. Accordingly, corresponding to the dielectric pattern 642, the first capacitor electrode 644 may be formed to have a zigzag shape.

In some implementations, the inner radius IR of the first capacitor electrode 644 of the first capacitor electrode 644, like the outer radius OR of the first capacitor electrode 644, may periodically increase and decrease with increasing distance from the lower surface of the ninth insulating interlayer 990 in the first direction D1.

The second filling pattern 646 may have a fourth extension portion and fourth protrusion portions. The fourth extension portion may have a shape of a pillar extending in the first direction D1. The fourth protrusion portions may protrude from a sidewall of the fourth extension portion and may be spaced apart from each other in the first direction D1. The fourth protrusion portions may be respectively protruding from portions of the sidewall of the fourth extension portion facing the first insulation patterns 315.

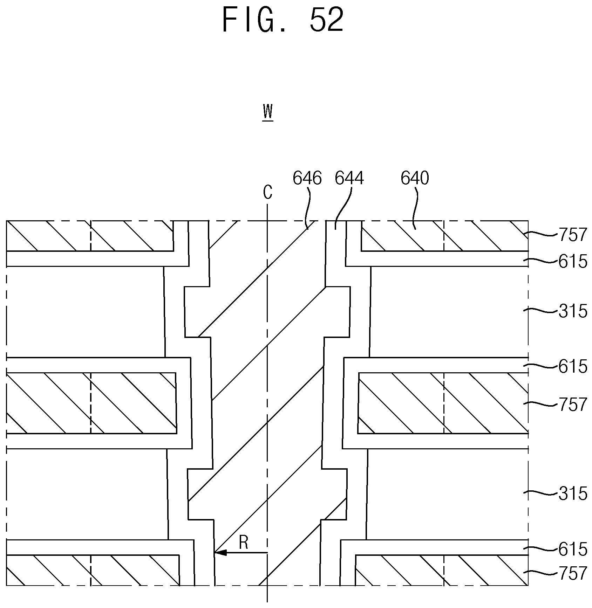

FIG. 52 is a cross-sectional view illustrating an example of a semiconductor device corresponding to FIG. 6 according to some implementations. The semiconductor device is substantially the same or similar to those described with reference to FIGS. 1 to 7 except for the configuration of the capacitor structure 650 and the shape of the first capacitor electrode 644, and thus, repeated explanations are omitted herein.

In FIG. 52, the capacitor structure 650 may not include the second filling pattern 646. Accordingly, the third extension portion of the first capacitor electrode 644 may have a shape of a pillar extending in the first direction D1, with the third protrusion portions protruding in the horizontal direction from the sidewall of the third extension portion. The third protrusion portions may be disposed on the portions of the sidewall facing the first insulation patterns 315. In some implementations, the radius R of the first capacitor electrode 644 may periodically increase and decrease with increasing distance from the lower surface of the ninth insulating interlayer 990 in the first direction D1.

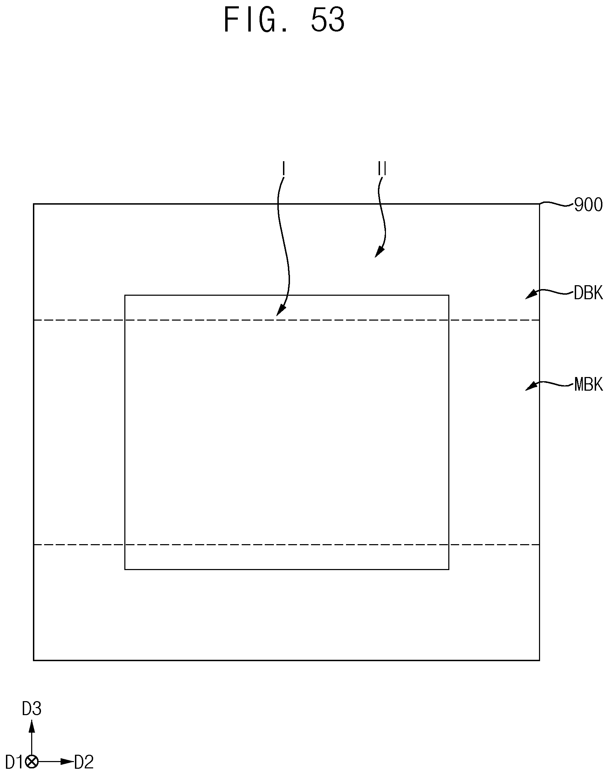

FIG. 53 is a plan view illustrating an example of a semiconductor device according to some implementations. In FIG. 53, a layout of the main memory block MBK and the dummy memory block DBK of a semiconductor device corresponding to FIG. 1 is shown.

In FIG. 53, the main memory block MBK may be disposed on a central portion in the third direction D3 of the second substrate 900, and the dummy memory block DBK may be disposed on an edge portion in the third direction D3 of the second substrate 900.

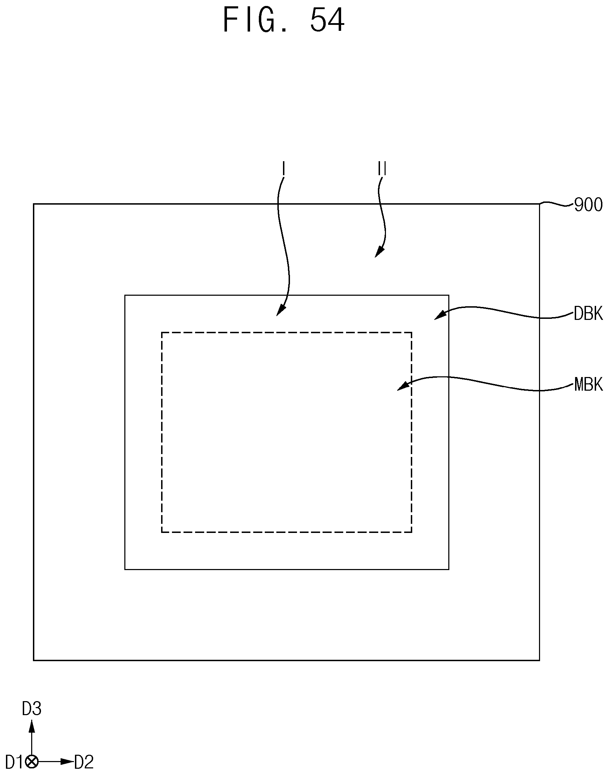

FIG. 54 is a plan view illustrating an example of a semiconductor device according to some implementations. In FIG. 54, a further layout of the main memory block MBK and the dummy memory block DBK of a semiconductor device corresponding to FIG. 1 is shown.

In FIG. 54, the main memory block MBK may be disposed on a central portion of the second substrate 900, and the dummy memory block DBK may be disposed on respective edge portions of the second substrate 900 in the second and third directions D2 and D3. The main memory block MBK and the dummy memory block DBK may share the second region II. The layout of the main memory block MBK and the dummy memory block DBK is not limited to the example embodiments illustrated in FIGS. 1, 53, and 54, and may be variously modified.

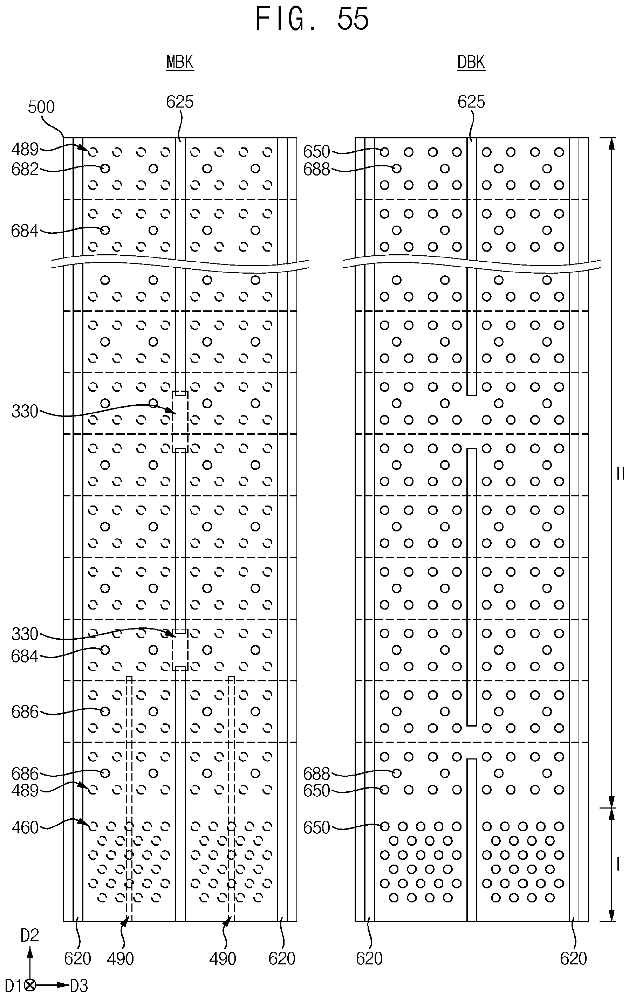

FIG. 55 is a plan view illustrating an example of a semiconductor device corresponding to FIG. 2 according to some implementations. The semiconductor device is substantially the same or similar to those described with reference to FIGS. 1 to 7 except for the position and layout of the capacitor structure 650, and thus, repeated explanations are omitted herein.

In FIG. 55, the capacitor structures 650 may be formed in the first and second regions I and II, and may be spaced apart from each other in the second and third directions D2 and D3 in the dummy memory block DBK. In some implementations, in a plan view, the fourth contact plug 688 may be disposed in a region defined by adjacent capacitor structures 650.

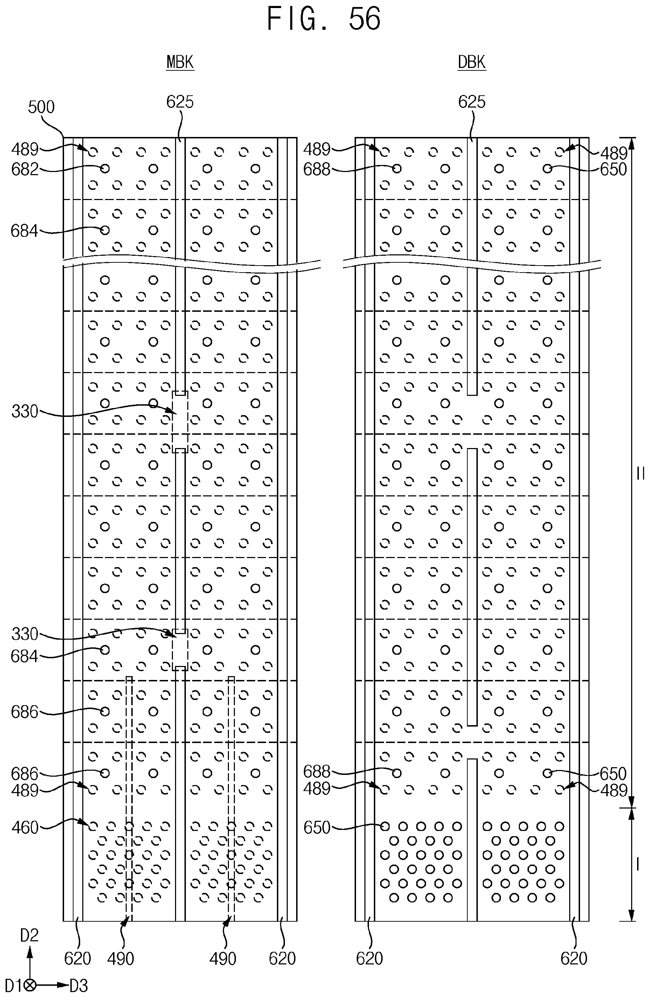

FIG. 56 is a plan view illustrating an example of a semiconductor device corresponding to FIG. 2 according to some implementations. The semiconductor device may be substantially the same or similar to those described with reference to FIGS. 1 to 7 except for the position and layout of the capacitor structure 650, and thus, repeated explanations are omitted herein.

In FIG. 56, the capacitor structures 650 may be disposed in the first and second regions I and II, and may be spaced apart from each other in the second and third directions D2 and D3 in the dummy memory block DBK. In some implementations, in a plan view, the capacitor structure 650 may be disposed in a region defined by adjacent support structures 489.

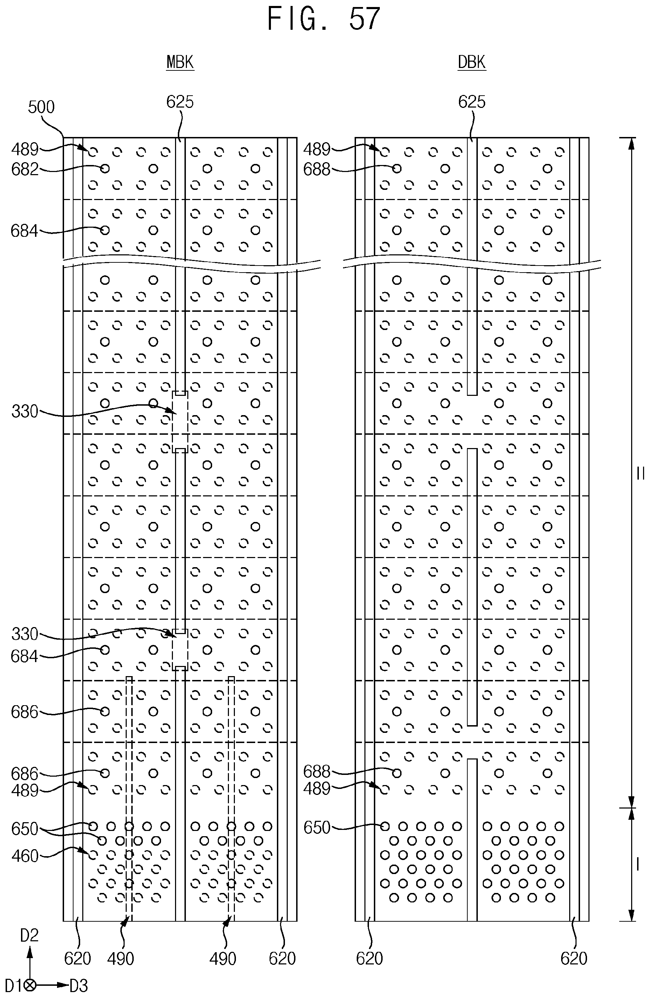

FIG. 57 is a plan view illustrating an example of a semiconductor device corresponding to FIG. 2 according to some implementations. The semiconductor device may be substantially the same or similar to those described with reference to FIGS. 1 to 7 except for the position and layout of the capacitor structure 650, and thus, repeated explanations are omitted herein.

In FIG. 57, the capacitor structures 650 may be spaced apart from each other in the second and third directions D2 and D3 in the main memory block MBK on a portion of the first region I adjacent to the second region II. The position and layout of the capacitor structures 650 are not limited to the example embodiments illustrated in FIG. 2 and FIGS. 55 to 57, and may be variously modified.

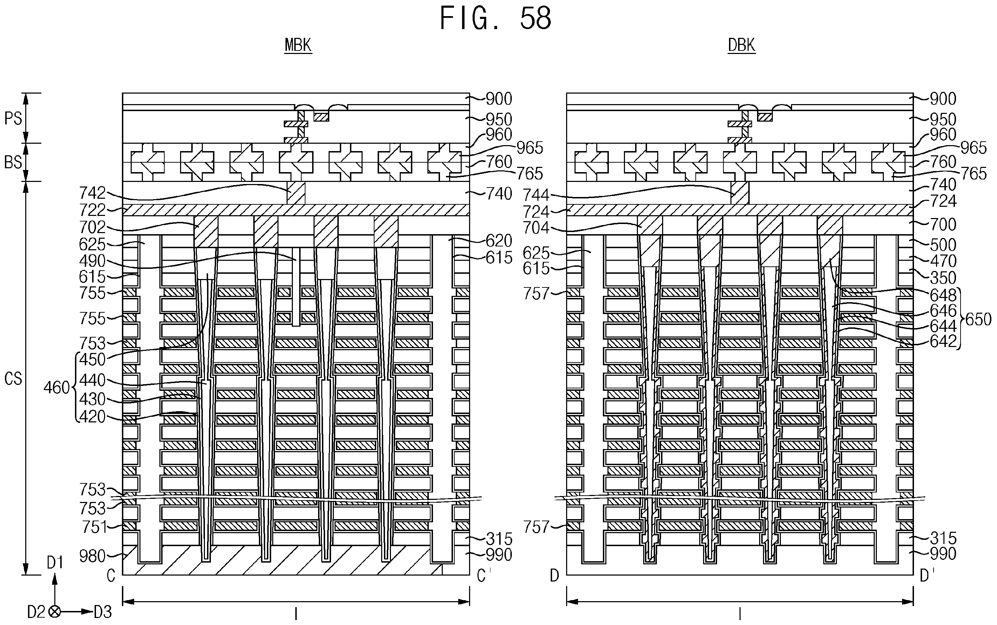

FIG. 58 is a cross-sectional view illustrating an example of a semiconductor device corresponding to FIG. 5 according to some implementations. The semiconductor device is substantially the same or similar to the semiconductor device illustrated with reference to FIGS. 1 to 7 except for the shapes of the memory channel structure 460 and the capacitor structure 650, and thus, repeated explanations are omitted herein.

In FIG. 58, the memory channel structure 460 may include sequentially stacked lower and upper portions, and each of the lower and upper portions may have a width that gradually increases with increasing distance from the lower surface of the ninth insulating interlayer 990 in the first direction D1. In some implementations, an upper surface of the lower portion of the memory channel structure 460 may have a larger width than a lower surface of the upper portion of the memory channel structure 460.

The capacitor structure 650 may include sequentially stacked lower and upper portions, and each of the lower and upper portions may have a width that gradually increases with increasing distance from the lower surface of the ninth insulating interlayer 990 in the first direction D1. In some implementations, an upper surface of the lower portion of the capacitor structure 650 may have a larger width than a lower surface of the upper portion of the capacitor structure 650. In some implementations, the upper surface of the lower portion of the memory channel structure 460 and the upper surface of the lower portion of the capacitor structure 650 may be disposed at substantially the same height.

FIG. 58 is a cross-sectional view illustrating an example of a semiconductor device according to some implementations. In FIG. 58, each of the memory channel structures 460 and the capacitor structures 540 includes two portions stacked in the first direction D1, however, the concept of the present disclosure is not limited thereto, and may include more than two portions stacked in the first direction D1. Each of the portions may have a width that gradually increases with increasing distance from the lower surface of the ninth insulating interlayer 990 in the first direction D1, and an upper surface of a portion may have a width greater than a lower surface of a portion thereon.

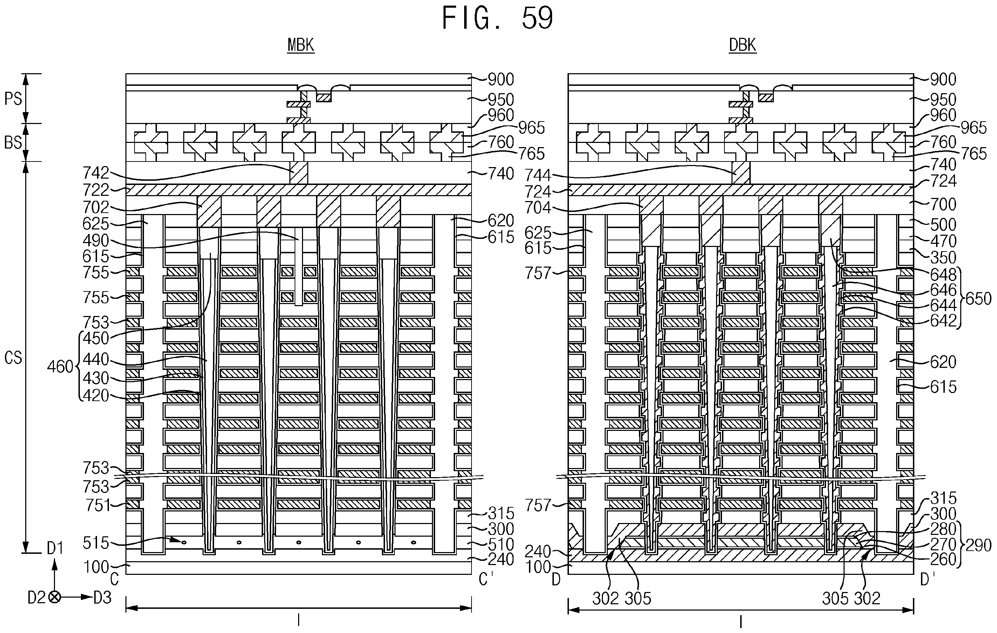

FIG. 59 is a cross-sectional view illustrating an example of a semiconductor device corresponding to FIG. 5 according to some implementations. The semiconductor device may be substantially the same or similar to those described with reference to FIGS. 1 to 7 except for further including a first substrate 100, a second CSP 240, a support layer 300, support patterns 305, a sacrificial layer structure 290, and a channel connection pattern 510 instead of the first CSP 980 and the ninth insulating interlayer 990, and thus, repeated explanations are omitted herein.

In FIG. 59, the second CSP 240 may be disposed on the first substrate 100. The second CSP 240 may include, e.g., polysilicon doped with n-type impurities. Alternatively, the second CSP 240 may include a metal silicide layer and a doped polysilicon layer sequentially stacked. The metal silicide layer may include, e.g., tungsten silicide.

The sacrificial layer structure 290, the channel connection pattern 510, the support layer 300, and the support patterns 305 may be formed on the second CSP 240. The channel connection pattern 510 may be disposed in the main memory block MBK on the first region I. The sacrificial layer structure 290 may be disposed in the portion of the main memory block MBK on the second region II and in the portion of the dummy memory block DBK on the first and second region I and II. The channel connection pattern 510 may include one or more air gaps therein.

The support layer 300 may be disposed on the channel connection pattern 510 and the sacrificial layer structure 290, and may also be disposed in fourth openings 302 extending through the channel connection pattern 510 and the sacrificial layer structure 290 to expose an upper surface of the first CSP 240. A portion of the support layer 300 disposed within the fourth openings 302 may be referred to as support patterns 305.

The support patterns 305 may have various layouts in a plan view. For example, first ones of the support patterns 305 may be spaced apart from each other in the second and third directions D2 and D3 in the portion of the main memory block MBK on the first region I. Second one or ones of the support patterns 305 may extend in the third direction D3 in the portion of the main memory block MBK on the second region II adjacent to the first region I. Third ones of the support patterns 305 may respectively extend in the second direction D2 and be spaced apart from each other in the third direction D3 in the portion of the main memory block MBK on the second region II. Furthermore, fourth ones of the support patterns 305 may respectively extending in the second direction D2 and be spaced apart from each other in the third direction D3 in the portion of the dummy memory block DBK on the first and second regions I and II. In FIG. 59, the support patterns 305 extend in the second direction D2 in the portion of the dummy memory block DBK on the first region I.

The channel connection pattern 510 may include polysilicon doped with n-type impurities or undoped polysilicon. The sacrificial layer structure 290 may include first to third sacrificial layers 260, 270, and 280 sequentially stacked in the first direction D1. Each of the first and third sacrificial layers 260 and 280 may include an oxide, e.g., silicon oxide, and the second sacrificial layer 270 may include a nitride, e.g., silicon nitride. The sacrificial layer structure 290 may be otherwise known as a layer structure (or a dielectric structure). The first to third sacrificial layers 260 to 280 may be otherwise known as first to third layers (or first to third dielectric layers).

The gate electrode structure may be disposed on the support layer 300 and the support patterns 305.

The memory channel structure 460 may contact the upper surface of the second CSP 240 by extending through the first gate structure, the first insulation patterns 315, and the third and fourth insulating interlayers 470 and 500.

In some implementations, the memory channel structures 460 included in the memory channel structure array may be connected to each other by the channel connection pattern 510. Specifically, the charge storage structure 420 may not be formed on a portion of outer sidewall of each of the channels 430, allowing the channel connection pattern 510 to contact outer sidewalls of the channels 430 and electrically interconnect the channels 430.

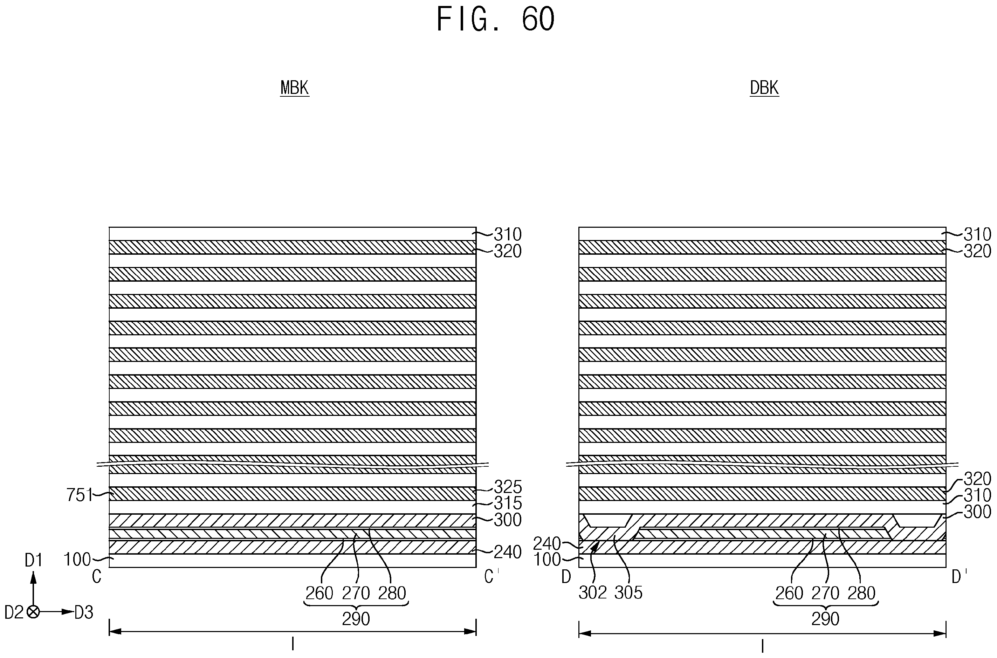

FIGS. 60 to 63 are cross-sectional views illustrating examples of methods of manufacturing a semiconductor device according to some implementations, including cross-sectional views taken along lines C-C' and D-D' of corresponding plan views. The method of manufacturing the semiconductor device includes processes substantially the same or similar to those described with reference to FIGS. 1 to 46, and thus, repeated explanations are omitted herein.

In FIG. 60, a second CSP 240 and a sacrificial layer structure 290 may be formed on the first substrate 100, the sacrificial layer structure 290 may be partially removed to form fourth openings 302 exposing an upper surface of the second CSP 240, and a support layer 300 may be formed on an upper surface of the sacrificial layer structure 290 and the exposed upper surface of the second CSP 240. The sacrificial layer structure 290 may include third to fifth sacrificial layers 260, 270, and 280 sequentially stacked.

In a plan view, the fourth openings 302 may be formed in various layouts. For example, first ones of the fourth openings 302 may be spaced apart from each other in the second and third directions D2 and D3 in the portion of the main memory block MBK on the first region I. Second one or ones of the fourth openings 302 may extend in the third direction D3 in the portion of the main memory block MBK on the second region II adjacent to the first region I. Third ones of the fourth openings 302 may respectively extend in the second direction D2 and be spaced apart from each other in the third direction D3 in the portion of the main memory block MBK on the second region II. Furthermore, fourth ones of the fourth openings 302 may respectively extending in the second direction D2 and be spaced apart from each other in the third direction D3 in the portion of the dummy memory block DBK on the first and second regions I and II. FIG. 60 illustrates the fourth openings 302 extending in the second direction D2 in the portion of the dummy memory block DBK on the first region I.

The support layer 300 may be formed with a uniform thickness, and accordingly, recesses may be respectively formed on portions of the support layer 300 formed within the fourth openings 302. Hereinafter, the portions of the support layer 300 respectively formed in the fourth openings 302 will be referred to as support patterns 305.

Subsequently, processes substantially the same or similar to those described with reference to FIGS. 8 to 29 may be performed.

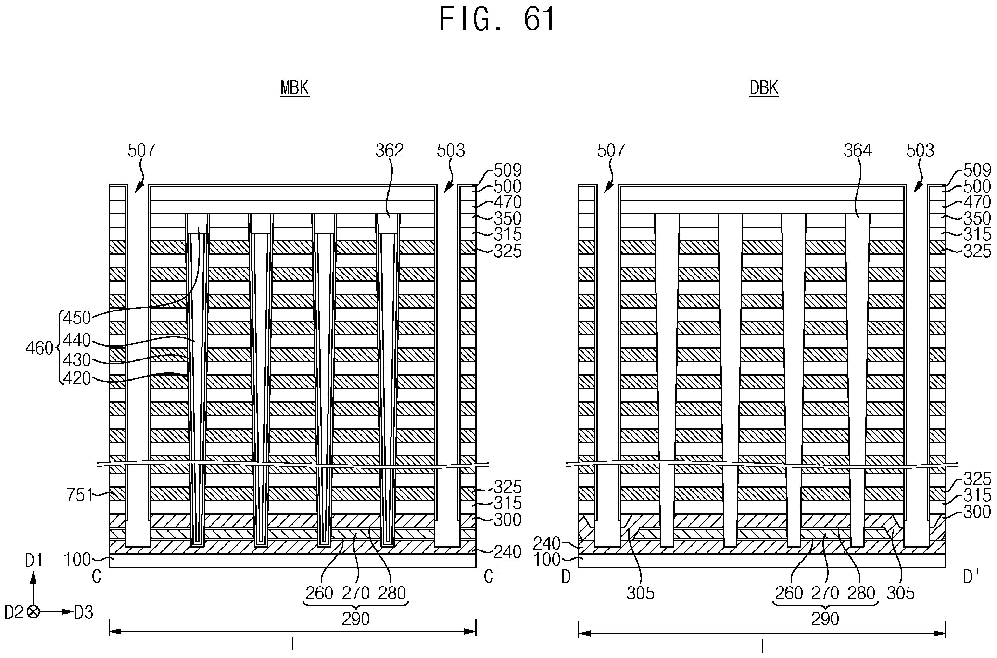

In FIG. 61, a tenth sacrificial pattern may be formed at a lower portion of each of the second and third openings 503 and 507, a spacer layer may be formed on an upper surface of the tenth sacrificial pattern, a sidewall of each second and third openings 503 and 507 and the upper surface of the fourth insulating interlayer 500, and a portion of the spacer layer on the upper surface of the tenth sacrificial pattern may be removed by an anisotropic etching process to form a spacer 509.

In example embodiments, the upper surface of the tenth sacrificial pattern may be higher than the upper surface of the sacrificial layer structure 290 but lower than an upper surface of the support layer 300. Accordingly, the spacer 509 may cover the sidewalls of the first insulation patterns 315 and first sacrificial patterns 325 exposed by each of the second and third openings 503 and 507. The spacer 509 may include, for example, undoped polysilicon.

Subsequently, the tenth sacrificial pattern may be removed.

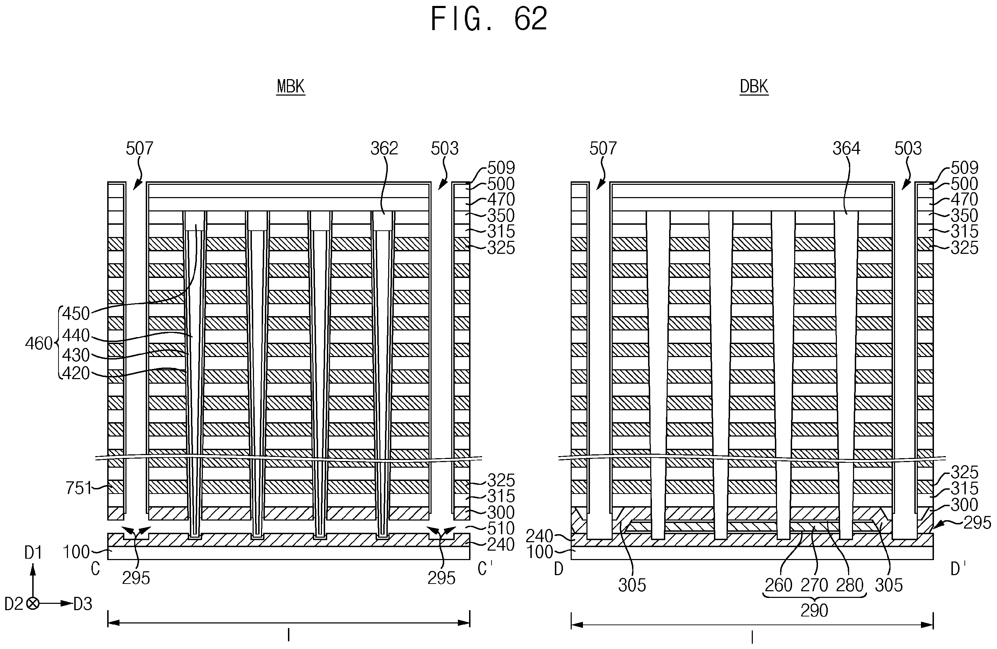

In FIG. 62, through the second and third openings 503 and 507, the sacrificial layer structure 290 (e.g. portions of the sacrificial layer structure 290 that are exposed by the second and third openings 503 and 507) may be removed by, for example, a wet etching process, and accordingly, a second gap 295 may be formed.

The wet etching process may be performed using, for example, hydrofluoric acid (HF) and/or phosphoric acid (H₃PO₄). In some implementations, in the portion of the main memory block MBK on the second region II and the portion of the dummy memory block DBK on the first and second regions I and II, each of the second and third openings 503 and 507 may extend through the support pattern 305 instead of extending through the support layer 300 and the sacrificial layer structure 290. Accordingly, the sacrificial layer structure 290 may not be removed by the wet etching process in the portion of the main memory block MBK on the second region II and the portion of the dummy memory block DBK on the first and second regions I and II.

As the second gap 295 is formed, a lower surface of the support layer 300 and an upper surface of the second CSP 240 may be exposed. Additionally, a portion of a sidewall of the charge storage structure 420 in the main memory block MBK on the first region I may be exposed by the second gap 295, and the exposed charge storage structure 420 may also be removed during the wet etching process, exposing an outer sidewall of the channel 430. Accordingly, the charge storage structure 420 may be divided into an upper portion that covers most of the outer sidewall of the channel 430 extending through the mold, and a lower portion that covers a lower surface of the channel 430 and is disposed on the second CSP 240.

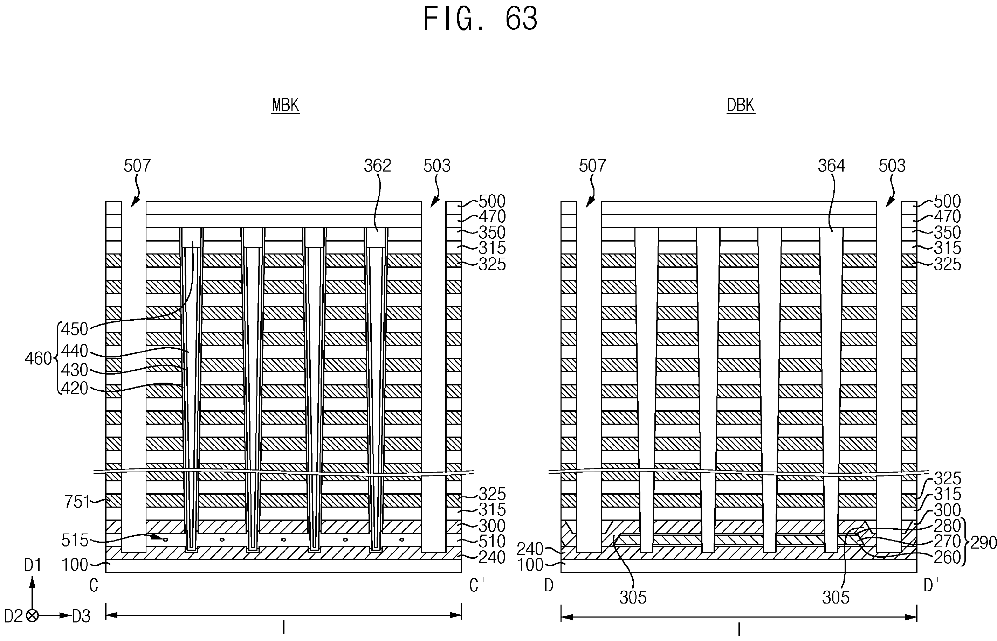

In FIG. 63, the spacer 509 may be removed, and a channel connection layer may be formed on the sidewall of each of the second and third openings 503 and 507 and within the second gap 295. A portion of the channel connection layer in each of the second and third openings 503 and 507 may be removed by performing, for example, an etch-back process to form a channel connection pattern 510 within the second gap 295.

As the channel connection pattern 510 is formed, the channels 430 disposed between the second and third openings 503 and 507 neighboring each other in the third direction D3 may be connected to each other.

Meanwhile, one or more air gaps 515 may also be formed within the channel connection pattern 510.

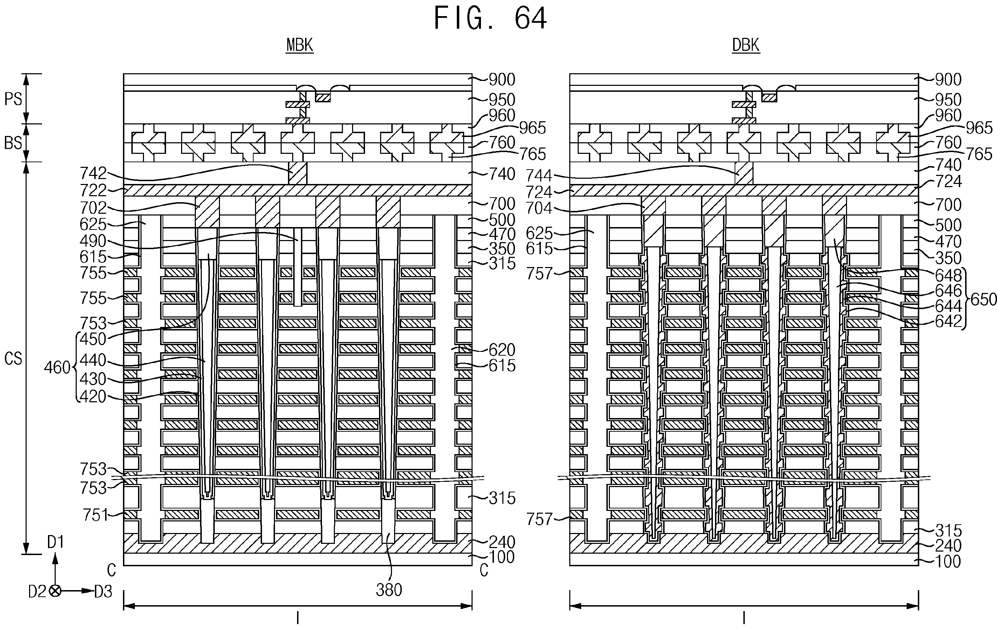

FIG. 64 is a cross-sectional view illustrating an example of a semiconductor device corresponding to FIG. 5 according to some implementations. The semiconductor device is substantially the same or similar to those described with reference to FIGS. 1 to 7 except for further including a first substrate 100, a second CSP 240, and a semiconductor pattern 380 instead of the first CSP 980 and the ninth insulating interlayer 990, and thus, repeated explanations are omitted herein.

In FIG. 64, the second CSP 240 may be formed on the first substrate 100. In some implementations, the second CSP 240 may include, for example, polysilicon doped with n-type impurities. In some implementations, the second CSP 240 may include a metal silicide layer and a polysilicon layer doped with n-type impurities that are sequentially stacked. The metal silicide layer may include, for example, tungsten silicide.

The memory channel structure 460 may further include a semiconductor pattern 380 formed on the second CSP 240, and the charge storage structure 420, the channel 430, the first filling pattern 440 and the first capping pattern 450 may be formed on the semiconductor pattern 380.

The semiconductor pattern 380 may include, for example, a single crystal silicon or polysilicon. In some implementations, the upper surface of the semiconductor pattern 380 may be located at a level (e.g. height in the first direction D1) between lower and upper surfaces of the first insulation pattern 315 between the first and second gate electrodes 751 and 753. The charge storage structure 420 may have a cup shape with an opening in a center of a bottom thereof and contact an edge portion of the upper surface of the semiconductor pattern 380. The channel 430 may have a cup shape and contact a center portion of the upper surface of the semiconductor pattern 380. Accordingly, the channel 430 may be electrically connected to the second CSP 240 through the semiconductor pattern 380.

In some implementations, the first insulation pattern 315 between the first and second gate electrodes 751 and 753, and the first insulation pattern 315 between the fourth gate electrodes 757 formed at lower two levels may have a greater thickness than the first insulation patterns 315 formed at upper levels.

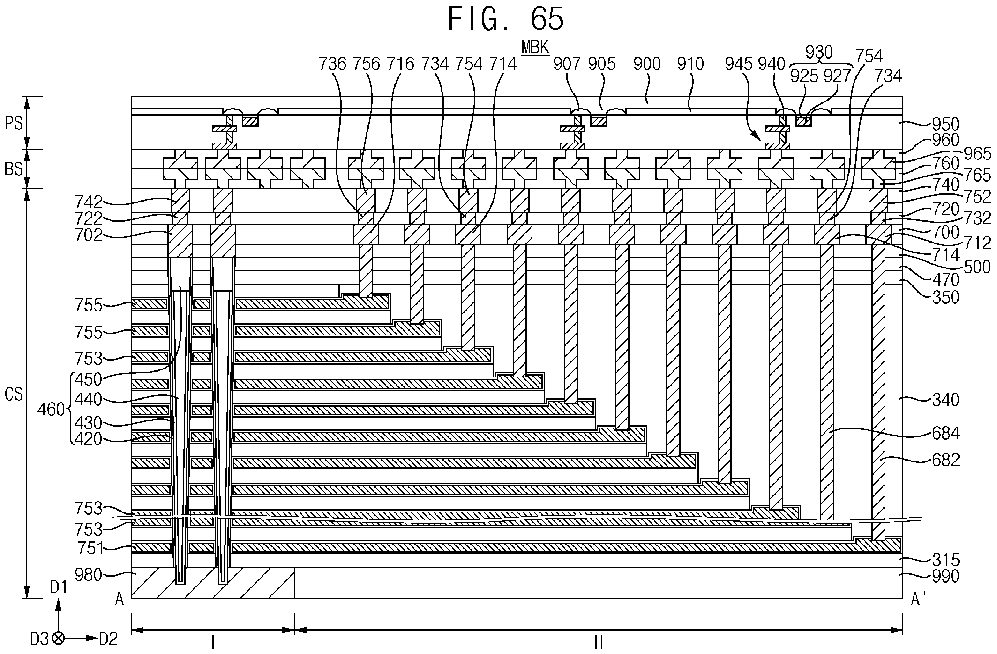

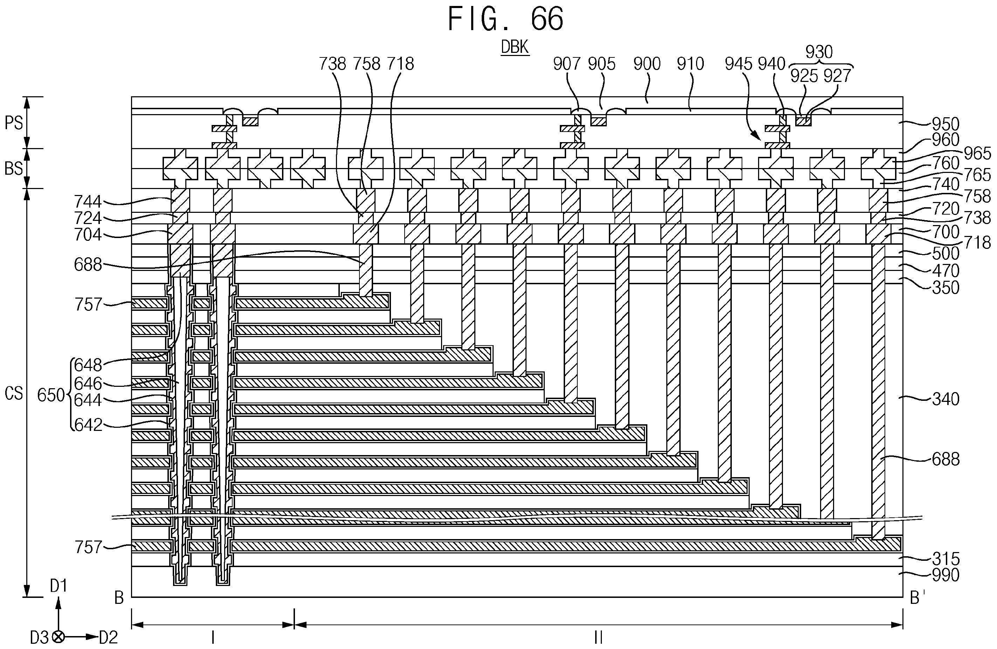

FIGS. 65 and 66 are cross-sectional views illustrating an example of a semiconductor device corresponding to FIGS. 3 and 4, respectively, according to some implementations. The semiconductor device is substantially the same or similar to those described with reference to FIGS. 1 to 7 except for the shape of the first to fourth contact plugs 682, 684, 686, and 688, and thus, repeated explanations are omitted herein.

In FIGS. 65 and 66, the first to fourth contact plugs 682, 684, 686, and 688 may extend through the first to fourth insulating interlayers 340, 350, 470, and 500 and respectively contact upper surfaces of the pads of the first to fourth gate electrodes 751, 753, 755, and 757.

Embodiments are set out in the following Clauses:
Clause 1. A semiconductor device comprising:
   a gate electrode structure including gate electrodes spaced apart from each other in a first direction perpendicular to an upper surface of a substrate;
   insulation patterns disposed between the gate electrodes;
   a first capacitor electrode extending through the gate electrode structure and the insulation patterns in the first direction, the first capacitor electrode including a metal;
   a dielectric pattern on a sidewall of the first capacitor electrode; and
   second capacitor electrodes having respective portions of the gate electrodes adjacent to the first capacitor electrode,
   wherein the first capacitor electrode includes:
      a first extension portion extending in the first direction; and
      first protrusion portions protruding from portions of a sidewall of the first extension portion in a horizontal direction parallel to the upper surface of the substrate, the portions of the sidewall of the first extension portion facing the insulation patterns in the horizontal direction.
Clause 2. The semiconductor device of Clause 1, wherein the first capacitor electrode, a second capacitor electrode of the second capacitor electrodes, and a portion of the dielectric pattern interposed between the first capacitor electrode and the second capacitor electrode define a capacitor.
Clause 3. The semiconductor device of Clause 1 or Clause 2, wherein a first protrusion portion of the first protrusion portions overlaps in the first direction with a gate electrode of the gate electrodes that is disposed immediately above or below an insulation pattern of the insulation patterns that overlaps in the horizontal direction with the first protrusion portion.
Clause 4. The semiconductor device of any preceding Clause, comprising a filling pattern extending in the first direction and contacting an inner sidewall of the first capacitor electrode.
Clause 5. The semiconductor device of Clause 4,
   wherein the first extension portion of the first capacitor electrode has a cup shape, and
   wherein the filling pattern has a pillar shape that contacts an inner sidewall of the first extension portion of the first capacitor electrode.
Clause 6. The semiconductor device of any preceding Clause, comprising:
   a blocking pattern covering upper surfaces, lower surfaces, and sidewalls of the gate electrodes,
   wherein the blocking pattern comprises a metal oxide.
Clause 7. A semiconductor device comprising:
   a gate electrode structure including gate electrodes spaced apart from each other in a first direction perpendicular to an upper surface of a substrate;
   a blocking pattern covering upper surfaces, lower surfaces, and sidewalls of the gate electrodes, wherein the blocking pattern comprises a metal oxide;
   insulation patterns disposed between the gate electrodes;
   a first capacitor electrode extending through the gate electrode structure and the insulation patterns in the first direction;
   a dielectric pattern on a sidewall of the first capacitor electrode; and
   second capacitor electrodes having portions of the gate electrodes adjacent to the first capacitor electrode,
   wherein an outer radius from a central axis of the first capacitor electrode to an outer sidewall of the first capacitor electrode periodically increases and decreases along the first direction, and
   wherein the outer radius increases at heights corresponding to the insulation patterns.
Clause 8. The semiconductor device of Clause 7, wherein the first capacitor electrode, a second capacitor electrode of the second capacitor electrodes, a portion of the dielectric pattern, and a portion of the blocking pattern define a capacitor, the portion of the dielectric pattern and the portion of the blocking pattern being interposed between the first capacitor electrode and the second capacitor electrode.
Clause 9. The semiconductor device of Clause 7 or Clause 8,
   wherein a distance from the central axis of the first capacitor electrode to an outer sidewall of a portion of the dielectric pattern facing an insulation pattern of the insulation patterns in a horizontal direction is greater than a distance from the central axis of the first capacitor electrode to a sidewall of a gate electrode of the gate electrodes disposed immediately above or below the insulation pattern, and
   wherein the horizontal direction is parallel to the upper surface of the substrate.
Clause 10. The semiconductor device of any of Clauses 7-9,
   wherein a distance from the central axis of the first capacitor electrode to an outer sidewall of a portion of the first capacitor electrode facing an insulation pattern of the insulation patterns in a horizontal direction is greater than a distance from the central axis of the first capacitor electrode to a sidewall of a gate electrode of the gate electrodes disposed immediately above or below the insulation pattern, and
   wherein the horizontal direction is parallel to the upper surface of the substrate.
Clause 11. The semiconductor device of any of Clauses 7-10,
   wherein the first capacitor electrode has a cup shape, and
   wherein the semiconductor device comprises a filling pattern contacting an inner sidewall of the first capacitor electrode.
Clause 12. The semiconductor device of Clause 11, wherein an inner radius from the central axis of the first capacitor electrode to the inner sidewall of the first capacitor electrode gradually increases with increasing distance from the upper surface of the substrate in the first direction.
Clause 13. The semiconductor device of Clause 11 or Clause 12,
   wherein an inner radius from the central axis of the first capacitor electrode to the inner sidewall of the first capacitor electrode periodically increases and decreases along the first direction, and
   wherein the inner radius increases at heights corresponding to the insulation patterns.
Clause 14. The semiconductor device of any of Clauses 11-13, wherein the filling pattern includes:
   an extension portion extending in the first direction; and
   protrusion portions protruding in a horizontal direction from portions of a sidewall of the extension portion that face the insulation patterns in the horizontal direction.
Clause 15. A semiconductor device comprising:
   a gate electrode structure including gate electrodes spaced apart from each other in a first direction substantially perpendicular to an upper surface of a substrate;
   a memory channel structure including:
      a channel extending through the gate electrode structure in the first direction; and
      a charge storage structure on an outer sidewall of the channel;
   a capacitor structure extending through the gate electrode structure and spaced apart from the memory channel structure in a horizontal direction parallel to the upper surface of the substrate,
   wherein the capacitor structure includes:
      a first capacitor electrode extending in the first direction;
      a dielectric pattern on a sidewall of the first capacitor electrode; and
      second capacitor electrodes having portions of the gate electrodes adjacent to the first capacitor electrode, and
   wherein the first capacitor electrode includes protrusion portions that protrude in the horizontal direction between adjacent ones of the gate electrodes in the first direction.
Clause 16. The semiconductor device of Clause 15, wherein the channel comprises one of a plurality of channels spaced apart from each other in the horizontal direction.
Clause 17. The semiconductor device of Clause 16, comprising a common source plate on the substrate and contacting lower portions of the plurality of channels.
Clause 18. The semiconductor device of Clause 16 or Clause 17, comprising:
   a channel connection pattern on the substrate and contacting the plurality of channels,
   wherein the charge storage structure comprises one of a plurality of channel storage structures on outer sidewalls of the plurality of the channels, and
   wherein the plurality of channel storage structures include an upper portion on the channel connection pattern and a lower portion below the channel connection pattern.
Clause 19. The semiconductor device of any of Clauses 15-18, comprising a semiconductor pattern on the substrate,
   wherein the channel contacts a central portion of an upper surface of the semiconductor pattern, and
   wherein the charge storage structure contacts an edge portion of the upper surface of the semiconductor pattern.
Clause 20. The semiconductor device of any of Clauses 15-19,
   wherein the memory channel structure and a portion of the gate electrode structure adjacent to the memory channel structure define a main memory block, and
   wherein the capacitor structure and a portion of the gate electrode structure adjacent to the capacitor structure define a dummy memory block.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device comprising:
a gate electrode structure including gate electrodes (757) spaced apart from each other in a first direction perpendicular to an upper surface of a substrate;
insulation patterns (315) disposed between the gate electrodes;
a first capacitor electrode (644) extending through the gate electrode structure and the insulation patterns (315) in the first direction, the first capacitor electrode (644) including a metal;
a dielectric pattern (642) on a sidewall of the first capacitor electrode (644); and
second capacitor electrodes (640) being respective portions of the gate electrodes (757) adjacent to the first capacitor electrode (644),
wherein the first capacitor electrode (644) includes:
a first extension portion extending in the first direction; and
first protrusion portions protruding from portions of a sidewall of the first extension portion in a horizontal direction parallel to the upper surface of the substrate, the portions of the sidewall of the first extension portion facing the insulation patterns (315) in the horizontal direction.

2. The semiconductor device of claim 1, wherein the first capacitor electrode (644), a second capacitor electrode of the second capacitor electrodes (640), and a portion of the dielectric pattern (642) interposed between the first capacitor electrode (644) and the second capacitor electrode define a capacitor.

3. The semiconductor device of claim 1 or claim 2, wherein a first protrusion portion of the first protrusion portions overlaps in the first direction with a gate electrode of the gate electrodes (757) that is disposed immediately above or below an insulation pattern of the insulation patterns (315) that overlaps in the horizontal direction with the first protrusion portion.

4. The semiconductor device of any preceding claim, comprising a filling pattern (646) extending in the first direction and contacting an inner sidewall of the first capacitor electrode (644).

5. The semiconductor device of claim 4,
wherein the first extension portion of the first capacitor electrode (644) has a cup shape, and
wherein the filling pattern (646) has a pillar shape that contacts an inner sidewall of the first extension portion of the first capacitor electrode (644).

6. The semiconductor device of any preceding claim, comprising:
a blocking pattern (615) covering upper surfaces, lower surfaces, and sidewalls of the gate electrodes (757),
wherein the blocking pattern (615) comprises a metal oxide.

7. The semiconductor device of any preceding claim, further comprising:
a blocking pattern (615) covering upper surfaces, lower surfaces, and sidewalls of the gate electrodes (757), wherein the blocking pattern comprises a metal oxide;
wherein an outer radius from a central axis of the first capacitor electrode (644) to an outer sidewall of the first capacitor electrode (644) periodically increases and decreases along the first direction, and
wherein the outer radius increases at heights corresponding to the insulation patterns (315).

8. The semiconductor device of claim 7, wherein the first capacitor electrode (644), a second capacitor electrode of the second capacitor electrodes (640), a portion of the dielectric pattern (642), and a portion of the blocking pattern (615) define a capacitor, the portion of the dielectric pattern (642) and the portion of the blocking pattern (615) being interposed between the first capacitor electrode (644) and the second capacitor electrode.

9. The semiconductor device of claim 7 or claim 8,
wherein a distance from the central axis of the first capacitor electrode (644) to an outer sidewall of a portion of the dielectric pattern (642) facing an insulation pattern of the insulation patterns (315) in a horizontal direction is greater than a distance from the central axis of the first capacitor electrode (644) to a sidewall of a gate electrode of the gate electrodes (757) disposed immediately above or below the insulation pattern.

10. The semiconductor device of any of claims 7-9,
wherein a distance from the central axis of the first capacitor electrode (644) to an outer sidewall of a portion of the first capacitor electrode (644) facing an insulation pattern of the insulation patterns (315) in a horizontal direction is greater than a distance from the central axis of the first capacitor electrode (644) to a sidewall of a gate electrode of the gate electrodes (757) disposed immediately above or below the insulation pattern.

11. The semiconductor device of any of claims 7-10,
wherein the first capacitor electrode (644) has a cup shape, and
wherein the semiconductor device comprises a filling pattern (646) contacting an inner sidewall of the first capacitor electrode (644).

12. The semiconductor device of claim 11, wherein an inner radius from the central axis of the first capacitor electrode (644) to the inner sidewall of the first capacitor electrode (644) gradually increases with increasing distance from the upper surface of the substrate in the first direction.

13. The semiconductor device of claim 11,
wherein an inner radius from the central axis of the first capacitor electrode (644) to the inner sidewall of the first capacitor electrode (644) periodically increases and decreases along the first direction, and
wherein the inner radius increases at heights corresponding to the insulation patterns (315).

14. The semiconductor device of any of claims 11-13, wherein the filling pattern (646) includes:
an extension portion extending in the first direction; and
protrusion portions protruding in a horizontal direction from portions of a sidewall of the extension portion that face the insulation patterns (315) in the horizontal direction.

15. The semiconductor device of any preceding claim comprising:
a memory channel structure including:
a channel extending through the gate electrode structure in the first direction; and
a charge storage structure on an outer sidewall of the channel; and
a capacitor structure extending through the gate electrode structure and spaced apart from the memory channel structure in a horizontal direction parallel to the upper surface of the substrate,
wherein the capacitor structure includes the first capacitor electrode, the dielectric pattern, and the second capacitor electrodes.
